# EUROPEAN PATENT APPLICATION

(11) **EP 4 397 734 A1**
(43) Date of publication of application: **10.07.2024**
(21) Application number: 23210706.0
(22) Date of filing: 17.11.2023
(51) Int. Cl.: C09K 11/06, H10K 50/11, H10K 85/60, C07F 5/02

(54) **METHOD OF PREPARING HETEROCYCLIC COMPOUND, HETEROCYCLIC COMPOUND PREPARED ACCORDING TO THE METHOD, LIGHT-EMITTING DEVICE COMPRISING THE HETEROCYCLIC COMPOUND, AND ELECTRONIC APPARATUS AND ELECTRONIC EQUIPMENT COMPRISING THE LIGHT-EMITTING DEVICE**

(30) Priority: 09.01.2023 KR 20230003029
(71) Applicant: Samsung Display Co., Ltd., Yongin-si, Gyeonggi-do 17113 (KR)
(72) Inventor: Sunwoo, Kyoung, 17113 Yongin-si (KR); Kim, Taeil, 17113 Yongin-si (KR); Pak, Sunyoung, 17113 Yongin-si (KR); Park, Junha, 17113 Yongin-si (KR); Baek, Jangyeol, 17113 Yongin-si (KR); Sung, Minjae, 17113 Yongin-si (KR); Sim, Munki, 17113 Yongin-si (KR); Oh, Chanseok, 17113 Yongin-si (KR); Jung, Minjung, 17113 Yongin-si (KR); Hur, Seonhyoung, 17113 Yongin-si (KR)
(74) Representative: Crow, Martin

(57) **Abstract**

A method of preparing a heterocyclic compound represented by Formula 1, the method comprises preparing a first reactant, preparing a second reactant represented by Formula 2-2, and preparing an intermediate compound by mixing the first reactant and the second reactant with i) a copper catalyst, ii) a base, and optionally, iii) an auxiliary solvent, to allow the first reactant and the second reactant to react, wherein the first reactant is a compound represented by Formula 2-1a, and the intermediate compound is a compound represented by Formula 2-3a, or the first reactant is a compound represented by Formula 2-1b, and the intermediate compound is a compound represented by Formula 2-3b: 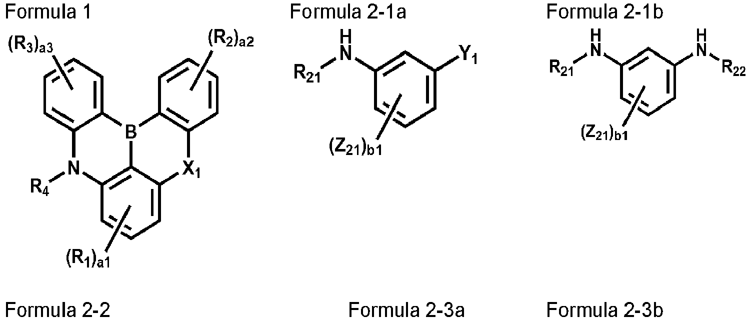 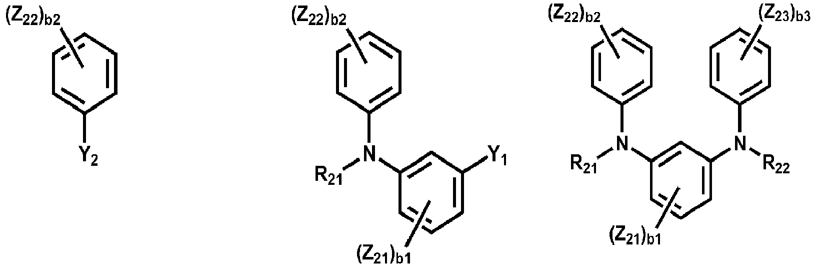 wherein more details of Formulae 1, 2-1a, 2-1b, 2-2, 2-3a, and 2-3b are as described herein.

## Description

### CROSS-REFERENCE TO RELATED APPLICATION

This application claims priority to and the benefit of Korean Patent Application No. 1 0-2023-0003029, filed on January 9, 2023, in the Korean Intellectual Property Office, the content of which is incorporated by reference herein in its entirety.

### BACKGROUND

### 1. Field

One or more embodiments relate to a method of preparing a heterocyclic compound, a heterocyclic compound prepared according to the method, a light-emitting device comprising the heterocyclic compound, and an electronic apparatus and electronic equipment that comprise the light-emitting device.

### 2. Description of the Related Art

From among light-emitting devices, self-emissive devices have relatively wide viewing angles, high contrast ratios, short response times, and/or excellent or suitable characteristics in terms of luminance, driving voltage, and/or response speed.

In a light-emitting device, a first electrode is arranged on a substrate, and a hole transport region, an emission layer, an electron transport region, and a second electrode are sequentially arranged on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition (relax) from an excited state to a ground state to thereby generate light.

### SUMMARY

Aspects according to one or more embodiments of the present disclosure are directed toward a method of preparing a heterocyclic compound, a heterocyclic compound prepared according to the method, a light-emitting device comprising the heterocyclic compound, and an electronic apparatus and electronic equipment that comprise the light-emitting device.

Additional aspects will be set forth in part in the description which follows and, in part, will be apparent from the description, or may be learned by practice of the presented embodiments of the disclosure.

According to one or more embodiments,
a method of preparing a heterocyclic compound represented by Formula 1 comprises
preparing a first reactant,
preparing a second reactant represented by Formula 2-2, and
preparing an intermediate compound by mixing the first reactant and the second reactant with a copper catalyst, a base, and optionally, an auxiliary solvent, to allow the first reactant and the second reactant to react,
wherein the first reactant is represented by Formula 2-1a, and the intermediate compound is represented by Formula 2-3a, or
the first reactant is represented by Formula 2-1b, and the intermediate compound is represented by Formula 2-3b: 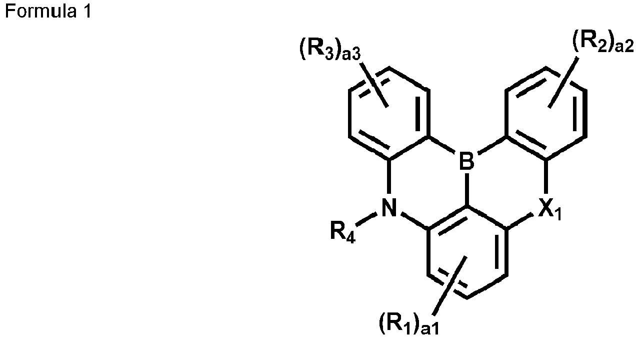 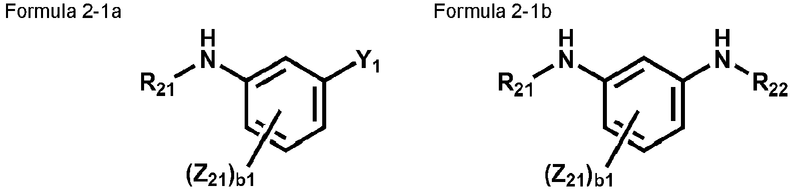 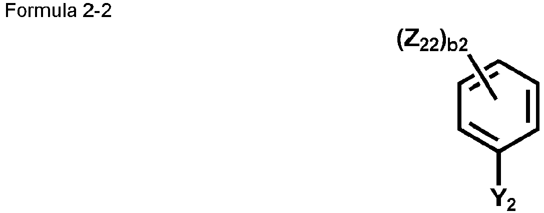 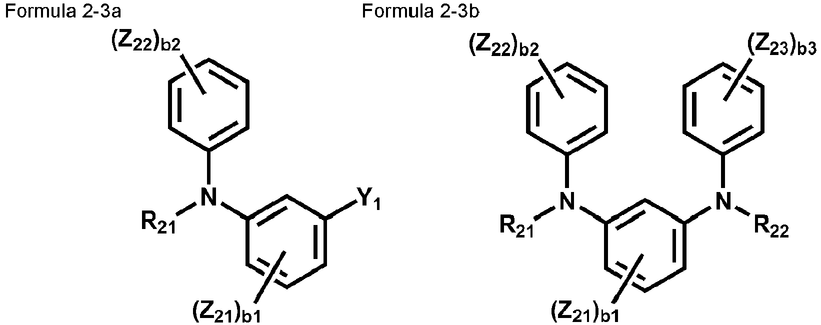
wherein, in Formula 1,
X₁ may be N(R₁₁), O, S, or Se,
R₁ to R₄ and R₁₁ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂),
a1 may be an integer from 1 to 3, and
a2 and a3 may each independently be an integer from 1 to 4,
wherein, in Formulae 2-1a, 2-1b, 2-2, 2-3a, and 2-3b,
Y₁ and Y₂ may each independently be -F, -Cl, -Br, or -I,
R₂₁, R₂₂, and Z₂₁ to Z₂₃ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or-P(=O)(Q₁)(Q₂),
b1 may be an integer from 1 to 4,
b2 and b3 may each independently be an integer from 1 to 5,
two or more adjacent groups selected from R₁ to R₄, R₁₁, R₂₁, R₂₂, and Z₂₁ to Z₂₃ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ,
R₁₀ₐ may be
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -B(Q₁₁)(Q₁₂), -C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -B(Q₂₁)(Q₂₂), -C(=O)(Q₂₁), -S(-O)₂(Q₂₁), -P(=O)(Q₂₁)(Q₂₂), or any combination thereof, or
-Si(Q₃₁)(Q₃₂)(Q₃₃), -B(Q₃₁)(Q₃₂), -C(=O)(Q₃₁), -S(=O)₂(Q₃₁), or -P(=O)(Q₃₁)(Q₃₂), and
Q₁ to Q₃, Q₁₁ to Q₁₃, Q₂₁ to Q₂₃, and Q₃₁ to Q₃₃ may each independently be hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₃-C₆₀ carbocyclic group, a C₁-C₆₀ heterocyclic group, or any combination thereof.

According to one or more embodiments,
a method of preparing a heterocyclic compound represented by Formula 1 comprises
reacting an intermediate compound represented by Formula 2-3a or 2-3b or a derivative thereof with a boron halide.

In an embodiment, at least one of R₁ to R₃ in Formula 1 is a group represented by Formula 1-1, and the group represented by Formula 1-1 is introduced into the heterocyclic compound after the reacting of the intermediate compound or a derivative thereof with the boron halide: 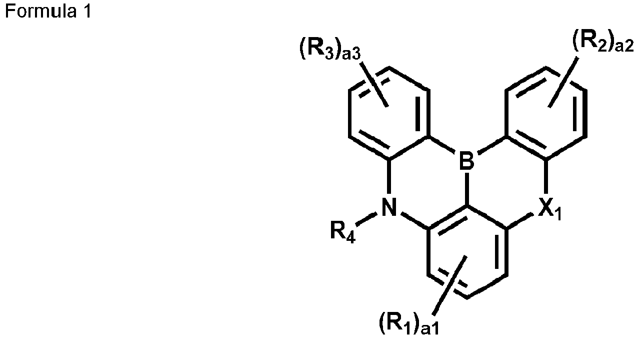 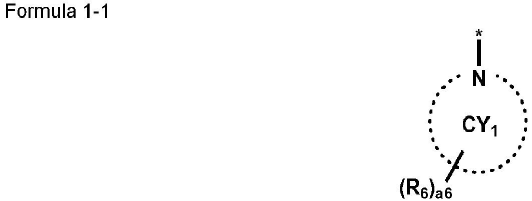 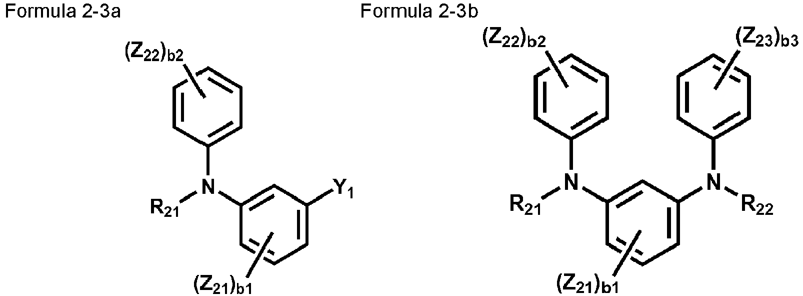
wherein, in Formulae 1 and 1-1,
X₁ may be N(R₁₁), O, S, or Se,
CY₁ may be a C₅-C₃₀ carbocyclic group or a C₁-C₃₀ heterocyclic group,
R₁ to R₄, R₁₁, and R₆ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or-P(=O)(Q₁)(Q₂),
a1 may be an integer from 1 to 3,
a2 and a3 may each independently be an integer from 1 to 4,
a6 may be an integer from 1 to 10, and
* indicates a binding site to a neighboring atom,
wherein, in Formulae 2-3a and 2-3b,
Y₁ and Y₂ may each independently be -F, -Cl, -Br, or -I,
R₂₁, R₂₂, and Z₂₁ to Z₂₃ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or-P(=O)(Q₁)(Q₂),
b1 may be an integer from 1 to 4,
b2 and b3 may each independently be an integer from 1 to 5,
two or more groups of R₁ to R₄, R₁₁, R₆, R₂₁, R₂₂, and Z₂₁ to Z₂₃ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ,
R₁₀ₐ may be
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -B(Q₁₁)(Q₁₂), -C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -B(Q₂₁)(Q₂₂), -C(=O)(Q₂₁), -S(=O)₂(Q₂₁), -P(=O)(Q₂₁)(Q₂₂), or any combination thereof, or
-Si(Q₃₁)(Q₃₂)(Q₃₃), -B(Q₃₁)(Q₃₂), -C(=O)(Q₃₁), -S(=O)₂(Q₃₁), or -P(=O)(Q₃₁)(Q₃₂), and
Q₁ to Q₃, Q₁₁ to Q₁₃, Q₂₁ to Q₂₃, and Q₃₁ to Q₃₃ may each independently be hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₃-C₆₀ carbocyclic group, a C₁-C₆₀ heterocyclic group, or any combination thereof.

According to one or more embodiments,
a heterocyclic compound is represented by Formula 1, the heterocyclic compound being prepared according to the method: 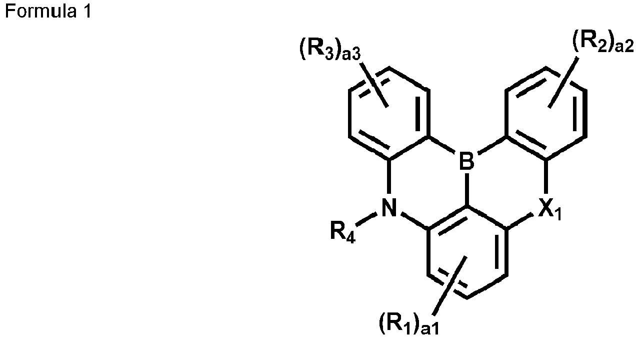
wherein, in Formula 1,
X₁ may be N(R₁₁), O, S, or Se,
R₁ to R₄ and R₁₁ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂),
a1 may be an integer from 1 to 3,
a2 and a3 may each independently be an integer from 1 to 4,
two or more adjacent groups selected from R₁ to R₄ and R₁₁ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ,
R₁₀ₐ may be
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -B(Q₁₁)(Q₁₂), -C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -B(Q₂₁)(Q₂₂), -C(=O)(Q₂₁), -S(=O)₂(Q₂₁), -P(=O)(Q₂₁)(Q₂₂), or any combination thereof, or
-Si(Q₃₁)(Q₃₂)(Q₃₃), -B(Q₃₁)(Q₃₂), -C(=O)(Q₃₁), -S(=O)₂(Q₃₁), or -P(=O)(Q₃₁)(Q₃₂), and
Q₁ to Q₃, Q₁₁ to Q₁₃, Q₂₁ to Q₂₃, and Q₃₁ to Q₃₃ may each independently be hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₃-C₆₀ carbocyclic group, a C₁-C₆₀ heterocyclic group, or any combination thereof.

According to one or more embodiments, a light-emitting device comprises
a first electrode,
a second electrode facing the first electrode,
an interlayer arranged between the first electrode and the second electrode and comprising an emission layer, and
the heterocyclic compound.

According to one or more embodiments, an electronic apparatus comprises the light-emitting device.

According to one or more embodiments, an electronic equipment comprises the light-emitting device.

### BRIEF DESCRIPTION OF THE DRAWINGS

The above and other aspects, features, and enhancements of certain embodiments of the disclosure will be more apparent from the following description taken in conjunction with the accompanying drawings, in which:
FIG. 1 is a schematic view of a light-emitting device according to an embodiment;
FIG. 2 is a schematic view of an electronic apparatus according to an embodiment;
FIG. 3 is a schematic view of an electronic apparatus according to another embodiment; and
FIG. 4 is a schematic view of an electronic equipment according to an embodiment.
FIG. 5 is a schematic view of an electronic equipment according to an embodiment.
FIG. 6A is a schematic view of an electronic equipment according to an embodiment.
FIG. 6B is a schematic view of an electronic equipment according to an embodiment.
FIG. 6C is a schematic view of an electronic equipment according to an embodiment.

### DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described below, by referring to the drawings, to explain aspects of the present description. As used herein, the term "and/or" comprises any and all combinations of one or more of the associated listed items. Throughout the disclosure, the expression "at least one of a, b or c", "at least one selected from a, b, and c", "at least one selected from the group consisting of a, b, and c", "at least one from among a, b, and c", "at least one of a to c", etc., indicates only a, only b, only c, both (e.g., simultaneously) a and b, both (e.g., simultaneously) a and c, both (e.g., simultaneously) band c, all of a, b, and c, or variations thereof.

According to one or more embodiments of the present disclosure,
a method of preparing a heterocyclic compound represented by Formula 1 comprises:
preparing a first reactant;
preparing a second reactant represented by Formula 2-2; and
preparing an intermediate compound by mixing the first reactant and the second reactant with: i) a copper catalyst; ii) a base; and optionally, iii) an auxiliary solvent, to allow the first reactant and the second reactant to react,
wherein the first reactant may be a compound represented by Formula 2-1a, and the intermediate compound may be a compound represented by Formula 2-3a, or
the first reactant may be a compound represented by Formula 2-1b, and the intermediate compound may be a compound represented by Formula 2-3b:

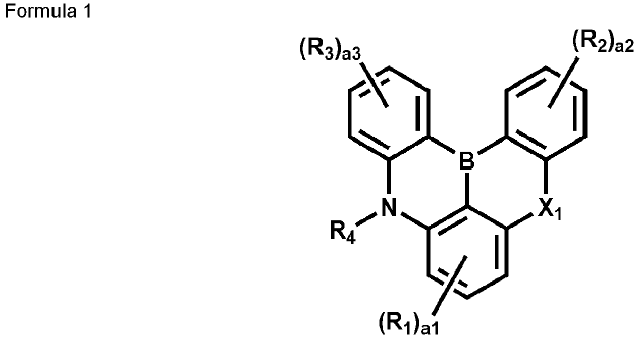

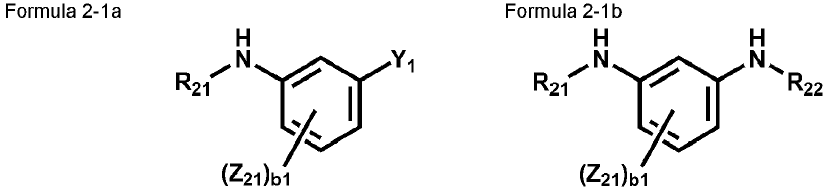

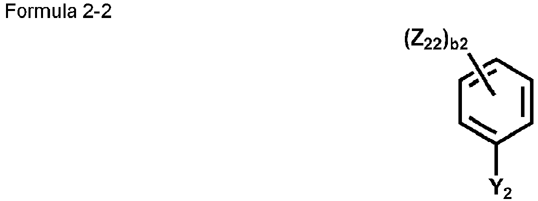

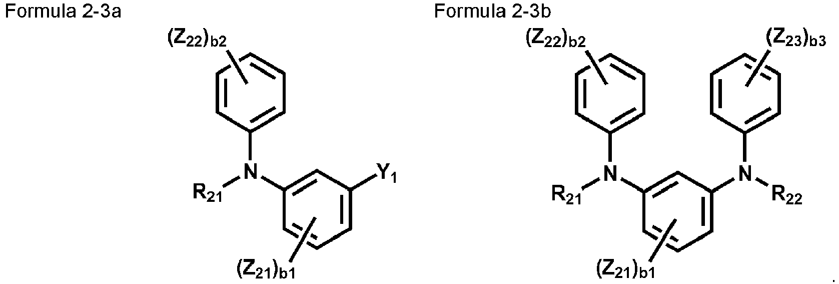

Details of Formulae 1, 2-1a, 2-1b, 2-2, 2-3a, and 2-3b may be as described herein.

In an embodiment, the second reactant may be utilized as a solvent.

In an embodiment, the second reactant may be iodobenzene, bromobenzene, 1-iodobenzene-2,3,4,5,6-D₅, 1-bromobenzene-2,3,4,5,6-Ds, 1-bromo-4-(tert-butyl)benzene, 1-iodo-4-(tert-butyl)benzene, 1-bromo-3,5-di-tert-butylbenzene, 1-iodo-3,5-di-tert-butylbenzene, 1-chloro-3-iodobenzene, 1-bromo-3-iodobenzene, 1-fluoro-3-iodobenzene, 1-fluoro-4-iodobenzene, 1-bromo-3-fluorobenzene, 1-bromo-4-fluorobenzene, 1-chloro-3-iodobenzene, 1-bromo-3-chlorobenzene, 1-chloro-4-iodobenzene, 1-bromo-4-iodobenzene, 1-chloro-4-iodobenzene, 1-bromo-4-chlorobenzene, 1-chloro-3-iodobenzene-2,4,5,6-D₄, 1-bromo-3-iodobenzene-2,4,5,6-D₄, 1-chloro-4-iodobenzene-2,3,5,6-D₄, 1-bromo-4-iodobenzene-2,3,5,6-D₄, 4-iodo-1,1'-biphenyl, or 4-bromo-1,1'-biphenyl.

In an embodiment, the copper catalyst may be metal copper, CuCI, CuBr, CuI, CuCl₂, CuBr₂, Culz, CuO, or CuS.

In an embodiment, the copper catalyst may be CuI.

In an embodiment, the base may be K₂CO₃, Na₂CO₃, Cs₂CO₃, K₃PO₄, KOH, or NaOtBu.

In an embodiment, the auxiliary solvent may be o-dichlorobenzene, chlorobenzene, toluene, 1,2,4-trimethylbenzene, xylene, diphenyl ether, anisole, cyclopentylmethyl ether, dioxane, trichlorotoluene, dimethylformamide (DMF), or dimethyl sulfoxide (DMSO).

In an embodiment, in the preparing of the intermediate compound, the number of moles of the second reactant may be 5 times or more, 6 times or more, 7 times or more, 8 times or more, 9 times or more, or 10 times or more the number of moles of the first reactant. That is, in the preparing of the intermediate compound, a molar ratio between the second reactant and the first reactant (second reactant: first reactant) may be 5 or more, 6 or more, 7 or more, 8 or more, 9 or more, or 10 or more.

For example, in the preparing of the intermediate compound, the number of moles of the second reactant may be about 5 times to about 30 times, about 6 times to about 30 times, about 7 times to about 30 times, about 8 times to about 30 times, about 9 times to about 30 times, about 5 times to about 25 times, about 6 times to about 25 times, about 7 times to about 25 times, about 8 times to about 25 times, about 9 times to about 25 times, about 5 times to about 20 times, about 6 times to about 20 times, about 7 times to about 20 times, about 8 times to about 20 times, about 9 times to about 20 times, about 5 times to about 18 times, about 6 times to about 18 times, about 7 times to about 18 times, about 8 times to about 18 times, about 9 times to about 18 times, about 5 times to about 16 times, about 6 times to about 16 times, about 7 times to about 16 times, about 8 times to about 16 times, or about 9 times to about 16 times the number of moles of the first reactant. For example, a molar ratio between the second reactant and the first reactant may be 5 to 30.

In an embodiment, in the preparing of the intermediate compound, the number of moles of the copper(I) catalyst may be about 1 times to about 3 times the number of moles of the first reactant. That is, in the preparing of the intermediate compound, a molar ratio between the copper(I) catalyst and the first reactant (copper(I) catalyst: first reactant) may be about 1 to about 3.

In an embodiment, in the preparing of the intermediate compound, the number of molecules (e.g., number of moles) of the base may be about 5 times to about 15 times the number of molecules (e.g., number of moles) of the first reactant. That is, in the preparing of the intermediate compound, a molar ratio between the base and the first reactant (base : first reactant) may be about 5 to about 15.

In an embodiment, the preparing of the intermediate compound may be performed at a temperature of about 170 °C to about 210 °C, about 175 °C to about 210 °C, about 180 °C to about 210 °C, about 170 °C to about 205 °C, about 175 °C to about 205 °C, about 180 °C to about 205 °C, about 170 °C to about 200 °C, about 175 °C to about 200 °C, or about 180 °C to about 200 °C.

In an embodiment, at the temperature of about 170 °C to about 210 °C, about 175 °C to about 210 °C, about 180 °C to about 210 °C, about 170 °C to about 205 °C, about 175 °C to about 205 °C, about 180 °C to about 205 °C, about 170 °C to about 200 °C, about 175 °C to about 200 °C, or about 180 °C to about 200 °C, the second reactant may be in a liquid state, or a mixture of the second reactant and the auxiliary solvent may be in a liquid state.

In an embodiment, in the mixture of the second reactant and the auxiliary solvent, a volume of the auxiliary solvent may be less than or equal to a volume of the second reactant.

In an embodiment, the preparing of the intermediate compound may be performed for about 100 hours to about 140 hours, about 105 hours to about 140 hours, about 110 hours to about 140 hours, about 100 hours to about 135 hours, about 105 hours to about 135 hours, about 110 hours to about 135 hours, about 100 hours to about 130 hours, about 105 hours to about 130 hours, or about 110 hours to about 130 hours.

In an embodiment, in the preparing of the intermediate compound, the first reactant may be added in an amount of 60 mmol or more, 70 mmol or more, 80 mmol or more, 90 mmol or more, 100 mmol or more, 120 mmol or more, 150 mmol or more, or 200 mmol or more.

For example, in the preparing of the intermediate compound, the first reactant may be added in an amount of about 60 mmol to about 1,000 mmol, about 70 mmol to about 1,000 mmol, about 80 mmol to about 1,000 mmol, about 90 mmol to about 1,000 mmol, about 100 mmol to about 1,000 mmol, about 120 mmol to about 1,000 mmol, about 150 mmol to about 1,000 mmol, about 200 mmol to about 1,000 mmol, about 60 mmol to about 700 mmol, about 70 mmol to about 700 mmol, about 80 mmol to about 700 mmol, about 90 mmol to about 700 mmol, about 100 mmol to about 700 mmol, about 120 mmol to about 700 mmol, about 150 mmol to about 700 mmol, about 200 mmol to about 700 mmol, about 60 mmol to about 500 mmol, about 70 mmol to about 500 mmol, about 80 mmol to about 500 mmol, about 90 mmol to about 500 mmol, about 100 mmol to about 500 mmol, about 120 mmol to about 500 mmol, about 150 mmol to about 500 mmol, about 200 mmol to about 500 mmol, about 60 mmol to about 400 mmol, about 70 mmol to about 400 mmol, about 80 mmol to about 400 mmol, about 90 mmol to about 400 mmol, about 100 mmol to about 400 mmol, about 120 mmol to about 400 mmol, about 150 mmol to about 400 mmol, about 200 mmol to about 400 mmol, about 60 mmol to about 300 mmol, about 70 mmol to about 300 mmol, about 80 mmol to about 300 mmol, about 90 mmol to about 300 mmol, about 100 mmol to about 300 mmol, about 120 mmol to about 300 mmol, about 150 mmol to about 300 mmol, or about 200 mmol to about 300 mmol.

In an embodiment, a yield of the intermediate compound may be 40 % or more, 50 % or more, 60 % or more, 70 % or more, or 80 % or more based on the number of moles of the first reactant (e.g., before the reaction started). The yield of the intermediate compound may be measured based on, for example, when the first reactant is added in an amount of about 20 mmol, about 40 mmol, about 60 mmol, about 80 mmol, about 100 mmol, or about 200 mmol.

For example, the yield of the intermediate compound may be about 40 % to about 100 %, about 50 % to about 100 %, about 60 % to about 100 %, about 70 % to about 100 %, about 80 % to about 100 %, about 40 % to about 99 %, about 50 % to about 99 %, about 60 % to about 99 %, about 70 % to about 99 %, about 80 % to about 99 %, about 40 % to about 95 %, about 50 % to about 95 %, about % 60 to about 95 %, about 70 % to about 95 %, about 80 % to about 95 %, about 40 % to about 90 %, about 50 % to about 90 %, about 60 % to about 90 %, about 70 % to about 90 %, or about 80 % to about 90 %, based on the number of moles of the first reactant.

In an embodiment, when the first reactant is added in an amount of about 100 mmol, the yield of the intermediate compound may be 40 % or more, 50 % or more, 60 % or more, 70 % or more, or 80 % or more, based on the number of moles of the first reactant.

For example, when the first reactant is added in the amount of 100 mmol, the yield of the intermediate compound may be about 40 % to about 100 %, about 50 % to about 100 %, about 60 % to about 100 %, about 70 % to about 100 %, about 80 % to about 100 %, about 40 % to about 99 %, about 50 % to about 99 %, about 60 % to about 99 %, about 70 % to about 99 %, about 80 % to about 99 %, about 40 % to about 95 %, about 50 % to about 95 %, about 60 % to about 95 %, about 70 % to about 95 %, about 80 % to about 95 %, about 40 % to about 90 %, about 50 % to about 90 %, about 60 % to about 90 %, about 70 % to about 90 %, or about 80 % to about 90 %, based on the number of moles of the first reactant.

In an embodiment, at least one of R₂₁ or R₂₂ may be a group represented by Formula 3:

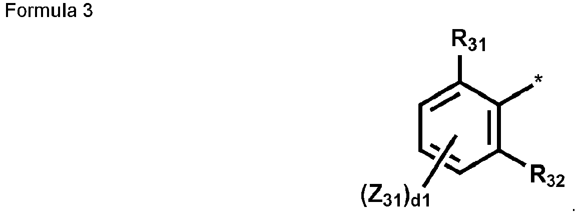

Details of Formula 3 may be as described herein.

In an embodiment, the group represented by Formula 3 may cause steric hindrance.

In an embodiment, at least one of R₃₁ or R₃₂ may be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, or -Si(Q₁)(Q₂)(Q₃).

R₁₀ₐ may be as defined herein.

In an embodiment, the method of preparing a heterocyclic compound may further comprise reacting the intermediate compound or a derivative thereof with a boron halide. Due to the reaction, for example, a compound represented by Formula 2-4 may be obtained:

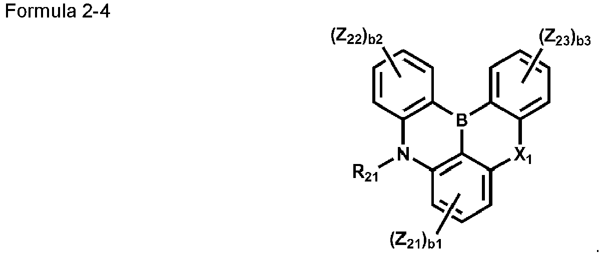

Details of Formula 2-4 may be as described herein.

In an embodiment, the boron halide may be BI₃ or BBr₃.

In an embodiment, when at least one of R₁ to R₃ in Formula 1 is a group represented by Formula 1-1, the group represented by Formula 1-1 may be introduced into the heterocyclic compound after the reacting of the intermediate compound or a derivative thereof with the boron halide:

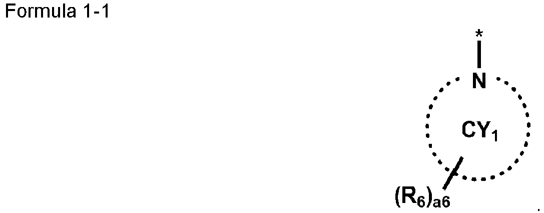

Details of Formula 1-1 may be as described herein.

In preparing a heterocyclic compound comprising boron (for example, the heterocyclic compound represented by Formula 1), in a method of the related art (for example, a process utilizing a Pd catalyst), when a substituent with large steric hindrance is present in a reactant (for example, when at least one of R₂₁ or R₂₂ in Formula 2-1a or 2-1b is a group represented by Formula 3), a reaction may not proceed or by-products may be produced, resulting in a significantly reduced yield, and the yield may converge to about 0 during large-scale synthesis. In contrast, according to the method of preparing a heterocyclic compound described above, even when a reactant comprises a substituent with large steric hindrance, a product may be obtained with high yield, and even when the number of moles of the reactant is increased, the yield of the product may not be reduced below a certain level. For example, according to the method of preparing a heterocyclic compound described above, the efficiency of a purification process following preparation of a final compound may be increased, so that economic efficiency may be improved and large-scale synthesis may be possible, thus enabling mass production of the heterocyclic compound.

According to one or more embodiments of the present disclosure,
a method of preparing a heterocyclic compound represented by Formula 1 comprises:
reacting an intermediate compound represented by Formula 2-3a or 2-3b or a derivative thereof with a boron halide,
wherein, at least one of R₁ to R₃ in Formula 1 is a group represented by Formula 1-1, and the group represented by Formula 1-1 may be introduced into the heterocyclic compound after the reacting of the intermediate compound or a derivative thereof with the boron halide:

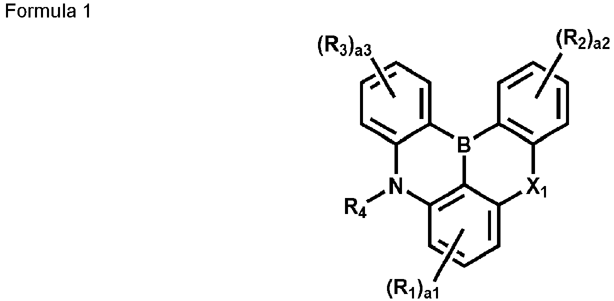

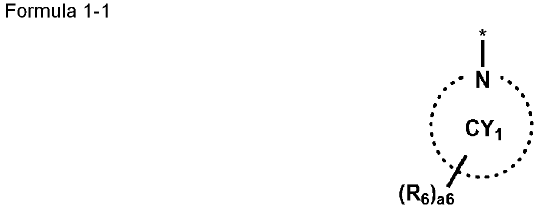

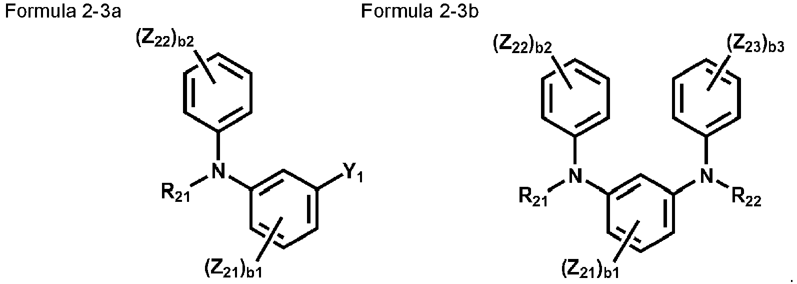

Details of Formulae 1, 1-1, 2-3a, and 2-3b may be as described herein.

In an embodiment, due to the reacting of the intermediate compound or a derivative thereof with the boron halide, for example, a compound represented by Formula 2-4 may be obtained:

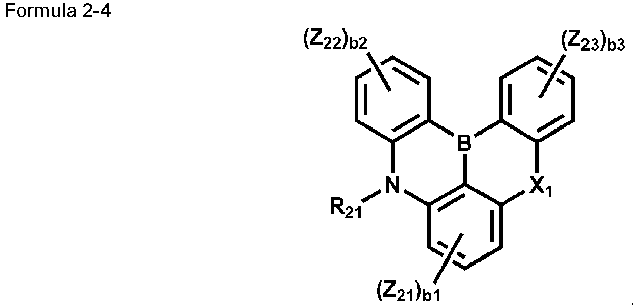

Details of Formula 2-4 may be as described herein.

In an embodiment, the boron halide may be BI₃ or BBr₃.

In an embodiment, Z₂₁ to Z₂₃ in Formulae 2-3a and 2-3b may not each be a group represented by Formula 1-1.

In an embodiment,
the method of preparing a heterocyclic compound may comprise:
obtaining a secondary intermediate compound represented by Formula 2-4 by reacting the intermediate compound or a derivative thereof with a boron halide; and
introducing the group represented by Formula 1-1 into at least one of Z₂₁ to Z₂₃ in the secondary intermediate compound.

In preparing a heterocyclic compound comprising boron (for example, the heterocyclic compound represented by Formula 1), when a substituent bonded to the heterocyclic compound through N is present in a final product (e.g., final synthesized product) (for example, when at least one of R₁ to R₃ in Formula 1 is a group represented by Formula 1-1), and when the substituent is introduced prior to boron (e.g., prior to adding boron to the reaction product), a reaction may not proceed or by-products may be produced, resulting in a significant decrease in the yield of the final product. However, according to the method of preparing a heterocyclic compound described above, because the substituent is introduced into the heterocyclic compound after boron has been introduced (e.g., boron has been added prior to the substituent), a reaction may proceed easily and production of by-products may be suppressed or reduced, so that the yield of the final product may be improved.

According to one or more embodiments of the present disclosure, a heterocyclic compound is represented by Formula 1, the heterocyclic compound being prepared according to the method of preparing a heterocyclic compound:

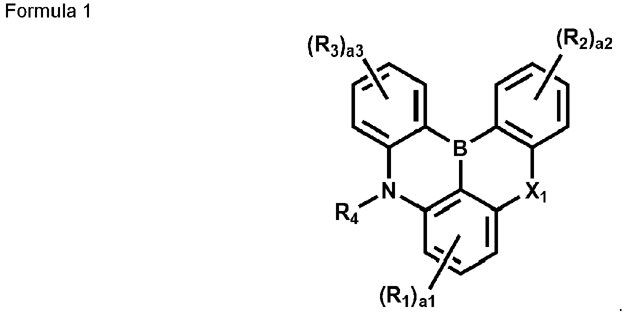

Details of Formula 1 may be as described herein.

In an embodiment, the heterocyclic compound may be to emit thermally activated delayed fluorescence (TADF).

In an embodiment, a difference between a triplet energy level (eV) of the heterocyclic compound and a singlet energy level (eV) of the heterocyclic compound may be greater than or equal to 0 eV and less than or equal to 0.5 eV (or, greater than or equal to 0 eV and less than or equal to 0.3 eV).

According to one or more embodiments of the present disclosure, a light-emitting device comprises:
a first electrode;
a second electrode facing the first electrode;
an interlayer arranged between the first electrode and the second electrode and comprising an emission layer; and
the heterocyclic compound.

In an embodiment,
the first electrode of the light-emitting device may be an anode,
the second electrode of the light-emitting device may be a cathode,
the interlayer may further comprise a hole transport region arranged between the first electrode and the emission layer and an electron transport region arranged between the emission layer and the second electrode,
the hole transport region may comprise a hole injection layer, a hole transport layer, an emission auxiliary layer, an electron blocking layer, or any combination thereof, and
the electron transport region may comprise a hole blocking layer, an electron transport layer, an electron injection layer, or any combination thereof.

In an embodiment, the emission layer of the light-emitting device may comprise a dopant and a host.

In an embodiment, the electron transport region of the light-emitting device may comprise a hole blocking layer, and the hole blocking layer may comprise a phosphine oxide-containing compound, a silicon-containing compound, or any combination thereof. For example, the hole blocking layer may directly contact the emission layer.

In an embodiment, the heterocyclic compound may be comprised in the interlayer.

In an embodiment, the heterocyclic compound may be comprised in the emission layer (e.g., as a first compound).

In an embodiment, the emission layer may further comprise: i) a transition metal-containing compound (e.g., as a second compound); ii) a third compound comprising at least one π electron-deficient nitrogen-containing C₁-C₆₀ heterocyclic group; iii) a fourth compound comprising a group represented by Formula 4; iv) or any combination thereof, and
the transition metal-containing compound, the third compound, and the fourth compound may be different from each other:

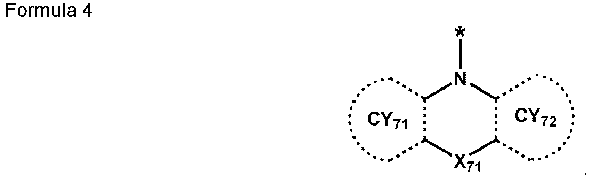

Details of Formula 4 may be as described herein.

In an embodiment, the transition metal-containing compound may be a compound represented by Formula 5:

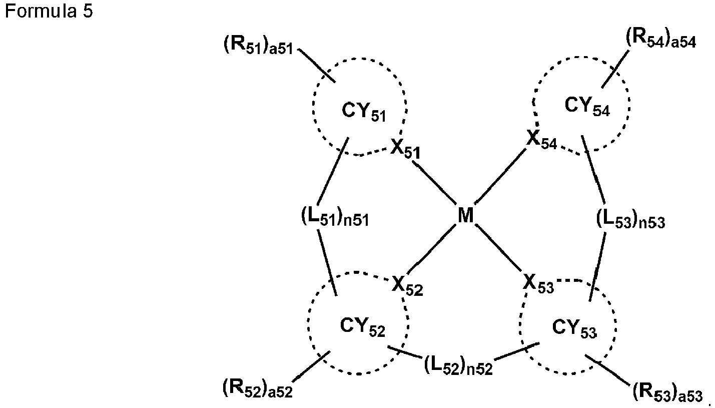

Details of Formula 5 may be as described herein.

In an embodiment, the heterocyclic compound may comprise at least one deuterium (D).

In one or more embodiments, the transition metal-containing compound, the third compound, or the fourth compound may comprise at least one deuterium.

In one or more embodiments, the light-emitting device may comprise the heterocyclic compound, a transition metal-containing compound, a third compound, and a fourth compound, and at least one of the third compound or the fourth compound may comprise at least one deuterium, at least one silicon, or any combination thereof.

In an embodiment, the light-emitting device (for example, the emission layer in the light-emitting device) may further comprise, in addition to the heterocyclic compound, a transition metal-containing compound. At least one of the heterocyclic compound or the transition metal-containing compound may comprise at least one deuterium. For example, the light-emitting device (for example, the emission layer in the light-emitting device) may further comprise, in addition to the heterocyclic compound and the transition metal-containing compound, a third compound, a fourth compound, or any combination thereof.

In one or more embodiments, the light-emitting device (for example, the emission layer in the light-emitting device) may further comprise, in addition to the heterocyclic compound, a third compound. At least one of the heterocyclic compound or the third compound may comprise at least one deuterium. For example, the light-emitting device (for example, the emission layer in the light-emitting device) may further comprise, in addition to the heterocyclic compound and the third compound, a transition metal-containing compound, a fourth compound, or any combination thereof.

In one or more embodiments, the light-emitting device (for example, the emission layer in the light-emitting device) may further comprise, in addition to the heterocyclic compound, a fourth compound. At least one of the heterocyclic compound or the fourth compound may comprise at least one deuterium. For example, the light-emitting device (for example, the emission layer in the light-emitting device) may further comprise, in addition to the heterocyclic compound and the fourth compound, a transition metal-containing compound, a third compound, or any combination thereof.

In one or more embodiments, the light-emitting device (for example, the emission layer in the light-emitting device) may further comprise, in addition to the heterocyclic compound, a third compound and a fourth compound. The third compound and the fourth compound may form an exciplex. At least one of the heterocyclic compound, the third compound, or the fourth compound may comprise at least one deuterium.

In one or more embodiments, the emission layer of the light-emitting device may comprise: i) the heterocyclic compound; and ii) the transition metal-containing compound, the third compound, the fourth compound, or any combination thereof, and the emission layer may be to emit blue light.

In one or more embodiments, a maximum emission wavelength of the blue light may be about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

For example, the third compound may comprise a pyridine group, a pyrimidine group, a pyrazine group, a pyridazine group, a triazine group, or any combination thereof.

In an embodiment, the fourth compound may not comprise (e.g., may exclude) the following compounds:

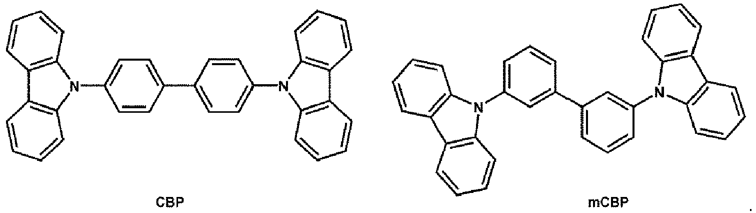

In an embodiment, the third compound may comprise a compound represented by Formula 6:

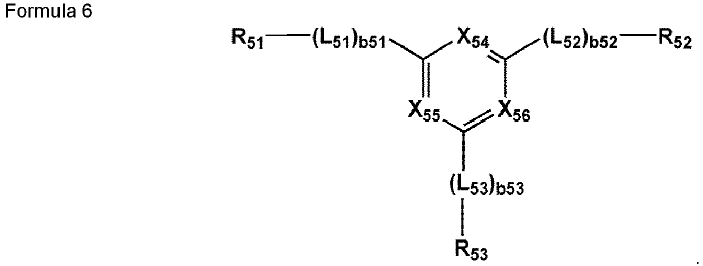

Details of Formula 6 may be as described herein.

In one or more embodiments, the fourth compound may comprise a compound represented by Formula 4-1, a compound represented by Formula 4-2, a compound represented by Formula 4-3, a compound represented by Formula 4-4, a compound represented by Formula 4-5, or any combination thereof:

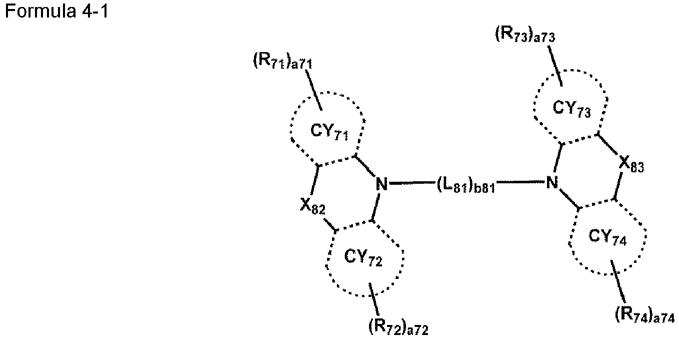

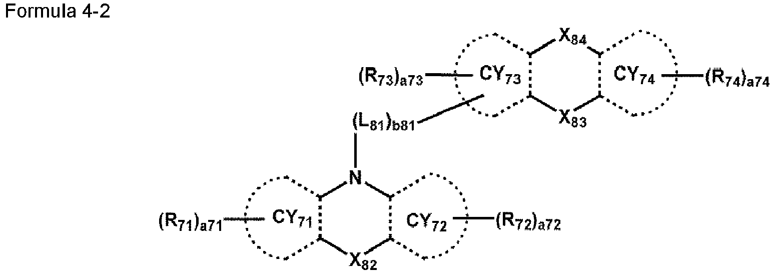

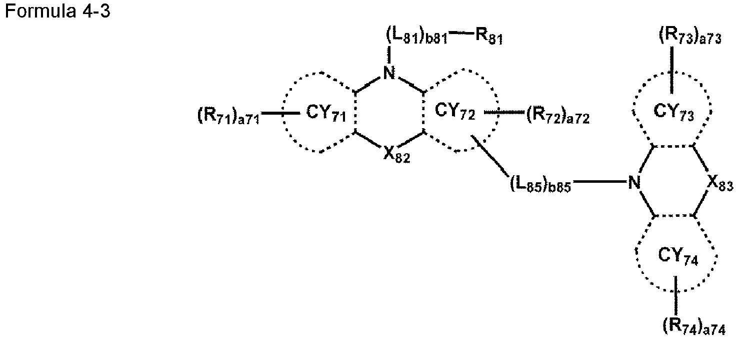

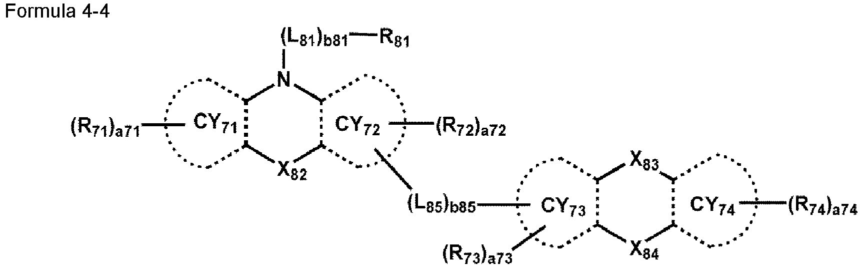

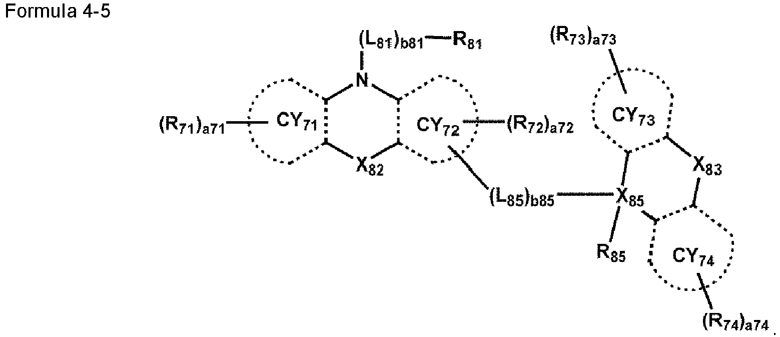

Details of Formulae 4-1 to 4-5 may be as described herein.

In an embodiment, the light-emitting device may satisfy at least one of Conditions 1 to 4:
Condition 1
   lowest unoccupied molecular orbital (LUMO) energy level (eV) of fourth compound > LUMO energy level (eV) of transition metal-containing compound;
Condition 2
   LUMO energy level (eV) of transition metal-containing compound > LUMO energy level (eV) of third compound;
Condition 3
   highest occupied molecular orbital (HOMO) energy level (eV) of transition metal-containing compound > HOMO energy level (eV) of fourth compound; and
Condition 4
   HOMO energy level (eV) of fourth compound > HOMO energy level (eV) of third compound.

Each of the HOMO energy level and LUMO energy level of each of the transition metal-containing compound, the third compound, and the fourth compound may be a negative value, and may be measured according to a suitable method.

In one or more embodiments, an absolute value of a difference between the LUMO energy level of the transition metal-containing compound and the LUMO energy level of the third compound may be greater than or equal to 0.1 eV and less than or equal to 1.0 eV, an absolute value of a difference between the LUMO energy level of the transition metal-containing compound and the LUMO energy level of the fourth compound may be greater than or equal to 0.1 eV and less than or equal to 1.0 eV, an absolute value of a difference between the HOMO energy level of the transition metal-containing compound and the HOMO energy level of the third compound may be less than or equal to 1.25 eV (for example, less than or equal to 1.25 eV and greater than or equal to 0.2 eV), and an absolute value of a difference between the HOMO energy level of the transition metal-containing compound and the HOMO energy level of the fourth compound may be less than or equal to 1.25 eV (for example, less than or equal to 1.25 eV and greater than or equal to 0.2 eV).

When the relationships between the LUMO energy level and the HOMO energy level satisfy the conditions described above, a balance between holes and electrons injected into the emission layer may be obtained.

The light-emitting device may have, for example, a structure of a first embodiment or a second embodiment.

### First embodiment

According to the first embodiment, the heterocyclic compound may be comprised in the emission layer in the interlayer of the light-emitting device, wherein the emission layer may further comprise the transition metal-containing compound and a host, and the heterocyclic compound, the transition metal-containing compound, and the host may be different from each other. The emission layer may be to emit phosphorescence or fluorescence emitted from the transition metal-containing compound. For example, the transition metal-containing compound may act as a dopant or an emitter, and the heterocyclic compound may act as an auxiliary dopant that improves luminescence efficiency by effectively transferring energy to the transition metal-containing compound.

In this regard, the phosphorescence or fluorescence emitted from the transition metal-containing compound may be blue light.

### Second embodiment

According to the second embodiment, the heterocyclic compound may be comprised in the emission layer in the interlayer of the light-emitting device, wherein the emission layer may further comprise the transition metal-containing compound and a host, and the heterocyclic compound, the transition metal-containing compound, and the host may be different from each other. The emission layer may be to emit phosphorescence or fluorescence (for example, delayed fluorescence) emitted from the heterocyclic compound. For example, the heterocyclic compound may act as a dopant or an emitter, and the transition metal-containing compound may act as an auxiliary dopant that improves luminescence efficiency by transferring energy to the heterocyclic compound.

For example, the phosphorescence or fluorescence emitted from the heterocyclic compound may be blue delayed fluorescence.

The blue light in the first embodiment and the second embodiment may be blue light having a maximum emission wavelength of about 390 nm to about 500 nm, about 410 nm to about 490 nm, about 430 nm to about 480 nm, about 440 nm to about 475 nm, or about 455 nm to about 470 nm.

The host in the first embodiment and the second embodiment may be any suitable host material (for example, a compound represented by Formula 301, a compound represented by 301-1, a compound represented by Formula 301-2, or any combination thereof).

In an embodiment, the host in the first embodiment and the second embodiment may be the third compound, the fourth compound, or any combination thereof.

In one or more embodiments, the light-emitting device may further comprise a capping layer arranged outside the first electrode and/or outside the second electrode.

For example, the light-emitting device may further comprise at least one of a first capping layer arranged outside the first electrode or a second capping layer arranged outside the second electrode, wherein at least one of the first capping layer or the second capping layer may comprise the heterocyclic compound represented by Formula 1. More details on the first capping layer and/or second capping layer may be as described herein.

In an embodiment, the light-emitting device may comprise:
a first capping layer arranged outside the first electrode and comprising the heterocyclic compound represented by Formula 1;
a second capping layer arranged outside the second electrode and comprising the heterocyclic compound represented by Formula 1; or
the first capping layer and the second capping layer.

The expression "(an interlayer and/or a capping layer) comprises at least one heterocyclic compound represented by Formula 1" as used herein may comprise a case in which "(an interlayer and/or a capping layer) comprises identical heterocyclic compounds represented by Formula 1" and a case in which "(an organic layer) comprises two or more different heterocyclic compounds represented by Formula 1."

For example, the interlayer and/or the capping layer may comprise Compound 1 only as the heterocyclic compound. In this regard, Compound 1 may be present in the emission layer of the light-emitting device. In an embodiment, the interlayer may comprise, as the heterocyclic compound, Compound 1 and Compound 2. In this regard, Compound 1 and Compound 2 may be present in substantially the same layer (for example, both Compound 1 and Compound 2 may be present in the emission layer), or may be present in different layers (for example, Compound 1 may be present in the emission layer, and Compound 2 may be present in the electron transport region).

The term "interlayer" as used herein refers to a single layer and/or all of a plurality of layers arranged between the first electrode and the second electrode of the light-emitting device.

According to one or more embodiments of the present disclosure, an electronic apparatus comprises the light-emitting device. For example, the electronic apparatus may further comprise a thin-film transistor, the thin-film transistor may comprise a source electrode and a drain electrode, wherein the first electrode of the light-emitting device may be electrically connected to the source electrode or the drain electrode of the thin-film transistor. In an embodiment, the electronic apparatus may further comprise a color filter, a color conversion layer, a touch screen layer, a polarizing layer, or any combination thereof. More details on the electronic apparatus may be as described herein.

According to one or more embodiments of the present disclosure, an electronic equipment comprises the light-emitting device.

For example, the electronic equipment may be a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and/or a signboard.

### Description of formulae

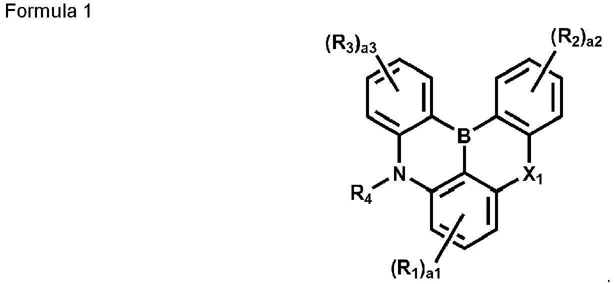

In Formula 1, X₁ may be N(R₁₁), O, S, or Se.

In an embodiment, X₁ may be N(R₁₁).

In Formula 1, R₁ to R₄ and R₁₁ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or-P(=O)(Q₁)(Q₂).

R₁₀ₐ and Q₁ to Q₃ may each be as defined herein.

In an embodiment, R₁ to R₄ and R₁₁ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂), and
Q₁ to Q₃ and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, R₁ to R₃ may each independently be:
hydrogen, deuterium, a hydroxyl group, a cyano group, a C₁-C₂₀ alkyl group, or a C₁-C₂₀ alkoxy group;
a C₁-C₂₀ alkyl group or a C₁-C₂₀ alkoxy group, each substituted with deuterium, -CD₃, - CD₂H, -CDH₂, a hydroxyl group, a cyano group, a C₁-C₂₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a triazolyl group, a tetrazolyl group, a triazinyl group, a benzocarbazolyl group, a dibenzocarbazolyl group, an imidazopyridinyl group, an imidazopyrimidinyl group, an azacarbazolyl group, or an azafluorenyl group, each unsubstituted or substituted with deuterium, -CD₃, -CD₂H, -CDH₂, a hydroxyl group, a cyano group, a C₁-C₂₀ alkyl group, a C₁-C₂₀ alkoxy group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, a pyrrolyl group, an imidazolyl group, a pyrazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a triazolyl group, a tetrazolyl group, a triazinyl group, a benzocarbazolyl group, a dibenzocarbazolyl group, an imidazopyridinyl group, an imidazopyrimidinyl group, an azacarbazolyl group, an azafluorenyl group, -O (Q₃₁), -S(Q₃₁), -Si(Q₃₁)(Q₃₂)(Q₃₃), N(Q₃₁)(Q₃₂), or any combination thereof; or
-C(Q₁)(Q₂)(Q₃), -Si(Q₁)(Q₂)(Q₃), or -N(Q₁)(Q₂), and
Q₁ to Q₃ and Q₃₁ to Q₃₃ may each independently be: hydrogen; deuterium; a hydroxyl group; a cyano group; a C₁-C₆₀ alkyl group; a C₂-C₆₀ alkenyl group; a C₂-C₆₀ alkynyl group; or a C₃-C₆₀ carbocyclic group or a C₁-C₆₀ heterocyclic group, each unsubstituted or substituted with deuterium, -F, a cyano group, a C₁-C₆₀ alkyl group, a phenyl group, a biphenyl group, or any combination thereof.

In an embodiment, R₄ and R₁₁ may each independently be:
hydrogen, deuterium, or a C₁-C₂₀ alkyl group;
a C₁-C₂₀ alkyl group substituted with deuterium, -CD₃, -CD₂H, -CDH₂, a C₁-C₁₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -CD₃, - CD₂H, -CDH₂, a C₁-C₂₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, -Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; a C₁-C₆₀ alkyl group; a C₂-C₆₀ alkenyl group; a C₂-C₆₀ alkynyl group; or a C₃-C₆₀ carbocyclic group or a C₁-C₆₀ heterocyclic group, each unsubstituted or substituted with deuterium, a C₁-C₆₀ alkyl group, a phenyl group, a biphenyl group, or any combination thereof.

In an embodiment, at least one of R₄ or R₁₁ may be a group represented by Formula 3.

In Formula 1, a1 indicates the number of R₁, and may be an integer from 1 to 3.

In Formula 1, a2 and a3 indicate the number of R₂ and the number of R₃, respectively, and may each independently be an integer from 1 to 4.

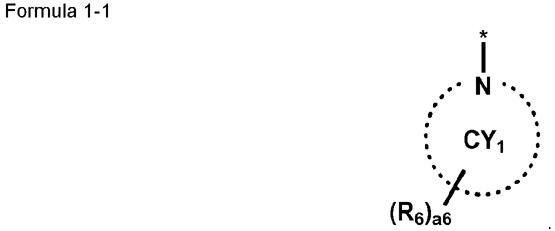

In Formula 1-1, CY₁ may be a C₅-C₃₀ carbocyclic group or a C₁-C₃₀ heterocyclic group.

In an embodiment, CY₁ may be a pyrrole group, a pyrazole group, an imidazole group, a triazole group, an oxazole group, an isoxazole group, an oxadiazole group, a thiazole group, an isothiazole group, a thiadiazole group, a pyridine group, a pyrimidine group, a pyrazine group, a pyridazine group, an indole group, an isoindole group, a carbazole group, a benzocarbazole group, a dibenzocarbazole group, an azaindole group, an azacarbazole group, an azabenzocarbazole group, or an azadibenzocarbazole group.

In Formula 1-1, R₆ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂).

R₁₀ₐ and Q₁ to Q₃ may each be as defined herein.

In an embodiment, R₆ may be hydrogen, deuterium, a C₁-C₂₀ alkyl group, a C₂-C₂₀ alkenyl group, a C₂-C₂₀ alkynyl group, a C₃-C₂₀ cycloalkyl group, a C₃-C₂₀ cycloalkenyl group, a C₃-C₂₀ cycloalkynyl group, a phenyl group, or a biphenyl group.

In Formula 1-1, a6 indicates the number of R₆, and may be an integer from 1 to 10.

In Formula 1-1, * indicates a binding site to a neighboring atom.

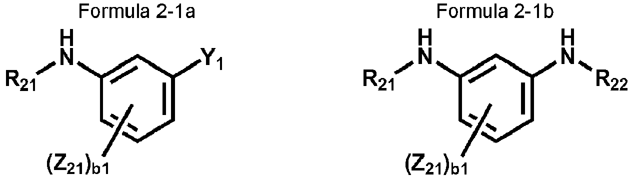

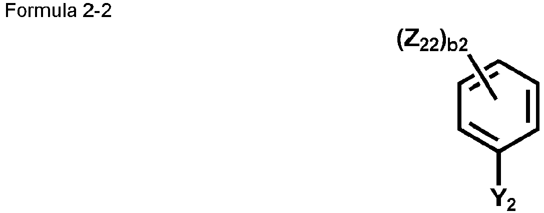

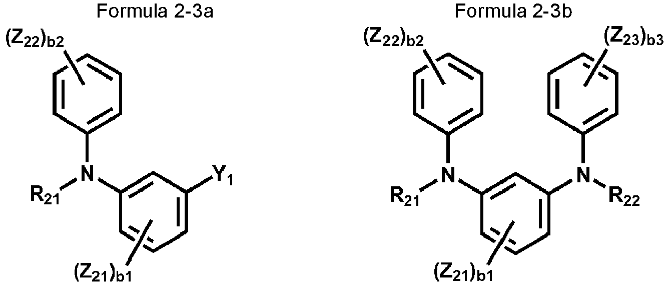

In Formulae 2-1a, 2-1b, 2-2, 2-3a, and 2-3b, Y₁ and Y₂ may each independently be -F, -Cl, - Br, or -I.

In Formulae 2-1a, 2-1b, 2-2, 2-3a, and 2-3b, R₂₁, R₂₂, and Z₂₁ to Z₂₃ may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, - Si(Q₁)(Q₂)(Q₃), -B(Q₁)(Q₂), -C(=O)(Q₁), -S(=O)₂(Q₁), or-P(=O)(Q₁)(Q₂).

R₁₀ₐ and Q₁ to Q₃ may each be as defined herein.

In an embodiment, two or more adjacent groups selected from R₂₁, R₂₂, and Z₂₁ to Z₂₃ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ.

R₁₀ₐ may be as defined herein.

In an embodiment, R₂₁ and R₂₂ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂).
Q₁ to Q₃ and Q₃₁ to Q₃₃ may each be as defined herein.
In an embodiment, R₂₁ and R₂₂ may each independently be:
hydrogen, deuterium, -F, -Cl, -Br, -I, or a C₁-C₂₀ alkyl group;
a C₁-C₂₀ alkyl group substituted with deuterium, -F, -Cl, -Br, -I, -CD₃, -CD₂H, -CDH₂, -CF₃, - CF₂H, -CFH₂, a C₁-C₁₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -F, -Cl, -Br, -I, -CD₃, -CD₂H, -CDH₂, -CF₃, -CF₂H, -CFH₂, a C₁-C₂₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, - Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; -F; -Cl; -Br; -I; a C₁-C₆₀ alkyl group; a C₂-C₆₀ alkenyl group; a C₂-C₆₀ alkynyl group; or a C₃-C₆₀ carbocyclic group or a C₁-C₆₀ heterocyclic group, each unsubstituted or substituted with deuterium, -F, a C₁-C₆₀ alkyl group, a phenyl group, a biphenyl group, or any combination thereof.

In an embodiment, Z₂₁ to Z₂₃ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or - P(=O)(Q₁)(Q₂).
Q₁ to Q₃ and Q₃₁ to Q₃₃ may each be as defined herein.
In an embodiment, Z₂₁ to Z₂₃ may each independently be:
hydrogen, deuterium, -F, -Cl, -Br, -I, or a C₁-C₂₀ alkyl group;
a C₁-C₂₀ alkyl group substituted with deuterium, -F, -Cl, -Br, -I, -CD₃, -CD₂H, -CDH₂, -CF₃, - CF₂H, -CFH₂, a C₁-C₁₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -F, -Cl, -Br, -I, -CD₃, -CD₂H, -CDH₂, -CF₃, -CF₂H, -CFH₂, a C₁-C₂₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, - Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; -F; -Cl; -Br; -I; a C₁-C₆₀ alkyl group; a C₂-C₆₀ alkenyl group; a C₂-C₆₀ alkynyl group; or a C₃-C₆₀ carbocyclic group or a C₁-C₆₀ heterocyclic group, each unsubstituted or substituted with deuterium, -F, a C₁-C₆₀ alkyl group, a phenyl group, a biphenyl group, or any combination thereof.

In an embodiment, Z₂₁ to Z₂₃ may not each be a group represented by Formula 1-1.

In an embodiment, at least one of R₂₁ or R₂₂ may be a group represented by Formula 3.

In Formulae 2-1a, 2-1b, 2-2, 2-3a, and 2-3b, b1 indicates the number of Z₂₁, and may be an integer from 1 to 4.

In Formulae 2-1a, 2-1b, 2-2, 2-3a, and 2-3b, b2 and b3 indicate the number of Z₂₂ and the number of Z₂₃, respectively, and may each independently be an integer from 1 to 5.

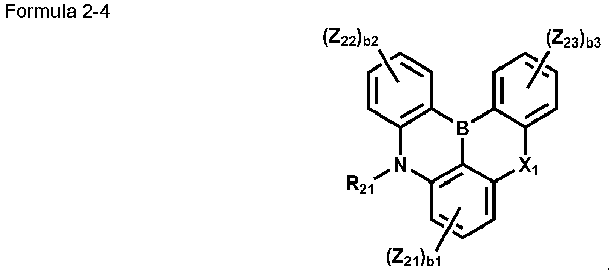

In Formula 2-4, X₁ may be defined the same as X₁ in Formula 1.

In Formula 2-4, R₂₁, Z₂₁ to Z₂₃, and b1 to b3 may be defined the same as R₂₁, Z₂₁ to Z₂₃, and b1 to b3 in Formulae 2-3a and 2-3b, respectively.

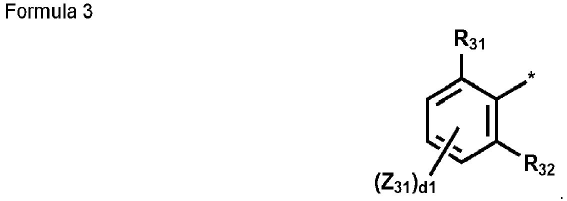

In Formula 3, R₃₁, R₃₂, and Z₃₁ may each independently be hydrogen, deuterium, -F, -Cl, - Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or-P(=O)(Q₁)(Q₂).

R₁₀ₐ and Q₁ to Q₃ may each be as defined herein.

In an embodiment, two or more adjacent groups selected from R₃₁, R₃₂, and Z₃₁ may optionally be bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ.

R₁₀ₐ may be as defined herein.

In an embodiment, at least one of R₃₁ or R₃₂ may be a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, or -Si(Q₁)(Q₂)(Q₃).

R₁₀ₐ and Q₁ to Q₃ may each be as defined herein.

In an embodiment, R₃₁, R₃₂, and Z₃₁ may each independently be:
hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, - I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -O(Q₃₁), -S(Q₃₁), -Si(Q₃₁)(Q₃₂)(Q₃₃), -N(Q₃₁)(Q₃₂), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or-P(=O)(Q₁)(Q₂).
Q₁ to Q₃ and Q₃₁ to Q₃₃ may each be as defined herein.

In an embodiment, R₃₁, R₃₂, and Z₃₁ may each independently be:
hydrogen, deuterium, -F, -Cl, -Br, -I, or a C₁-C₂₀ alkyl group;
a C₁-C₂₀ alkyl group substituted with deuterium, -F, -Cl, -Br, -I, -CD₃, -CD₂H, -CDH₂, -CF₃, - CF₂H, -CFH₂, a C₁-C₁₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a naphthyl group, or any combination thereof;
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with deuterium, -F, -Cl, -Br, -I, -CD₃, -CD₂H, -CDH₂, -CF₃, -CF₂H, -CFH₂, a C₁-C₂₀ alkyl group, a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, - Si(Q₃₁)(Q₃₂)(Q₃₃), or any combination thereof; or
-C(Q₁)(Q₂)(Q₃) or -Si(Q₁)(Q₂)(Q₃), and
Q₁ to Q₃ and Q₃₁ to Q₃₃ may each independently be: hydrogen; deuterium; -F; -Cl; -Br; -I; a C₁-C₆₀ alkyl group; a C₂-C₆₀ alkenyl group; a C₂-C₆₀ alkynyl group; or a C₃-C₆₀ carbocyclic group or a C₁-C₆₀ heterocyclic group, each unsubstituted or substituted with deuterium, -F, a C₁-C₆₀ alkyl group, a phenyl group, a biphenyl group, or any combination thereof.

In an embodiment, at least one of R₃₁ or R₃₂ may be
a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, or a naphthyl group, each unsubstituted or substituted with a cyclopentyl group, a cyclohexyl group, a cycloheptyl group, a cyclooctyl group, a cyclopentenyl group, a cyclohexenyl group, a cycloheptenyl group, a phenyl group, a biphenyl group, a C₁-C₁₀ alkylphenyl group, a naphthyl group, or any combination thereof.

In an embodiment, Z₃₁ may not be a group represented by Formula 1-1.

In Formula 3, d1 indicates the number of Z₃₁, and may be an integer from 1 to 3.

In Formula 3, * indicates a binding site to a neighboring atom.

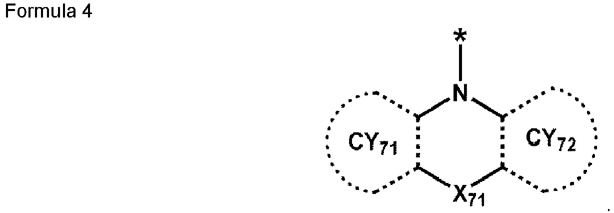

In Formula 4,
ring CY₇₁ and ring CY₇₂ may each independently be a π electron-rich C₃-C₆₀ cyclic group or a pyridine group,
X₇₁ may be a single bond, or a linking group comprising O, S, N, B, C, Si, or any combination thereof, and
* indicates a binding site to any atom included in a remaining portion of the fourth compound other than the group represented by Formula 4.

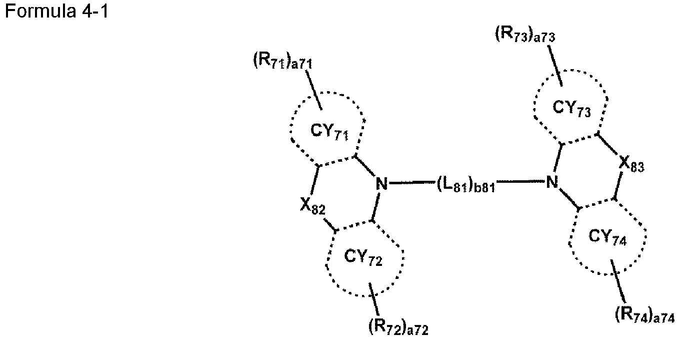

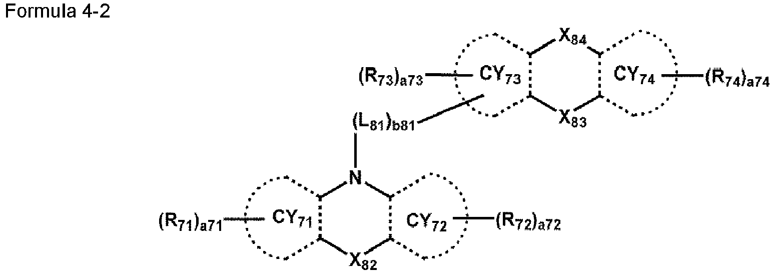

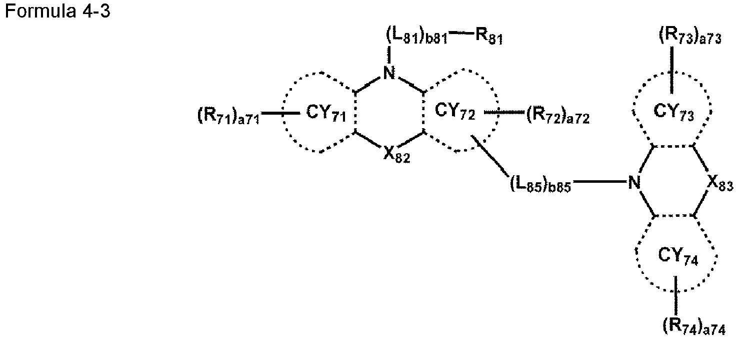

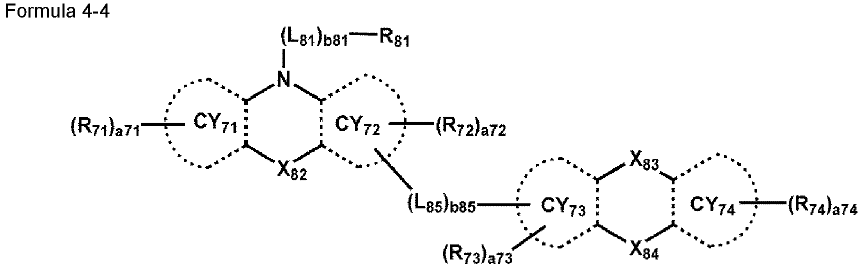

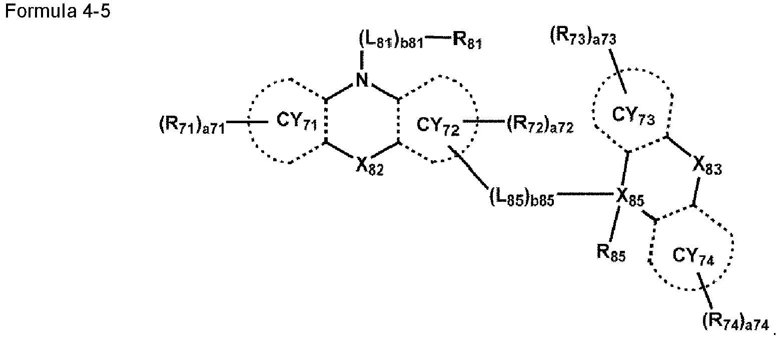

In Formulae 4-1 to 4-5,
ring CY₇₁ to ring CY₇₄ may each independently be a π electron-rich C₃-C₆₀ cyclic group or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each independently be defined the same as Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be as defined herein,
a71 to a74 may each independently be an integer from 0 to 20, and
R₁₀ₐ may be as defined herein.

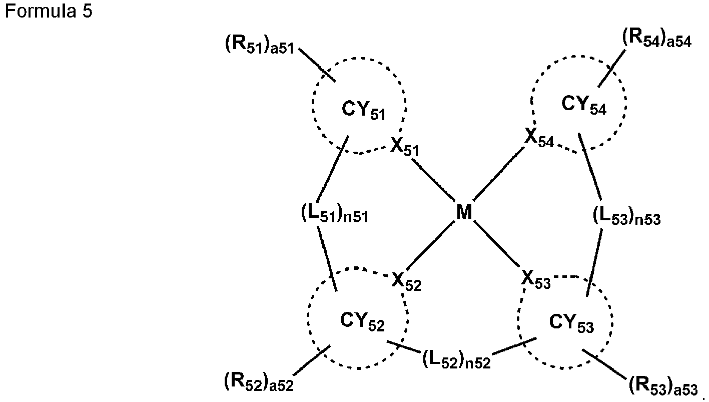

In Formula 5, M may be platinum (Pt), palladium (Pd), copper (Cu), silver (Ag), gold (Au), rhodium (Rh), ruthenium (Ru), osmium (Os), titanium (Ti), zirconium (Zr), hafnium (Hf), europium (Eu), terbium (Tb), or thulium (Tm).

In an embodiment, M may be Pt.

In Formula 5, X₅₁ to X₅₄ may each independently be C or N.

In an embodiment, X₅₁ may be C. For example, X₅₁ in Formula 3 may be C, and C may be carbon of a carbene moiety.

In an embodiment, X₅₂ and X₅₃ may each be C, and X₅₄ may be N.

In Formula 5, i) a bond between X₅₁ and M may be a coordinate bond, and ii) one of a bond between X₅₂ and M, a bond between X₅₃ and M, and a bond between X₅₄ and M may be a coordinate bond, and the other two (e.g., the remaining two) may each be a covalent bond.

For example, a bond between X₅₁ and M and a bond between X₅₄ and M may each be a coordinate bond, and a bond between X₅₂ and M and a bond between X₅₃ and M may each be a covalent bond.

In Formula 5, ring CY₅₁ to ring CY₅₄ may each independently be a C₅-C₃₀ carbocyclic group or a C₁-C₃₀ heterocyclic group.

For example, ring CY₅₁ may be a nitrogen-containing C₁-C₆₀ heterocyclic group.

In Formula 5, ring CY₅₁ may be i) an X₅₁-containing 5-membered ring, ii) an X₅₁-containing 5-membered ring in which at least one 6-membered ring is condensed, or iii) an X₅₁-containing 6-membered ring. In an embodiment, ring CY₅₁ in Formula 5 may be i) an X₅₁-containing 5-membered ring or ii) an X₅₁-containing 5-membered ring in which at least one 6-membered ring is condensed. For example, ring CY₅₁ may comprise a 5-membered ring bonded to M in Formula 5 via X₅₁. In this regard, the X₅₁-containing 5-membered ring may be a pyrrole group, a pyrazole group, an imidazole group, a triazole group, an oxazole group, an isoxazole group, a thiazole group, an isothiazole group, an oxadiazole group, or a thiadiazole group, and the X₅₁-containing 6-membered ring and the 6-membered ring which may be optionally condensed to the X₅₁-containing 5-membered ring may each independently be a benzene group, a pyridine group, or a pyrimidine group.

In one or more embodiments, ring CY₅₁ may be an imidazole group, a triazole group, a benzimidazole group, or an imidazopyridine group.

In one or more embodiments, ring CY₅₂ may be a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenbenzosilole group, an azadinaphthofuran group, an azadinaphthothiophene group, an azadibenzocarbazole group, an azadibenzofluorene group, or an azadinaphthosilole group.

In Formula 5, ring CY₅₃ may be: a C₂-C₈ monocyclic group; or a C₄-C₂₀ polycyclic group in which two or three C₂-C₈ monocyclic groups are condensed with each other.

The term "C₂-C₈ monocyclic group" as used herein refers to a non-condensed cyclic group. For example, the C₂-C₈ monocyclic group may be a cyclopentadiene group, a pyrrole group, a pyrazole group, an imidazole group, a triazole group, an oxazole group, an isoxazole group, a thiazole group, an isothiazole group, an oxadiazole group, a thiadiazole group, a benzene group, a pyridine group, a pyrimidine group, a pyrazine group, a pyridazine group, a triazine group, a cycloheptadiene group, or a cyclooctadiene group.

For example, ring CY₅₃ may be a benzene group, a pyridine group, a pyrimidine group, a naphthalene group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

In Formula 5, ring CY₅₄ may be a nitrogen-containing C₁-C₆₀ heterocyclic group.

For example, ring CY₅₄ may be a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, a benzopyrazole group, a benzimidazole group, or a benzothiazole group.

In Formula 5, L₅₁ to L₅₃ may each independently be a single bond, *-C(R₁ₐ)(R_{1b})-*', *-C(R₁ₐ)=*', *=C(R₁ₐ)-*', *-C(R₁ₐ)=C(R_{1b})-*', *-C(=O)-*', *-C(=S)-*', *-C≡C-*', *-B(R₁ₐ)-*', *-N(R₁ₐ)-*', *-O-*', *-P(R₁ₐ)-*', *-Si(R₁ₐ)(R_{1b})-*', *-P(=O)(R₁ₐ)-*', *-S-*', *-S(=O)-*', *-S(=O)₂-*', or *-Ge(R₁ₐ)(R_{1b})-*', wherein * and *' each indicate a binding site to a neighboring atom.

R₁ₐ and R_{1b} may each be as defined herein.

In Formula 5, n51 to n53 indicate the number of L₅₁, L₅₂, and L₅₃, respectively, and may each independently be an integer from 1 to 5. When each of n51 to n53 is 2 or more, each of two or more of L₅₁ to two or more of L₅₃ may be identical to or different from each other.

In Formula 5, R₅₁ to R₅₄, R₁ₐ, and R_{1b} may each independently be hydrogen, deuterium, -F, - Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), or-P(=O)(Q₁)(Q₂).

R₁₀ₐ, Q₁, Q₂, and Q₃ may each be as defined herein.

In Formula 5, a51 to a54 indicate the number of R₅₁, R₅₂, R₅₃, and R₅₄, respectively, and may each independently be an integer from 1 to 10. When each of a51 to a54 is 2 or more, each of two or more of R₅₁ to two or more of R₅₄ may be identical to or different from each other.

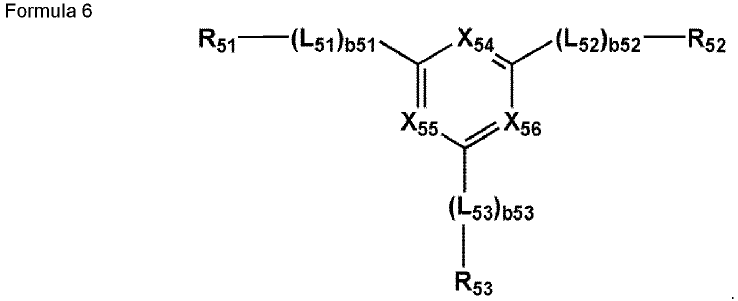

In Formula 6,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one of X₅₄ to X₅₆ may be N, and
R₅₁ to R₅₆ and R₁₀ₐ may each be as defined herein.

Unless otherwise defined, R₁₀ₐ in Formulae 1, 2-1a, 2-1b, 2-2, 2-3a, 2-3b, 2-4, 3, 4, 4-1 to 4-5, 5, and 6 may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -B(Q₃₁)(Q₃₂), -C(=O)(Q₃₁), -S(=O)₂(Q₃₁), or -P(=O)(Q₃₁)(Q₃₂).

Unless otherwise defined, Q₁ to Q₃, Q₁₁ to Q₁₃, Q₂₁ to Q₂₃, and Q₃₁ to Q₃₃ in Formulae 1, 2-1a, 2-1b, 2-2, 2-3a, 2-3b, 2-4, 3, 4, 4-1 to 4-5, 5, and 6 may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₃-C₆₀ carbocyclic group, a C₁-C₆₀ heterocyclic group, or any combination thereof.

### Examples of compounds

In an embodiment, the heterocyclic compound may be selected from Compounds 1 to 6:

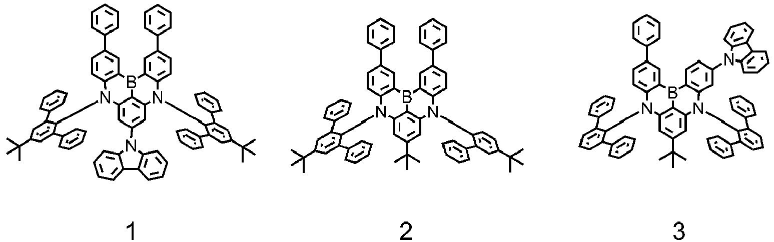

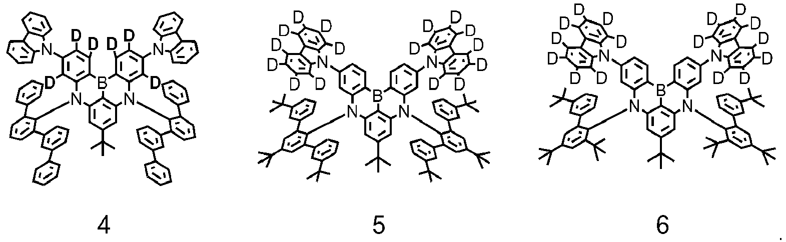

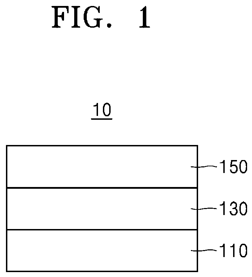

### Description of FIG. 1

FIG. 1 is a schematic cross-sectional view of a light-emitting device 10 according to an embodiment. The light-emitting device 10 comprises a first electrode 110, an interlayer 130, and a second electrode 150.

Hereinafter, the structure of the light-emitting device 10 according to an embodiment and a method of manufacturing the light-emitting device 10 will be described with reference to FIG. 1.

### First electrode 110

In FIG. 1, a substrate may be additionally arranged under the first electrode 110 or on the second electrode 150. In an embodiment, as the substrate, a glass substrate and/or a plastic substrate may be utilized. In one or more embodiments, the substrate may be a flexible substrate, and may comprise plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing or sputtering a material for forming the first electrode 110 on the substrate. When the first electrode 110 is an anode, a material for forming the first electrode 110 may be a high-work function material that can facilitate injection of holes.

The first electrode 110 may be a reflective electrode, a semi-transmissive electrode, or a transmissive electrode. In an embodiment, when the first electrode 110 is a transmissive electrode, a material for forming the first electrode 110 may comprise indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may comprise magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure consisting of a single layer or a multi-layer structure comprising multiple layers. For example, the first electrode 110 may have a three-layer structure of ITO/Ag/ITO.

### Interlayer 130

The interlayer 130 is arranged on the first electrode 110. The interlayer 130 comprises an emission layer.

The interlayer 130 may further comprise a hole transport region arranged between the first electrode 110 and the emission layer, and an electron transport region arranged between the emission layer and the second electrode 150.

In an embodiment, the interlayer 130 may further comprise, in addition to one or more suitable organic materials, a metal-containing compound such as a transition metal-containing compound, an inorganic material such as a quantum dot, and/or the like.

In one or more embodiments, the interlayer 130 may comprise i) two or more emitting units sequentially stacked between the first electrode 110 and the second electrode 150, and ii) a charge generation layer arranged between two neighboring emitting units. When the interlayer 130 comprises the two or more emitting units and the charge generation layer, the light-emitting device 10 may be a tandem light-emitting device.

### Hole transport region in interlayer 130

The hole transport region may have i) a single-layer structure consisting of a single layer consisting of a single material, ii) a single-layer structure consisting of a single layer comprising (e.g., consisting of) multiple materials that are different from each other, or iii) a multi-layer structure comprising multiple layers comprising multiple materials that are different from each other.

The hole transport region may comprise a hole injection layer, a hole transport layer, an emission auxiliary layer, an electron blocking layer, or any combination thereof.

For example, the hole transport region may have a multi-layer structure comprising a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110 in the respective stated order.

The hole transport region may comprise a compound represented by Formula 201, a compound represented by Formula 202, or any combination thereof:

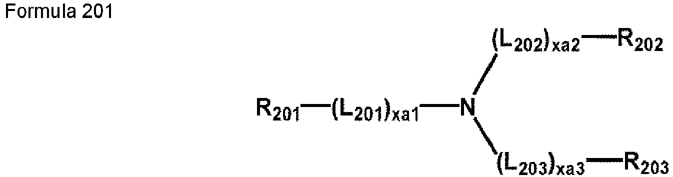

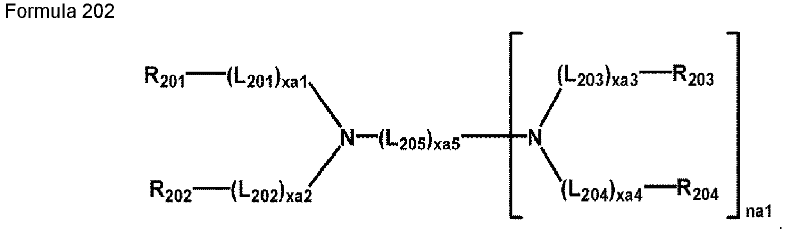

In Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group, etc.) unsubstituted or substituted with at least one R₁₀ₐ (for example, Compound HT16, etc.),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may comprise at least one of the groups represented by Formulae CY201 to CY217:

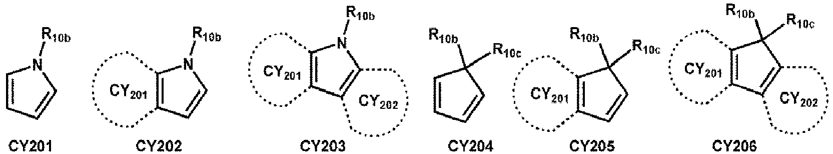

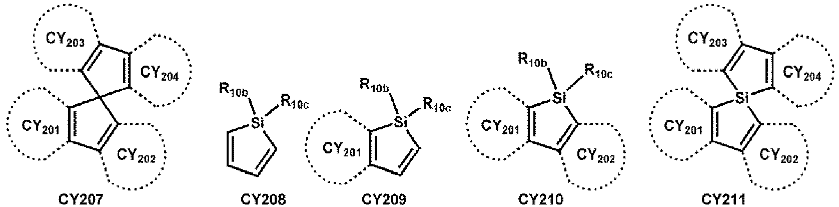

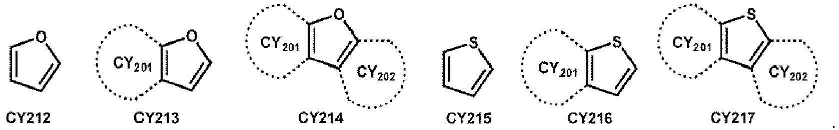

In Formulae CY201 to CY217, R_{10b} and R_{10c} may each be defined the same as R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may comprise at least one of the groups represented by Formulae CY201 to CY203.

In one or more embodiments, Formula 201 may comprise at least one of the groups represented by Formulae CY201 to CY203 and at least one of the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not comprise (e.g., may exclude) any of the groups represented by Formulae CY201 to CY203.

In one or more embodiments, each of Formulae 201 and 202 may not comprise (e.g., may exclude) any of the groups represented by Formulae CY201 to CY203, and may comprise at least one of the groups represented by Formulae CY204 to CY217.

In one or more embodiments, each of Formulae 201 and 202 may not comprise (e.g., may exclude) any of the groups represented by Formulae CY201 to CY217.

For example, the hole transport region may comprise at least one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

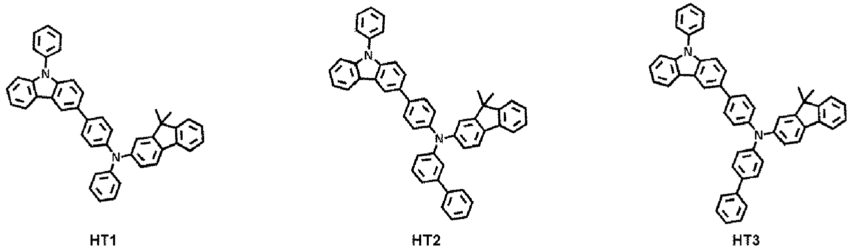

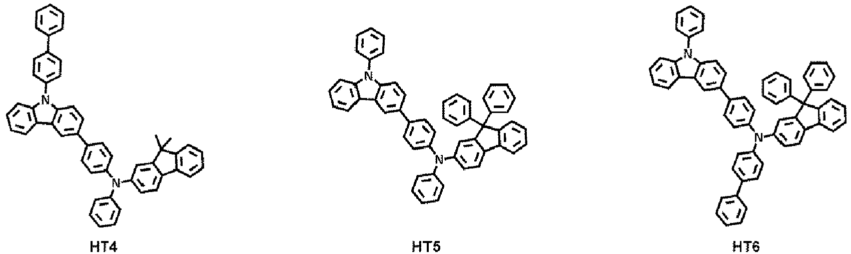

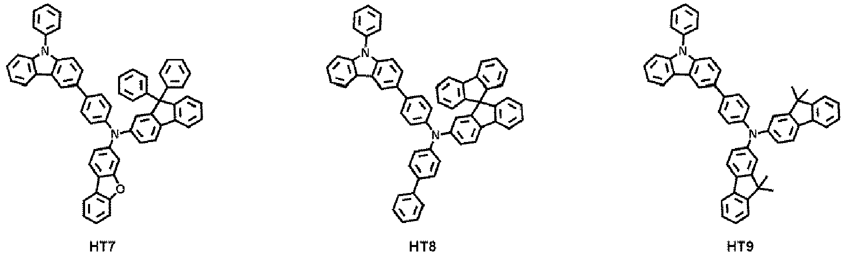

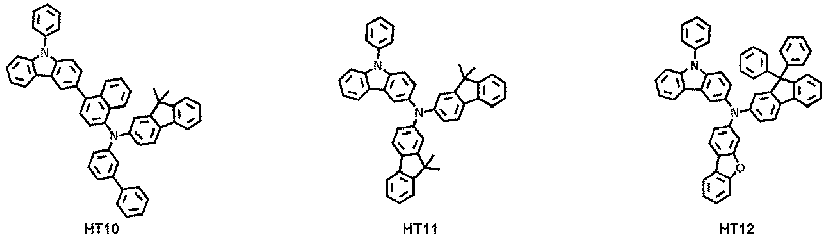

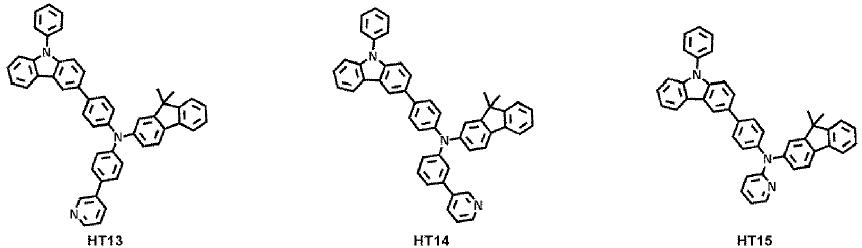

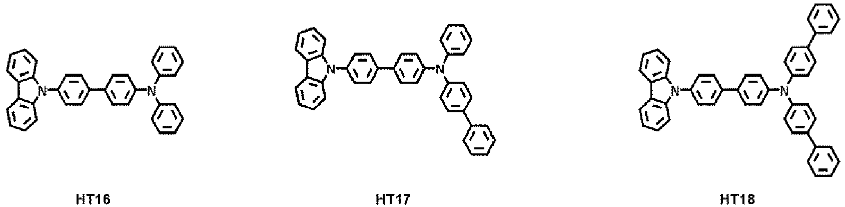

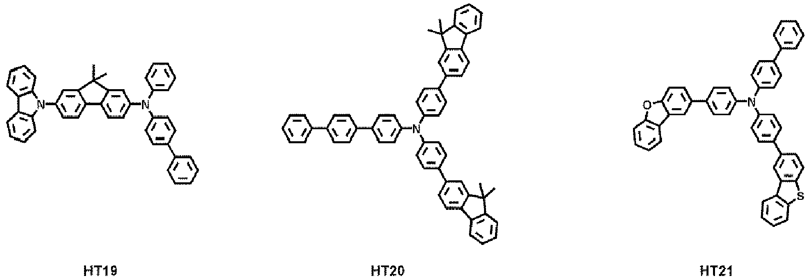

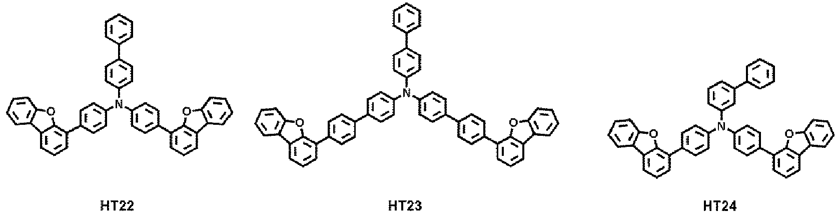

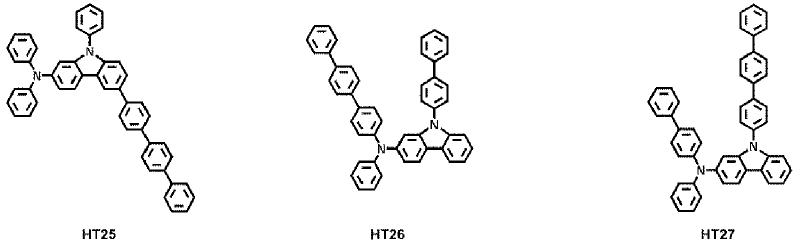

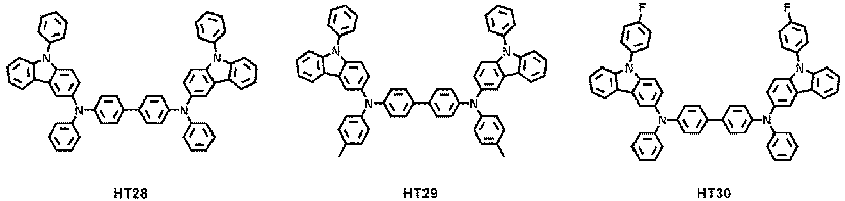

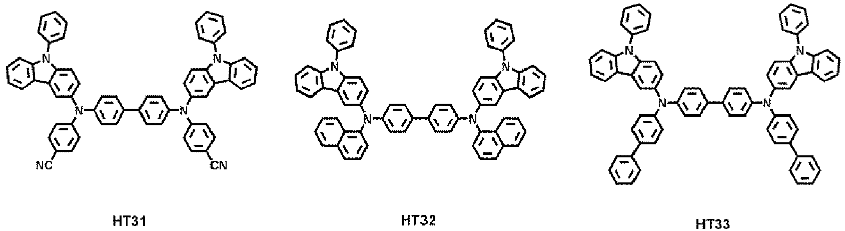

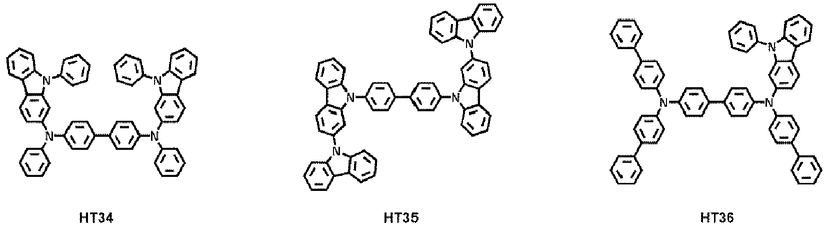

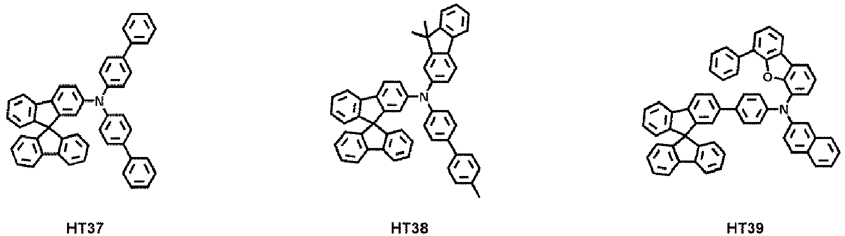

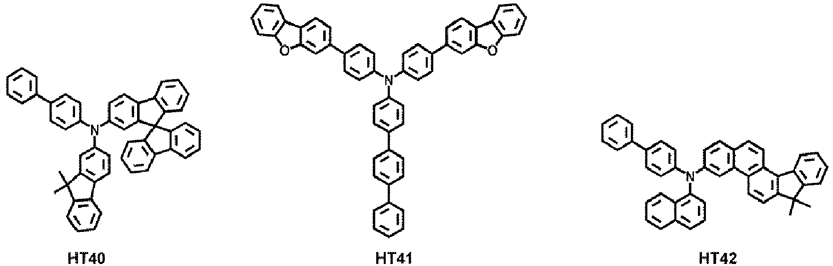

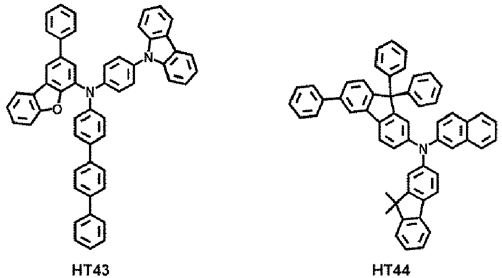

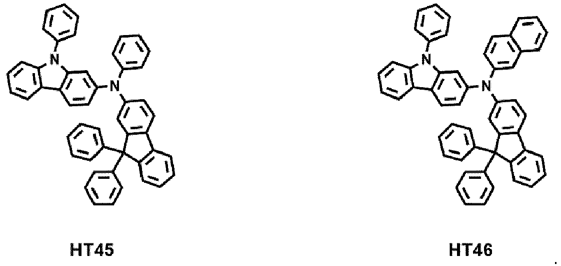

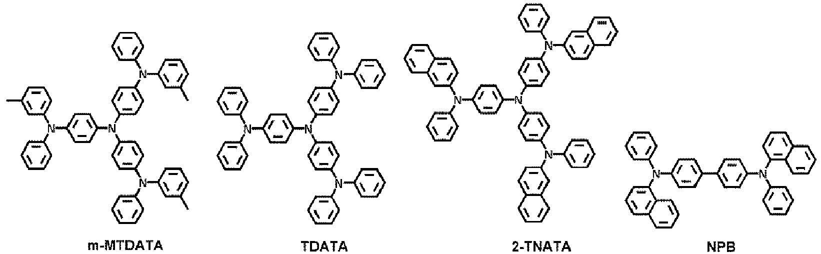

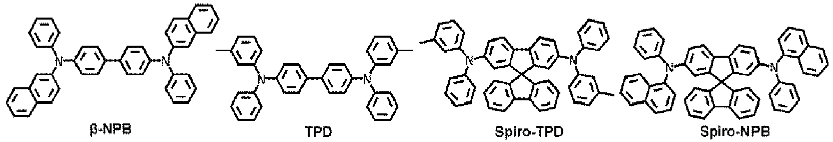

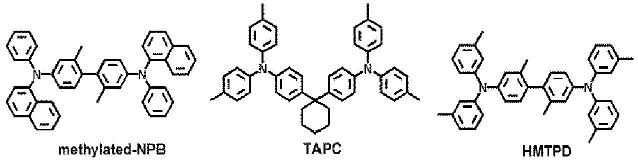

A thickness of the hole transport region may be about 50 Å to about 10,000 Å, for example, about 100 Å to about 4,000 Å. When the hole transport region comprises a hole injection layer, a hole transport layer, or any combination thereof, a thickness of the hole injection layer may be about 100 Å to about 9,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer are within the ranges described above, suitable or satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be comprised in the hole transport region may be comprised in the emission auxiliary layer and the electron blocking layer.

### p-dopant

The hole transport region may further comprise, in addition to the materials described above, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the p-dopant may have a LUMO energy level of less than or equal to -3.5 eV.

In an embodiment, the p-dopant may comprise a quinone derivative, a cyano group-containing compound, a compound comprising element EL1 and element EL2, or any combination thereof.

Examples of the quinone derivative may comprise TCNQ, F4-TCNQ, and/or the like.

Examples of the cyano group-containing compound may comprise HAT-CN, a compound represented by Formula 221, and/or the like:

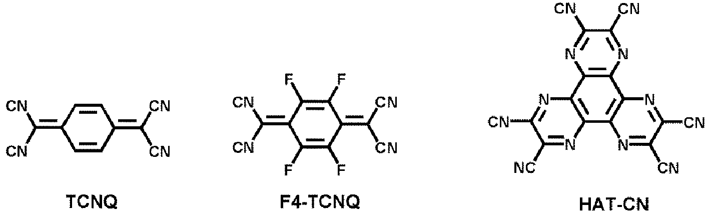

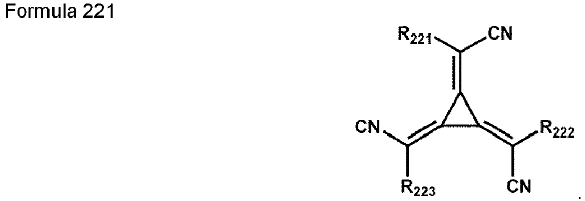

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, -I, or any combination thereof; or any combination thereof.

In the compound comprising element EL1 and element EL2, element EL1 may be metal, metalloid, or any combination thereof, and element EL2 may be non-metal, metalloid, or any combination thereof.

Examples of the metal may comprise (e.g., may be): an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and/or the like.

Examples of the metalloid may comprise (e.g., may be) silicon (Si), antimony (Sb), tellurium (Te), and/or the like.

Examples of the non-metal may comprise (e.g., may be) oxygen (O), halogen (for example, F, Cl, Br, I, etc.), and/or the like.

Examples of the compound comprising element EL1 and element EL2 may comprise (e.g., may be) a metal oxide, a metal halide (for example, a metal fluoride, a metal chloride, a metal bromide, a metal iodide, etc.), a metalloid halide (for example, a metalloid fluoride, a metalloid chloride, a metalloid bromide, a metalloid iodide, etc.), a metal telluride, or any combination thereof.

Examples of the metal oxide may comprise (e.g., may be) tungsten oxide (for example, WO, W₂O₃, WO₂, WO₃, WzOs, etc.), vanadium oxide (for example, VO, V₂O₃, VO₂, VzOs, etc.), molybdenum oxide (MoO, MozOs, MoO₂, MoOs, MozOs, etc.), rhenium oxide (for example, ReOs, etc.), and/or the like.

Examples of the metal halide may comprise (e.g., may be) an alkali metal halide, an alkaline earth metal halide, a transition metal halide, a post-transition metal halide, a lanthanide metal halide, and/or the like.

Examples of the alkali metal halide may comprise (e.g., may be) LiF, NaF, KF, RbF, CsF, LiCI, NaCl, KCI, RbCI, CsCI, LiBr, NaBr, KBr, RbBr, CsBr, Lil, Nal, KI, Rbl, Csl, and/orthe like.

Examples of the alkaline earth metal halide may comprise (e.g., may be) BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and/orthe like.

Examples of the transition metal halide may comprise (e.g., may be) titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBrs, VI₃, etc.), niobium halide (for example, NbFs, NbCl₃, NbBr₃, NbI₃, etc.), tantalum halide (for example, TaF₃, TaCl₃, TaBr₃, TaI₃, etc.), chromium halide (for example, CrFs, CrCl₃, CrBr₃, CrI₃, etc.), molybdenum halide (for example, MoF₃, MoCl₃, MoBr₃, MoI₃, etc.), tungsten halide (for example, WF₃, WCl₃, WBrs, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCI, CuBr, Cul, etc.), silver halide (for example, AgF, AgCl, AgBr, Agl, etc.), gold halide (for example, AuF, AuCI, AuBr, Aul, etc.), and/orthe like.

Examples of the post-transition metal halide may comprise (e.g., may be) zinc halide (for example, ZnF₂, ZnCl₂, ZnBr₂, ZnI₂, etc.), indium halide (for example, InI₃, etc.), tin halide (for example, SnI₂, etc.), and/or the like.

Examples of the lanthanide metal halide may comprise (e.g., may be) YbF, YbF₂, YbF₃, SmF₃, YbCl, YbCl₂, YbCl₃, SmCl₃, YbBr, YbBr₂, YbBr₃, SmBr₃, YbI, YbI₂, YbI₃, SmI₃, and/or the like.

Examples of the metalloid halide may comprise (e.g., may be) antimony halide (for example, SbCl₅, etc.) and/or the like.

Examples of the metal telluride may comprise (e.g., may be) an alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), a lanthanide metal telluride (for example, LaTe, CeTe, PrTe, NdTe, PmTe, EuTe, GdTe, TbTe, DyTe, HoTe, ErTe, TmTe, YbTe, LuTe, etc.), and/or the like.

### Emission layer in interlayer 130

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact each other or are separated from each other, to emit white light. In one or more embodiments, the emission layer may comprise two or more materials of a red light-emitting material, a green light-emitting material, and a blue light-emitting material, in which the two or more materials are mixed with each other in a single layer, to emit white light.

In an embodiment, the emission layer may comprise a host and a dopant (or emitter). In one or more embodiments, the emission layer may further comprise an auxiliary dopant that promotes energy transfer to a dopant (or emitter), in addition to the host and the dopant (or emitter). When the emission layer comprises the dopant (or emitter) and the auxiliary dopant, the dopant (or emitter) and the auxiliary dopant are different from each other.

The transition metal-containing compound represented by Formula 5 described herein may act as the dopant (or emitter), or may act as the auxiliary dopant.

An amount (weight) of the dopant (or emitter) in the emission layer may be about 0.01 parts by weight to about 15 parts by weight based on 100 parts by weight of the host.

The transition metal-containing compound represented by Formula 5 may be comprised in the emission layer. An amount (weight) of the transition metal-containing compound in the emission layer may be about 0.01 parts by weight to about 30 parts by weight, about 0.1 parts by weight to about 20 parts by weight, or about 0.1 parts by weight to about 15 parts by weight, based on 100 parts by weight of the emission layer.

A thickness of the emission layer may about 100 Å to about 1,000 Å, for example, about 200 Å to about 600 Å. When the thickness of the emission layer is within the ranges described above, excellent or suitable luminescence characteristics may be obtained without a substantial increase in driving voltage.

### Host

The host in the emission layer may comprise the third compound or the fourth compound described herein, or any combination thereof.

In an embodiment, the host may comprise a compound represented by Formula 301: Formula 301

[Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be defined the same as Q₁.

For example, when xb11 in Formula 301 is 2 or more, two or more of Ar₃₀₁ may be linked to each other via a single bond.

In an embodiment, the host may comprise a compound represented by Formula 301-1, a compound represented by Formula 301-2, or any combination thereof:

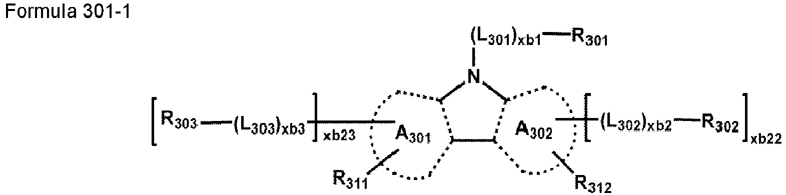

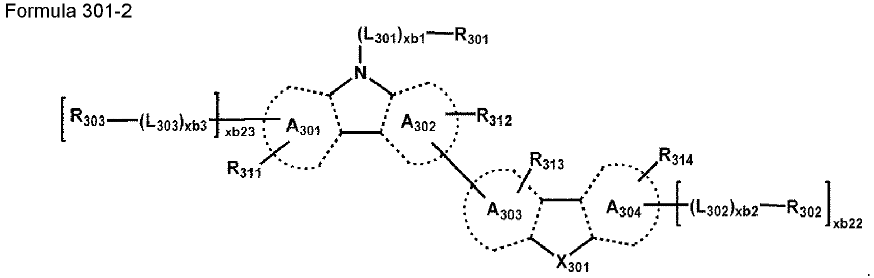

In Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be as defined herein,
L₃₀₂ to L₃₀₄ may each independently be defined the same as L₃₀₁,
xb2 to xb4 may each independently be defined the same as xb1, and
R₃₀₂ to R₃₀₅ and R₃₁₁ to R₃₁₄ may each independently be defined the same as R₃₀₁.

In one or more embodiments, the host may comprise an alkaline earth metal complex, a post-transition metal complex, or any combination thereof. For example, the host may comprise a Be complex (for example, Compound H55), an Mg complex, a Zn complex, or any combination thereof.

In one or more embodiments, the host may comprise at least one of Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

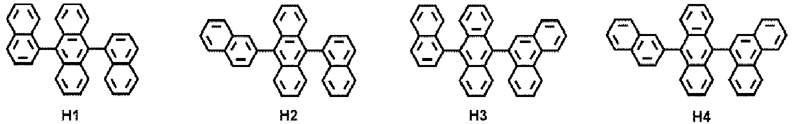

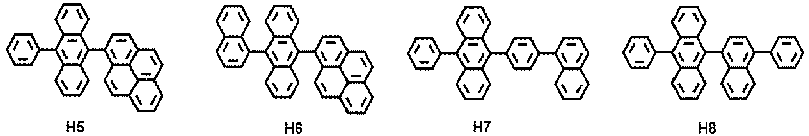

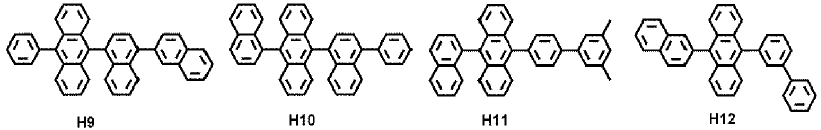

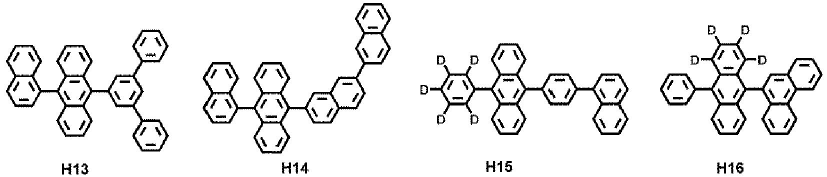

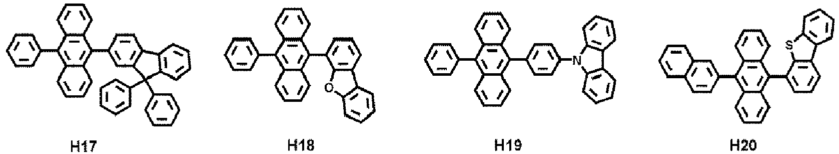

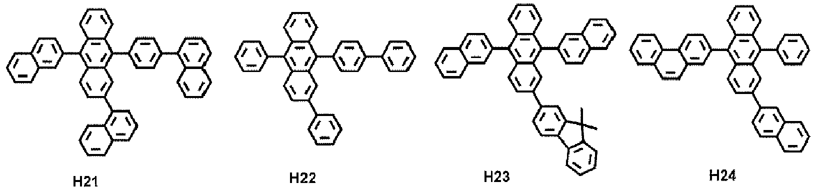

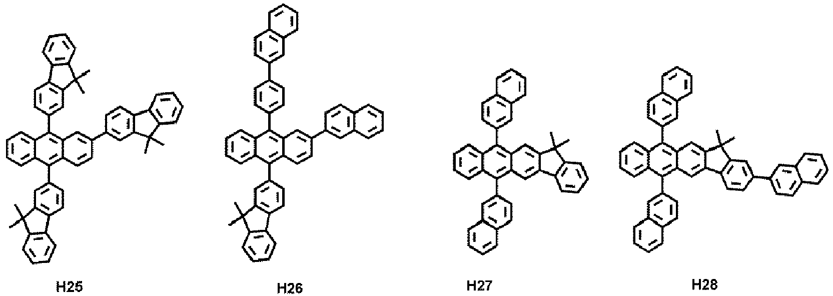

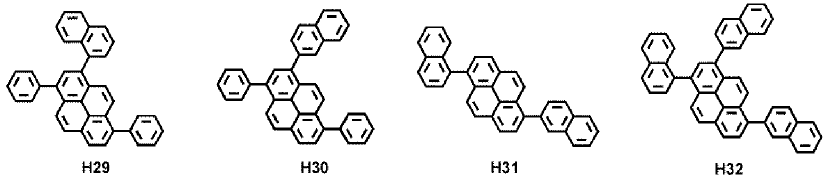

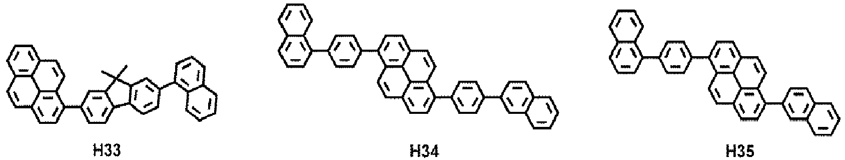

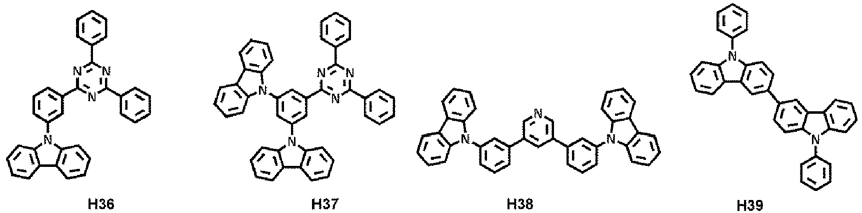

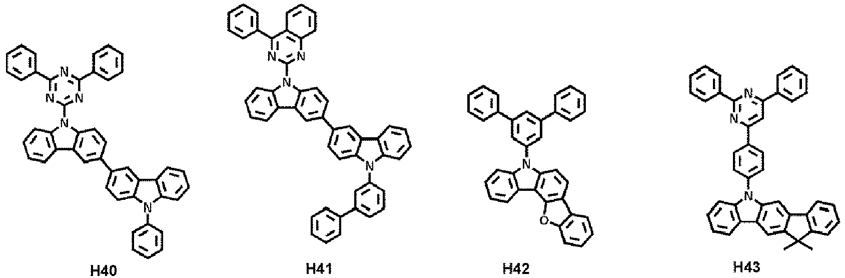

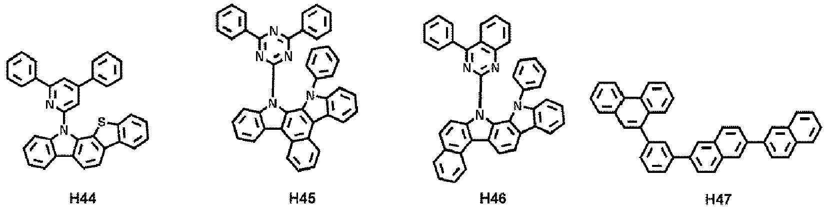

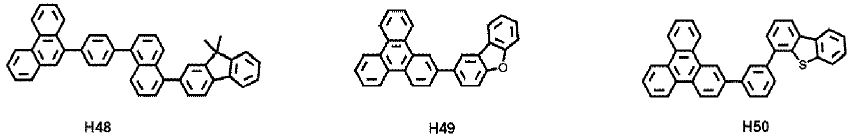

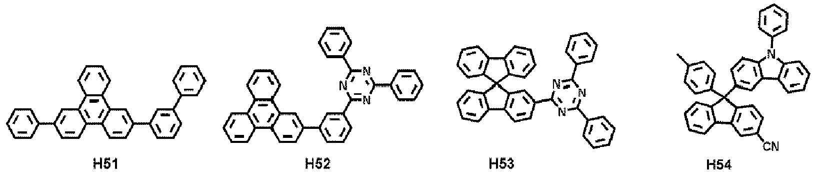

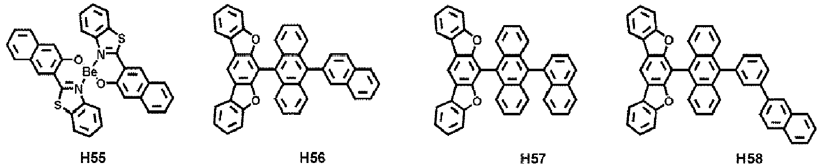

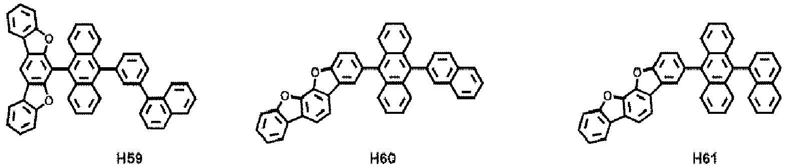

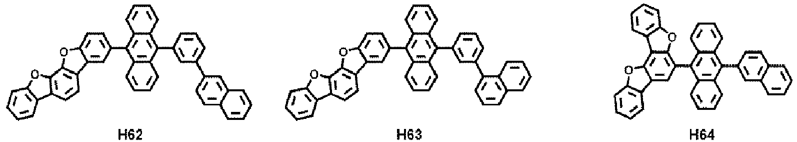

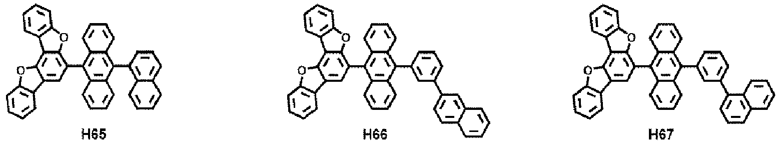

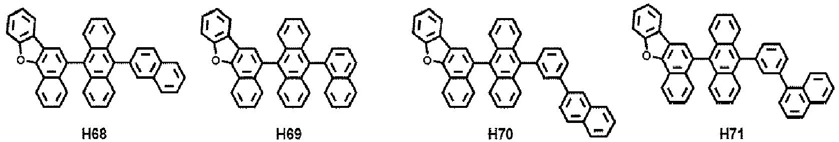

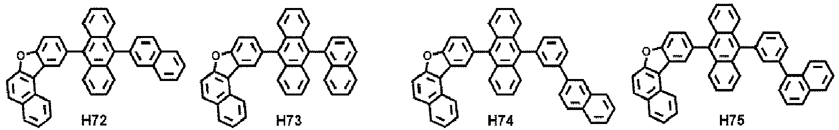

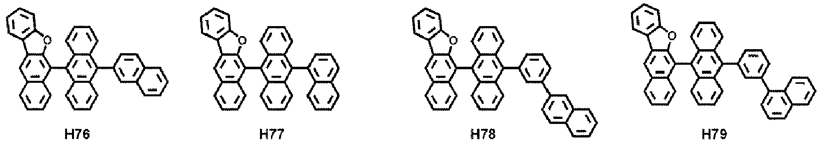

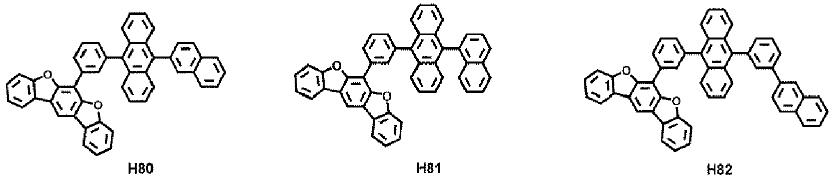

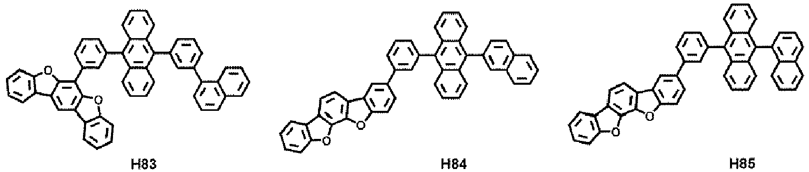

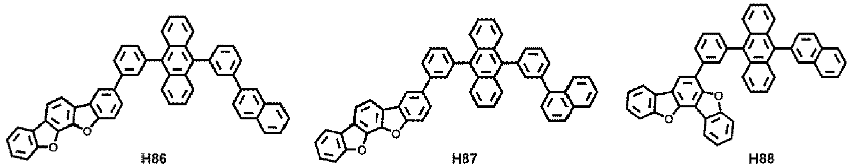

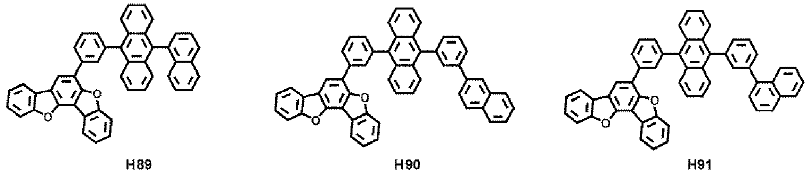

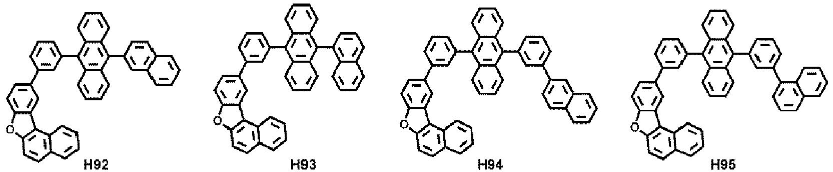

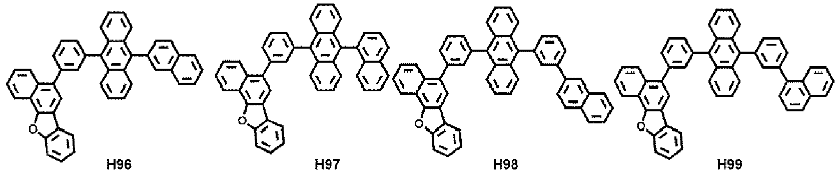

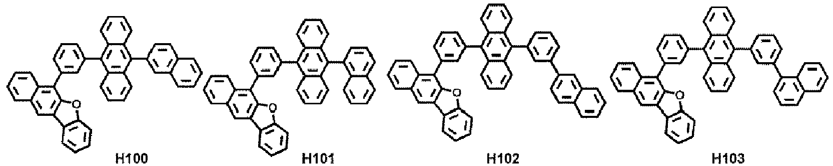

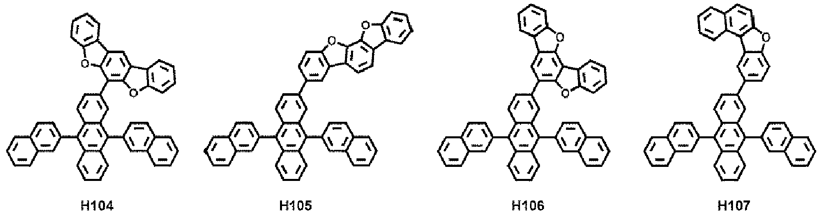

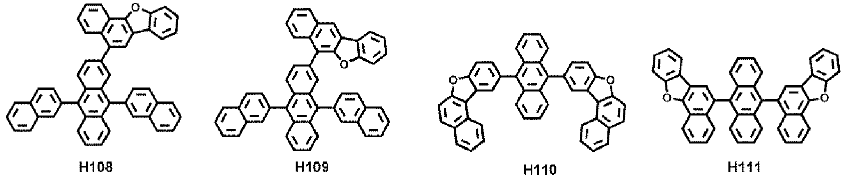

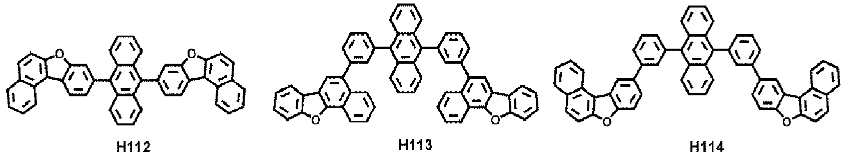

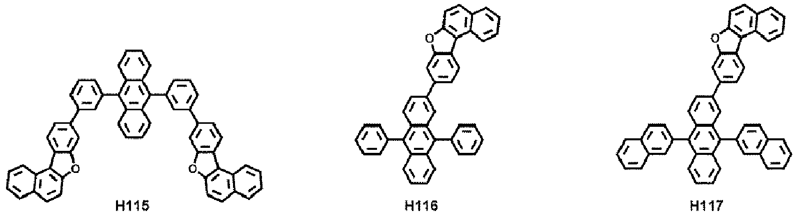

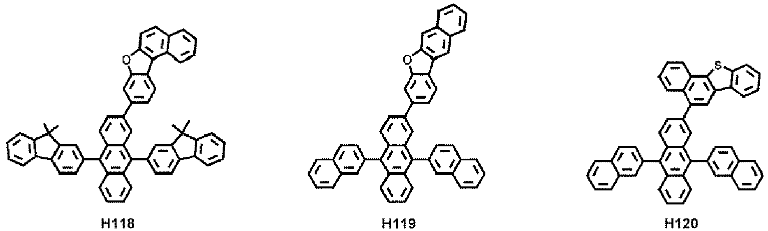

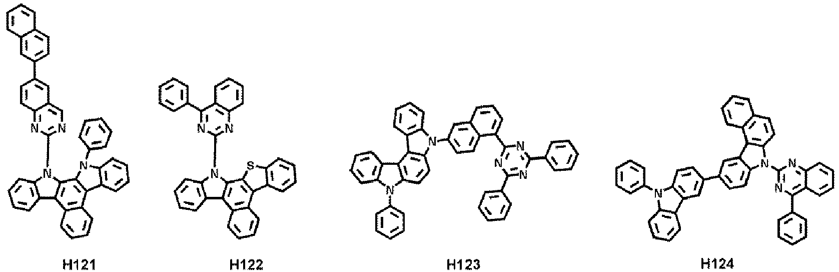

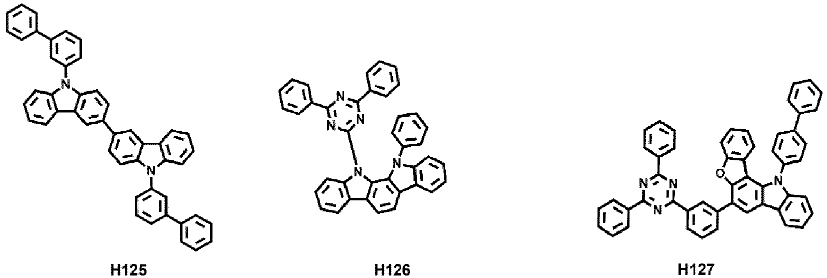

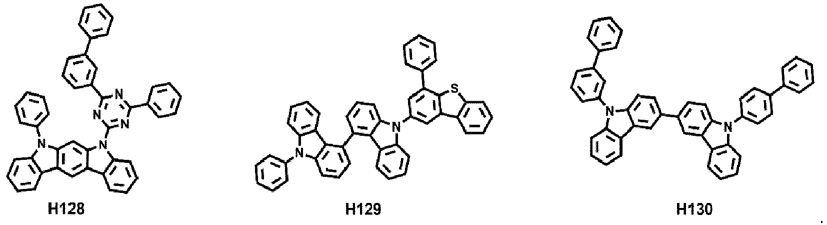

In an embodiment, the host may comprise a silicon-containing compound, a phosphine oxide-containing compound, or any combination thereof.

The host may have one or more suitable modifications. For example, the host may comprise only one kind of compound, or may comprise two or more kinds of different compounds.

### Phosphorescent dopant

The emission layer may comprise, as a phosphorescent dopant, the transition metal-containing compound represented by Formula 5 described herein.

In an embodiment, the emission layer may comprise the transition metal-containing compound represented by Formula 5 described herein, wherein, when the transition metal-containing compound represented by Formula 5 described herein acts as an auxiliary dopant, the emission layer may comprise a phosphorescent dopant.

The phosphorescent dopant may comprise at least one transition metal as a central metal.

The phosphorescent dopant may comprise a monodentate ligand, a bidentate ligand, a tridentate ligand, a tetradentate ligand, a pentadentate ligand, a hexadentate ligand, or any combination thereof.

The phosphorescent dopant may be electrically neutral.

For example, the phosphorescent dopant may comprise a transition metal-containing compound represented by 401:

Formula 401 M(L₄₀₁)_{xc1}(L₄₀₂)_{xc2}

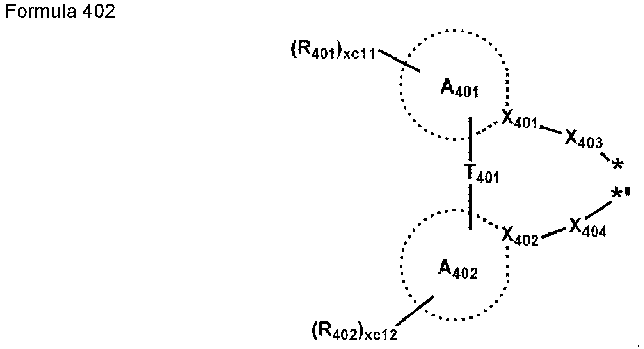

In Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 is 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, wherein, when xc2 is 2 or more, two or more of L₄₀₂ may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordinate bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each independently be defined the same as Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), or -P(=O)(Q₄₀₁)(Q₄₀₂),
Q₄₀₁ to Q₄₀₃ may each independently be defined the same as Q₁,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In an embodiment, when xc1 in Formula 402 is 2 or more, two ring A₄₀₁(s) among two or more of L₄₀₁ may optionally be linked to each other via T₄₀₂, which is a linking group, and two ring A₄₀₂(s) among two or more of L₄₀₁ may optionally be linked to each other via T₄₀₃, which is a linking group (see Compounds PD1 to PD4 and PD7). T₄₀₂ and T₄₀₃ may each independently be defined the same as T₄₀₁.

In Formula 401, L₄₀₂ may be an organic ligand. For example, L₄₀₂ may comprise a halogen group, a diketone group (for example, an acetylacetonate group), a carboxylic acid group (for example, a picolinate group), -C(=O), an isonitrile group, a -CN group, a phosphorus group (for example, a phosphine group, a phosphite group, etc.), or any combination thereof.

The phosphorescent dopant may comprise, for example, at least one of Compounds PD1 to PD25, or any combination thereof:

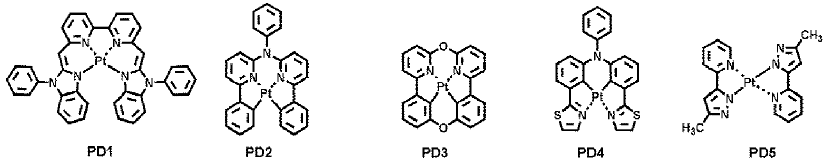

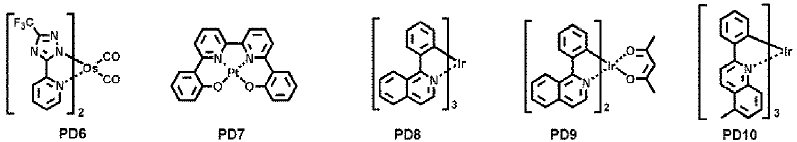

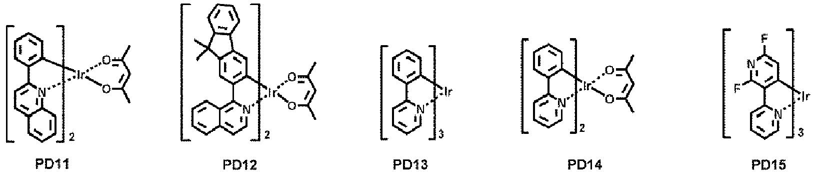

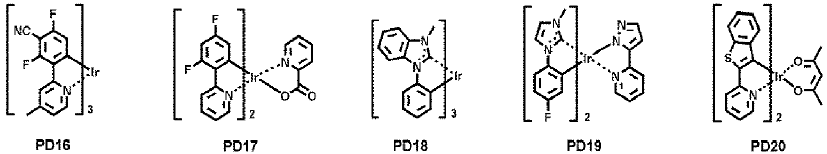

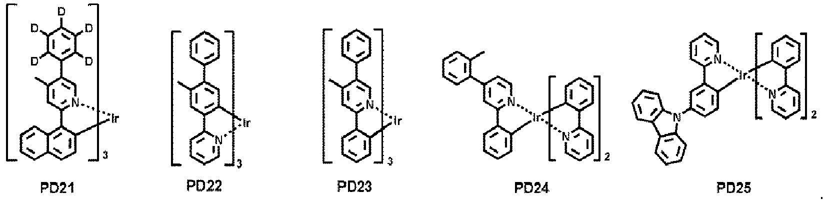

### Fluorescent dopant

The emission layer may comprise the transition metal-containing compound represented by Formula 5 described herein, wherein, when the transition metal-containing compound represented by Formula 5 described herein acts as an auxiliary dopant, the emission layer may further comprise a fluorescent dopant.

In an embodiment, the emission layer may comprise the transition metal-containing compound represented by Formula 5 described herein, wherein, when the transition metal-containing compound represented by Formula 5 described herein acts as a phosphorescent dopant, the emission layer may further comprise an auxiliary dopant.

The fluorescent dopant and the auxiliary dopant may each independently comprise an arylamine compound, a styrylamine compound, a boron-containing compound, or any combination thereof.

For example, the fluorescent dopant and the auxiliary dopant may each independently comprise a compound represented by Formula 501:

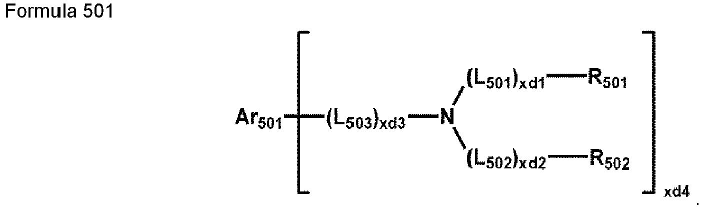

In Formula 501,
Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, a pyrene group, etc.) in which three or more monocyclic groups are condensed together.

In an embodiment, xd4 in Formula 501 may be 2.

For example, the fluorescent dopant and the auxiliary dopant may each comprise at least one of Compounds FD1 to FD36, DPVBi, DPAVBi, or any combination thereof:

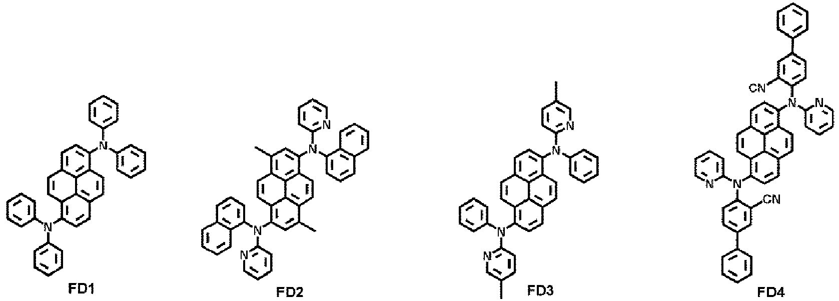

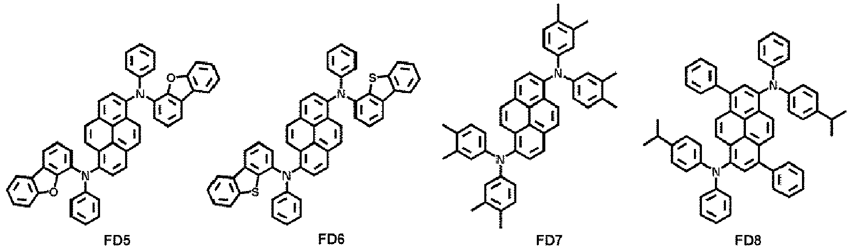

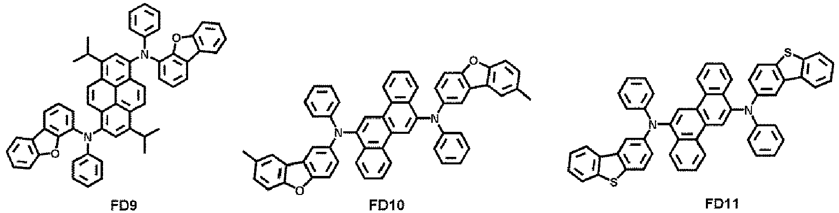

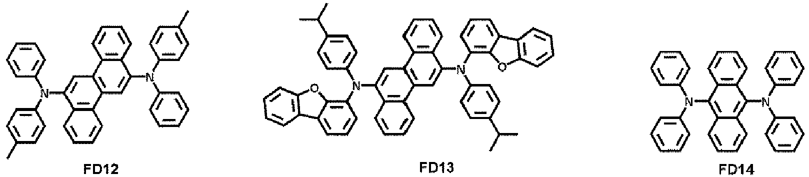

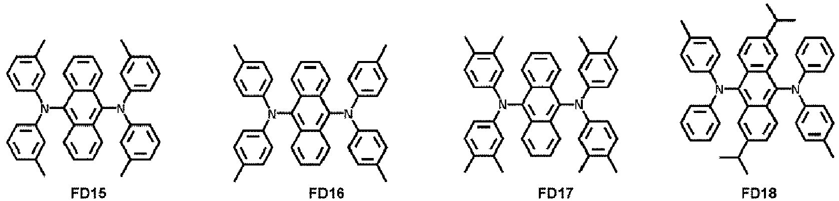

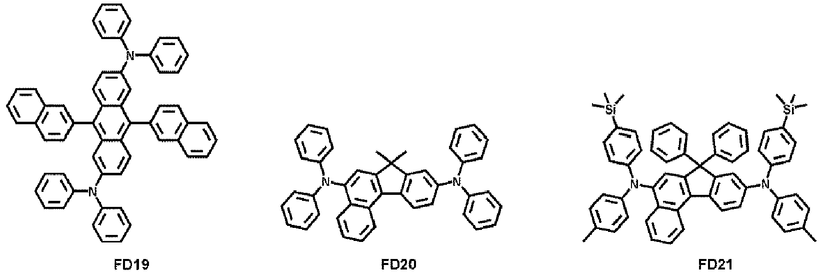

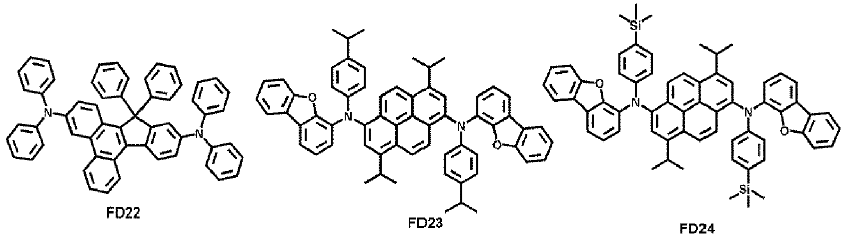

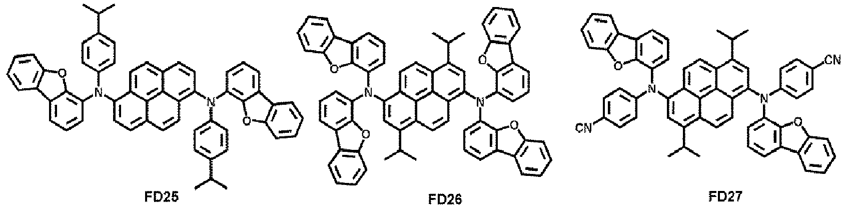

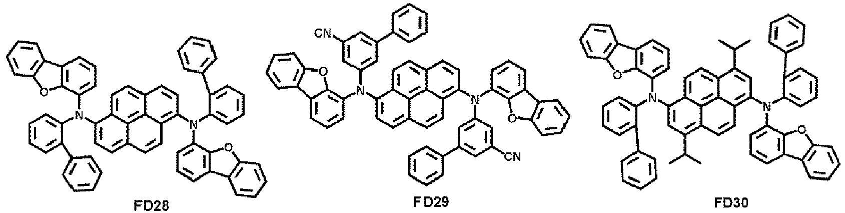

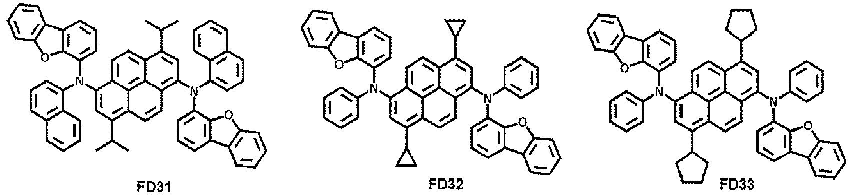

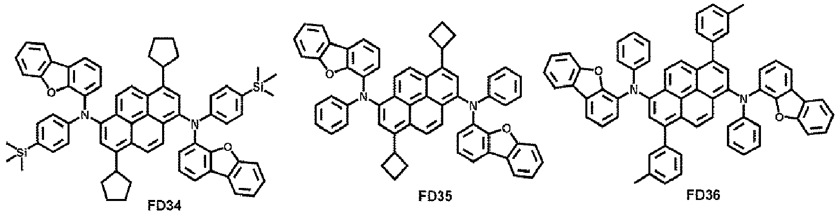

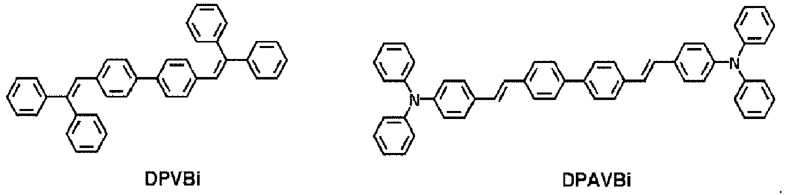

In an embodiment, the fluorescent dopant and the auxiliary dopant may each independently comprise the delayed fluorescence compound represented by Formula 1 described herein.

### Electron transport region in interlayer 130

The electron transport region may have i) a single-layer structure consisting of a single layer consisting of a single material, ii) a single-layer structure consisting of a single layer comprising (e.g., consisting of) multiple different materials, or iii) a multi-layer structure comprising multiple layers comprising different materials.

The electron transport region may comprise a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer in the respective stated order.

In an embodiment, the electron transport region (for example, the buffer layer, the hole blocking layer, the electron control layer, or the electron transport layer in the electron transport region) may comprise a metal-free compound comprising at least one π electron-deficient nitrogen-containing C₁-C₆₀ heterocyclic group.

For example, the electron transport region may comprise a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), - C(=O)(Q₆₀₁), -S(=O)₂(Q₆₀₁), or-P(=O)(Q₆₀₁)(Q₆₀₂),
Q₆₀₁ to Q₆₀₃ may each be defined the same as Q₁,
xe21 may be 1, 2, 3, 4, or 5, and
at least one of Ar₆₀₁, L₆₀₁, or R₆₀₁ may each independently be a π electron-deficient nitrogen-containing C₁-C₆₀ heterocyclic group unsubstituted or substituted with at least one R₁₀ₐ.

For example, when xe11 in Formula 601 is 2 or more, two or more of Ar₆₀₁ may be linked to each other via a single bond.

In an embodiment, Ar₆₀₁ in Formula 601 may be a substituted or unsubstituted anthracene group.

In one or more embodiments, the electron transport region may comprise a compound represented by Formula 601-1:

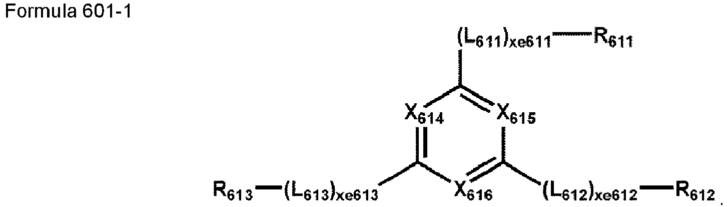

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be defined the same as L₆₀₁,
xe611 to xe613 may each be defined the same as xe1,
R₆₁₁ to R₆₁₃ may each be defined the same as R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

The electron transport region may comprise at least one of Compounds ET1 to ET46, 2,9-dimethyl-4,7-diphenyl-1,10-phenanthroline (BCP), 4,7-diphenyl-1,10-phenanthroline (Bphen), Alq₃, BAIq, TAZ, NTAZ, or any combination thereof:

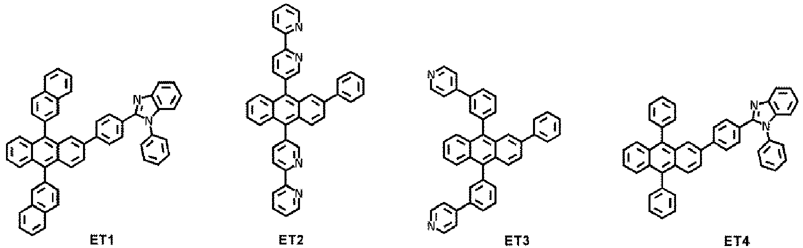

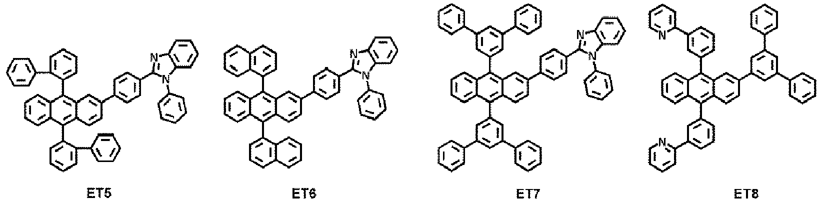

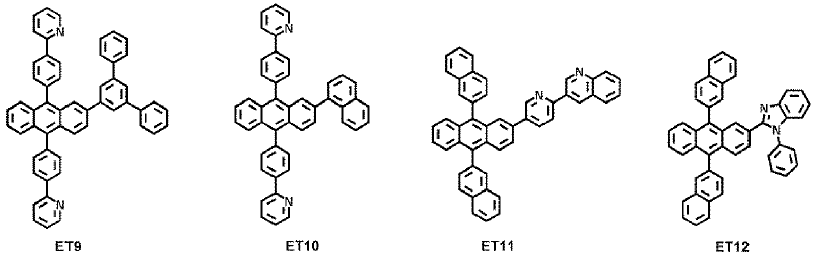

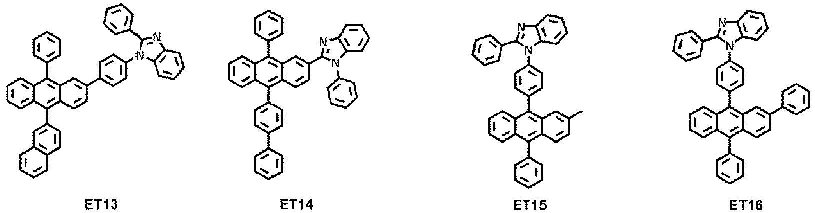

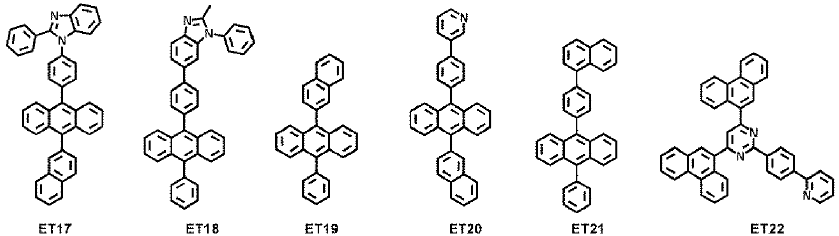

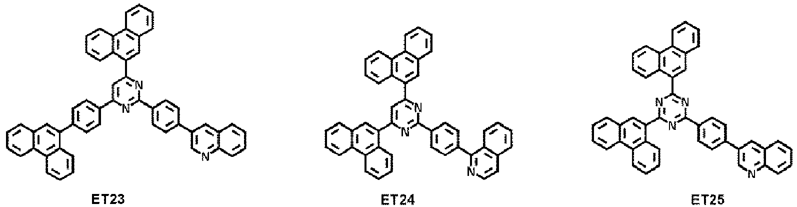

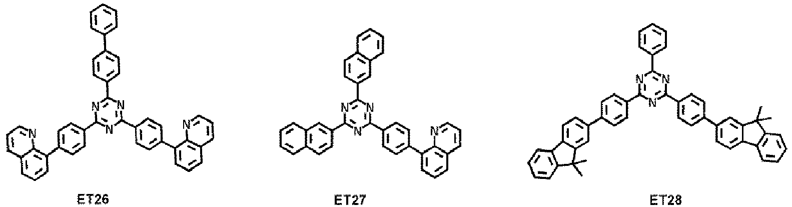

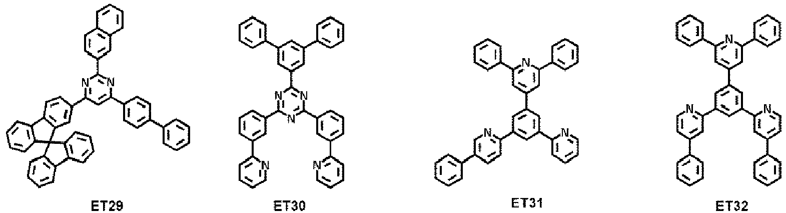

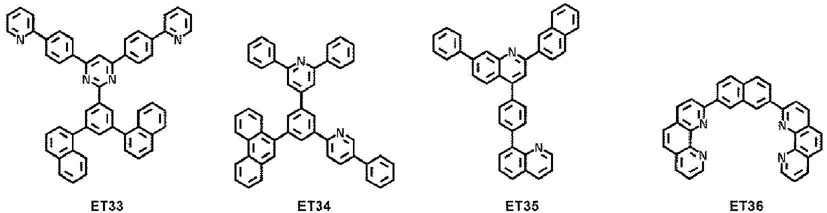

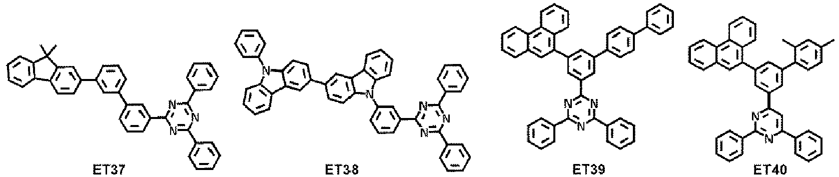

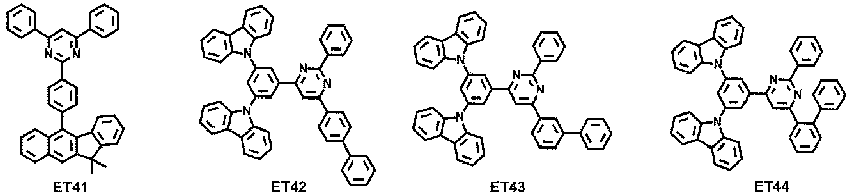

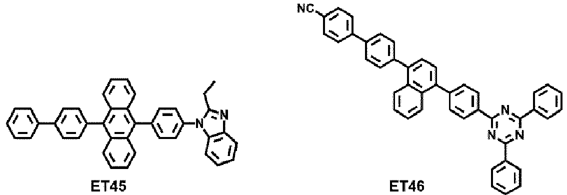

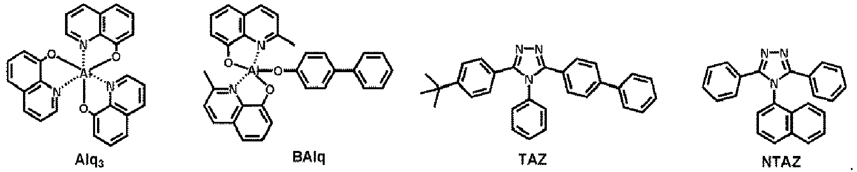

A thickness of the electron transport region may be about 100 Å to about 5,000 Å, for example, about 160 Å to about 4,000 Å. When the electron transport region comprises a buffer layer, a hole blocking layer, an electron control layer, an electron transport layer, or any combination thereof, a thickness of the buffer layer, the hole blocking layer, or the electron control layer may be about 20 Å to about 1,000 Å, for example, about 30 Å to about 300 Å, and a thickness of the electron transport layer may be about 100 Å to about 1,000 Å, for example, about 150 Å to about 500 Å. When the thicknesses of the buffer layer, the hole blocking layer, the electron control layer, the electron transport layer, and/or the electron transport layer are within the ranges described above, satisfactory electron transporting characteristics may be obtained without a substantial increase in driving voltage.

The electron transport region (for example, the electron transport layer in the electron transport region) may further comprise, in addition to the materials described above, a metal-containing material.

The metal-containing material may comprise an alkali metal complex, an alkaline earth metal complex, or any combination thereof. The metal ion of the alkali metal complex may be a Li ion, a Na ion, a K ion, a Rb ion, or a Cs ion, and the metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may comprise a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may comprise a Li complex. The Li complex may comprise, for example, Compound ET-D1 (LiQ) or ET-D2:

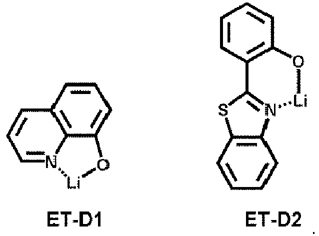

The electron transport region may comprise an electron injection layer that facilitates the injection of electrons from the second electrode 150. The electron injection layer may directly contact the second electrode 150.

The electron injection layer may have i) a single-layer structure consisting of a single layer consisting of a single material, ii) a single-layer structure consisting of a single layer comprising (e.g., consisting of) multiple different materials, or iii) a multi-layer structure comprising multiple layers comprising different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may comprise Li, Na, K, Rb, Cs, or any combination thereof. The alkaline earth metal may comprise Mg, Ca, Sr, Ba, or any combination thereof. The rare earth metal may comprise Sc, Y, Ce, Tb, Yb, Gd, or any combination thereof.

The alkali metal-containing compound, the alkaline earth metal-containing compound, and the rare earth metal-containing compound may be one or more oxides, halides (for example, fluorides, chlorides, bromides, iodides, etc.), and/or tellurides of the alkali metal, the alkaline earth metal, and the rare earth metal, or any combination thereof.

The alkali metal-containing compound may comprise: an alkali metal oxide, such as Li₂O, Cs₂O, and/or K₂O; an alkali metal halide, such as LiF, NaF, CsF, KF, Lil, Nal, Csl, KI, and/or Rbl; or any combination thereof. The alkaline earth metal-containing compound may comprise an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may comprise YbF₃, ScF₃, Sc₂O₃, Y₂O₃, Ce₂O₃, GdF₃, TbF₃, YbI₃, ScI₃, Tbls, or any combination thereof. In an embodiment, the rare earth metal-containing compound may comprise lanthanide metal telluride. Examples of the lanthanide metal telluride may comprise (e.g., may be) LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and/or the like.

The alkali metal complex, the alkaline earth-metal complex, and the rare earth metal complex may comprise i) one of metal ions of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

In an embodiment, the electron injection layer may comprise (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further comprise an organic material (for example, a compound represented by Formula 601).

In an embodiment, the electron injection layer may comprise (e.g., consist of) i) an alkali metal-containing compound (for example, an alkali metal halide), or ii) a) an alkali metal-containing compound (for example, an alkali metal halide); and b) an alkali metal, an alkaline earth metal, a rare earth metal, or any combination thereof. For example, the electron injection layer may be a KI:Yb co-deposited layer, an RbI:Yb co-deposited layer, a LiF:Yb co-deposited layer, and/or the like.

When the electron injection layer further comprises an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly or non-uniformly dispersed in a matrix comprising the organic material.

A thickness of the electron injection layer may be about 1 Å to about 100 Å, for example, about 3 Å to about 90 Å. When the thickness of the electron injection layer is within the ranges described above, satisfactory electron injection characteristics may be obtained without a substantial increase in driving voltage.

### Second electrode 150

The second electrode 150 may be arranged on the interlayer 130 having a structure as described above. The second electrode 150 may be a cathode, which is an electron injection electrode, and as a material for forming the second electrode 150, a metal, an alloy, an electrically conductive compound, or any combination thereof, each having a low-work function, may be utilized.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layer structure or a multi-layer structure comprising multiple layers.

### Capping layer

A first capping layer may be arranged outside the first electrode 110, and/or a second capping layer may be arranged outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the light-emitting device 10 may be extracted toward the outside through the first electrode 110 which is a semi-transmissive electrode or a transmissive electrode, and the first capping layer. Light generated in the emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 may be increased, so that the luminescence efficiency of the light-emitting device 10 may be improved.

Each of the first capping layer and the second capping layer may comprise a material having a refractive index of greater than or equal to 1.6 (at 589 nm).

The first capping layer and the second capping layer may each independently be an organic capping layer comprising an organic material, an inorganic capping layer comprising an inorganic material, or an organic-inorganic composite capping layer comprising an organic material and an inorganic material.

At least one of the first capping layer or the second capping layer may each independently comprise a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent comprising O, N, S, Se, Si, F, Cl, Br, I, or any combination thereof. In an embodiment, at least one of the first capping layer or the second capping layer may each independently comprise an amine group-containing compound.

For example, at least one of the first capping layer or the second capping layer may each independently comprise a compound represented by Formula 201, a compound represented by Formula 202, or any combination thereof.

In one or more embodiments, at least one of the first capping layer or the second capping layer may each independently comprise at least one of Compounds HT28 to HT33, at least one of Compounds CP1 to CP6, β-NPB, or any combination thereof:

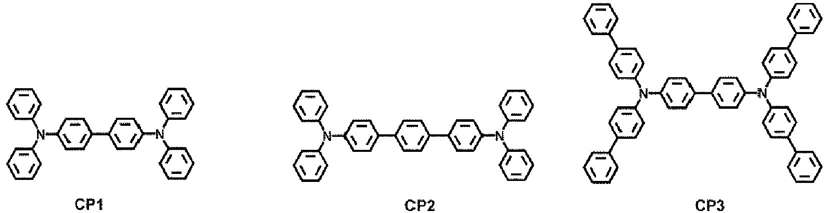

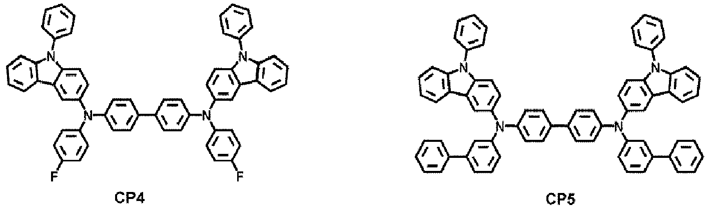

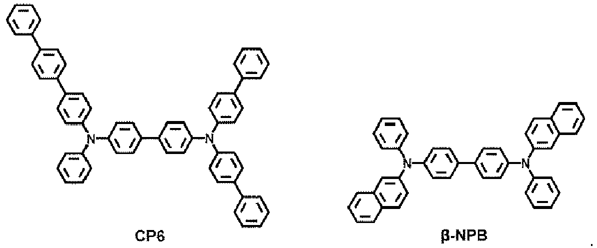

### Electronic apparatus

The light-emitting device may be comprised in one or more suitable electronic apparatuses. For example, the electronic apparatus comprising the light-emitting device may be a light-emitting apparatus, an authentication apparatus, and/or the like.

The electronic apparatus (for example, a light-emitting apparatus) may further comprise, in addition to the light-emitting device, i) a color filter, ii) a color conversion layer, or iii) a color filter and a color conversion layer. The color filter and/or the color conversion layer may be arranged in at least one direction in which light emitted from the light-emitting device travels. For example, the light emitted from the light-emitting device may be blue light, green light, or white light. Details on the light-emitting device may be as described herein. In an embodiment, the color conversion layer may comprise a quantum dot.

The electronic apparatus may comprise a first substrate. The first substrate may comprise a plurality of subpixel areas, the color filter may comprise a plurality of color filter areas respectively corresponding to the plurality of sub pixel areas, and the color conversion layer may comprise a plurality of color conversion areas respectively corresponding to the plurality of subpixel areas.

A pixel-defining film may be arranged among the subpixel areas to define each of the plurality of subpixel areas.

The color filter may further comprise a plurality of color filter areas and light-shielding patterns arranged among the plurality of color filter areas, and the color conversion layer may further comprise a plurality of color conversion areas and light-shielding patterns arranged among the plurality of color conversion areas.

The plurality of color filter areas (or the plurality of color conversion areas) may comprise a first area emitting a first color light, a second area emitting a second color light, and/or a third area emitting a third color light, wherein the first color light, the second color light, and/or the third color light may have different maximum emission wavelengths. For example, the first color light may be red light, the second color light may be green light, and the third color light may be blue light. For example, the plurality of color filter areas (or the plurality of color conversion areas) may comprise quantum dots. In particular, the first area may comprise a red quantum dot, the second area may comprise a green quantum dot, and the third area may not comprise (e.g., may exclude) a quantum dot. Details on the quantum dot may be as described herein. The first area, the second area, and/or the third area may each further comprise a scatter.

For example, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further comprise a thin-film transistor, in addition to the light-emitting device described above. The thin-film transistor may comprise a source electrode, a drain electrode, and an activation layer, wherein the source electrode or the drain electrode may be electrically connected to the first electrode or the second electrode of the light-emitting device.

The thin-film transistor may further comprise a gate electrode, a gate insulating film, and/or the like.

The activation layer may comprise crystalline silicon, amorphous silicon, an organic semiconductor, an oxide semiconductor, and/or the like.

The electronic apparatus may further comprise a sealing portion for sealing the light-emitting device. The sealing portion may be arranged between the color filter and the light-emitting device and/or between the color conversion layer and the light-emitting device. The sealing portion allows light from the light-emitting device to be extracted to the outside, and concurrently (e.g., simultaneously) prevents or substantially prevents ambient air and moisture from penetrating into the light-emitting device. The sealing portion may be a sealing substrate comprising a transparent glass substrate and/or a plastic substrate. The sealing portion may be a thin-film encapsulation layer comprising at least one layer of an organic layer and/or an inorganic layer. When the sealing portion is a thin-film encapsulation layer, the electronic apparatus may be flexible.

Various suitable functional layers may be additionally arranged on the sealing portion, in addition to the color filter and/or the color conversion layer, according to the usage of the electronic apparatus. Examples of the functional layers may comprise a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further comprise, in addition to the light-emitting device described above, a biometric information collector.

The electronic apparatus may be applied to one or more suitable displays, light sources, lighting apparatuses, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

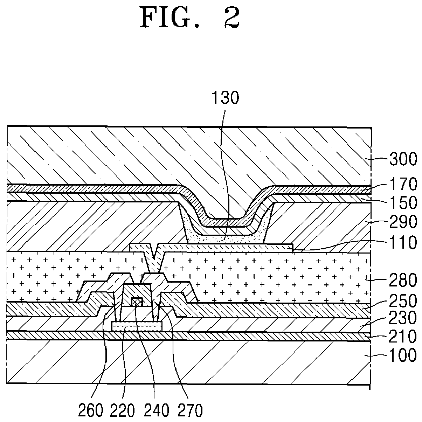

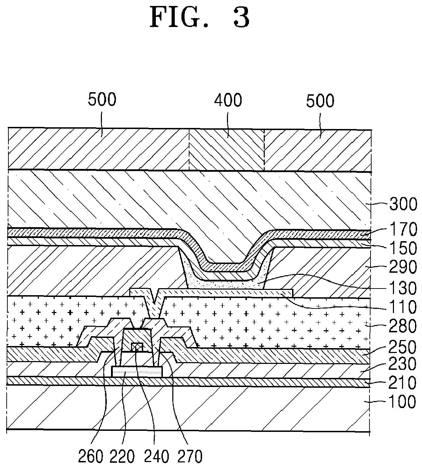

### Description of FIGS. 2 and 3

FIG. 2 is a cross-sectional view of a light-emitting apparatus as an electronic apparatus according to an embodiment.

The light-emitting apparatus of FIG. 2 comprises a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be arranged on the substrate 100. The buffer layer 210 may prevent or reduce penetration of impurities through the substrate 100 and may provide a flat surface on the substrate 100.

A TFT may be arranged on the buffer layer 210. The TFT may comprise an activation layer 220, a gate electrode 240, a source electrode 260, and a drain electrode 270.

The activation layer 220 may comprise an inorganic semiconductor such as silicon and/or polysilicon, an organic semiconductor, and/or an oxide semiconductor, and may comprise a source region, a drain region, and a channel region.

A gate insulating film 230 for insulating the activation layer 220 from the gate electrode 240 may be arranged on the activation layer 220, and the gate electrode 240 may be arranged on the gate insulating film 230.

An interlayer insulating film 250 may be arranged on the gate electrode 240. The interlayer insulating film 250 may be arranged between the gate electrode 240 and the source electrode 260 to insulate the gate electrode 240 from the source electrode 260 and between the gate electrode 240 and the drain electrode 270, to insulate the gate electrode 240 from the drain electrode 270.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220.

The TFT may be electrically connected to a light-emitting device to drive the light-emitting device, and may be covered and protected by a passivation layer 280. The passivation layer 280 may comprise an inorganic insulating film, an organic insulating film, or any combination thereof. A light-emitting device may be provided on the passivation layer 280. The light-emitting device may comprise the first electrode 110, the interlayer 130, and the second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel defining layer 290 comprising an insulating material may be arranged on the first electrode 110. The pixel defining layer 290 may expose a certain region of the first electrode 110, and an interlayer 130 may be formed in the exposed region of the first electrode 110. The pixel defining layer 290 may be a polyimide-based organic film or a polyacrylic-based organic film. In one or more embodiments, at least some layers of the interlayer 130 may extend beyond the upper portion of the pixel defining layer 290 to be arranged in the form of a common layer.

The second electrode 150 may be arranged on the interlayer 130, and a second capping layer 170 may be additionally formed on the second electrode 150. The second capping layer 170 may be formed to cover the second electrode 150.

The encapsulation portion 300 may be arranged on the second capping layer 170. The encapsulation portion 300 may be arranged on a light-emitting device to protect the light-emitting device from moisture or oxygen. The encapsulation portion 300 may comprise: an inorganic film comprising silicon nitride (SiNx), silicon oxide (SiOx), indium tin oxide, indium zinc oxide, or any combination thereof; an organic film comprising polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or any combination of the inorganic films and the organic films.

FIG. 3 is a cross-sectional view of a light-emitting apparatus as an electronic apparatus according to another embodiment.

The light-emitting apparatus of FIG. 3 is the same as the light-emitting apparatus of FIG. 2, except that a light-shielding pattern 500 and a functional region 400 are additionally arranged on the encapsulation portion 300. The functional region 400 may be i) a color filter area, ii) a color conversion area, or iii) a combination of the color filter area and the color conversion area. In an embodiment, the light-emitting device comprised in the light-emitting apparatus of FIG. 3 may be a tandem light-emitting device.

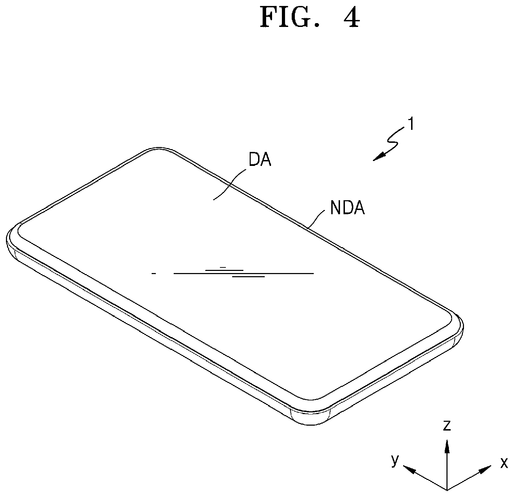

### Description of FIG. 4

FIG. 4 is a schematic perspective view of electronic equipment 1 comprising a light-emitting device according to an embodiment. The electronic equipment 1 may be, as an apparatus that displays a moving image and/or still image, a portable electronic equipment, such as a mobile phone, a smart phone, a tablet personal computer (PC), a mobile communication terminal, an electronic notebook, an electronic book, a portable multimedia player (PMP), a navigation, and/or an ultra mobile PC (UMPC), as well as one or more suitable products, such as a television, a laptop, a monitor, a billboard, and/or an Internet of things (IOT). The electronic equipment 1 may be a product described above or a part thereof. In some embodiments, the electronic equipment 1 may be a wearable device, such as a smart watch, a watch phone, a glasses-type or kind display, and/or a head mounted display (HMD), and/or a part of the wearable device. However, embodiments of the disclosure are not limited thereto. For example, the electron equipment 1 may comprise a dashboard of a vehicle, a center fascia of a vehicle, a center information display arranged on a dashboard of a vehicle, a room mirror display replacing a side mirror of a vehicle, an entertainment display for the rear seat of a vehicle and/or a display arranged on the back of the front seat, and/or a head up display (HUD) installed in the front of a vehicle and/or projected on a front window glass, and/or a computer generated hologram augmented reality head up display (CGH AR HUD). FIG. 4 illustrates a case in which the electronic equipment 1 is a smart phone for convenience of explanation.

The electronic equipment 1 may comprise a display area DA and a non-display area NDA outside the display area DA. A display apparatus may implement an image through an array of a plurality of pixels that are two-dimensionally arranged in the display area DA.

The non-display area NDA is an area that does not display an image, and may be around (e.g., entirely surround) the display area DA. On the non-display area NDA, a driver for providing electrical signals and/or power to display devices arranged on the display area DA may be arranged. On the non-display area NDA, a pad, which is an area to which an electronic device and/or a printing circuit board may be electrically connected, may be arranged.

In the electronic equipment 1, a length in the x-axis direction and a length in the y-axis direction may be different from each other. In an embodiment, as shown in FIG. 4 , the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

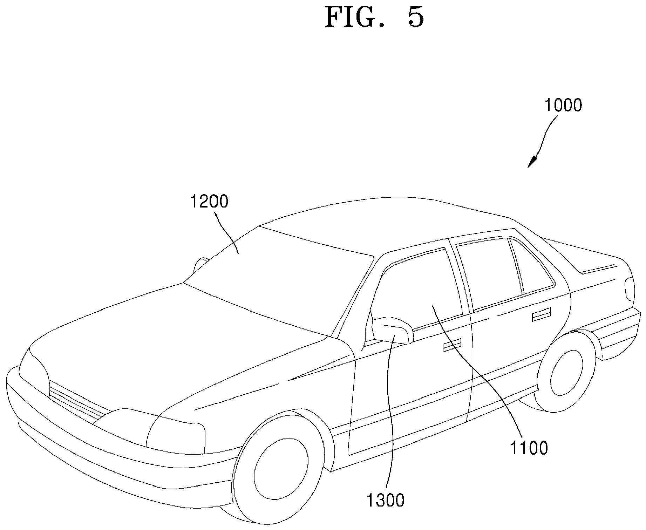

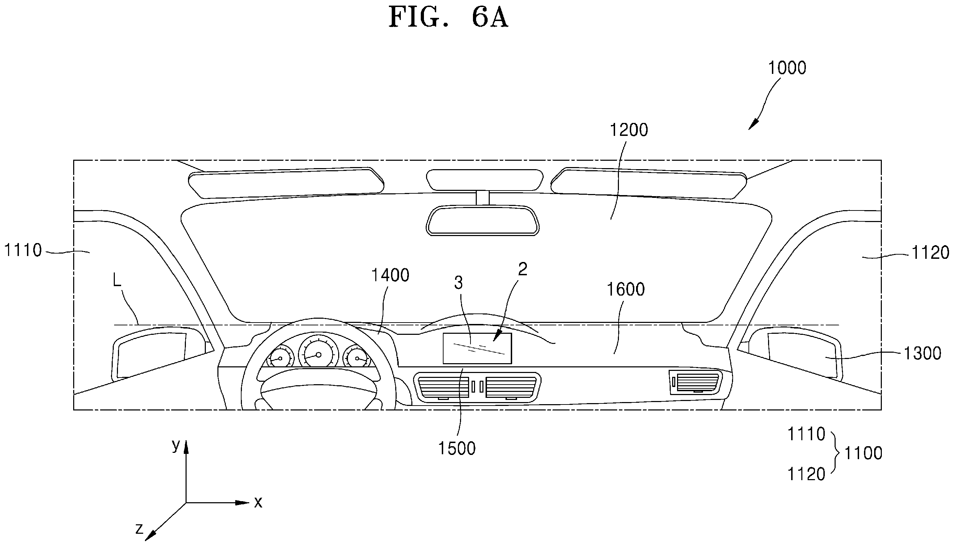

### Description of FIGS. 5 and 6A to 6C

FIG. 5 is a schematic view of the exterior of a vehicle 1000 as electronic equipment comprising a light-emitting device according to an embodiment. FIGS. 6A to 6C are each a schematic view of the interior of the vehicle 1000 according to one or more suitable embodiments.

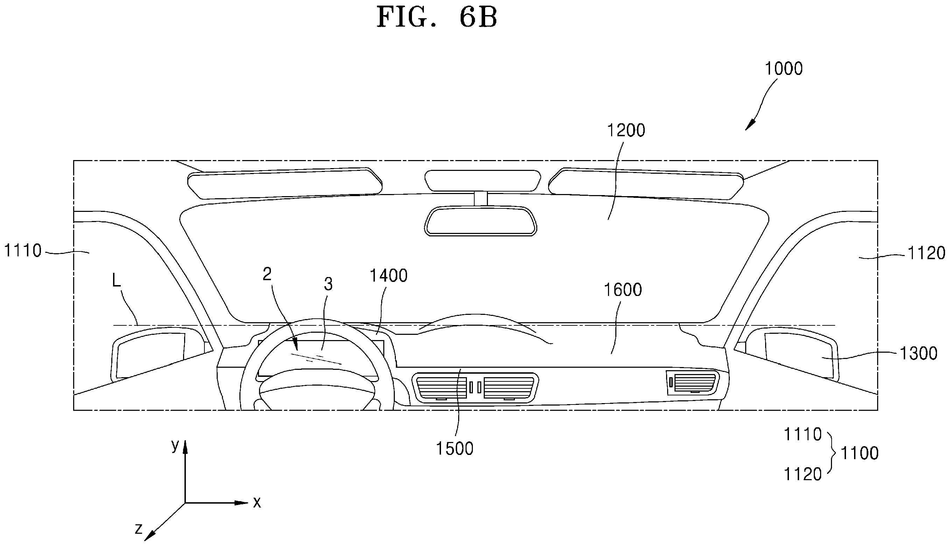

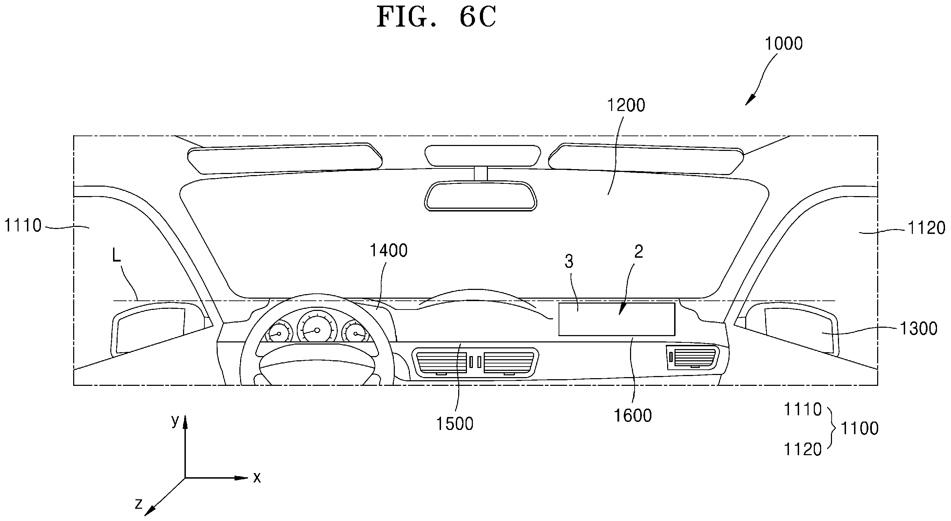

Referring to FIGS. 5, 6A, 6B, and 6C, the vehicle 1000 may refer to one or more suitable apparatuses for moving a subject to be transported, such as a human, an object, and/or an animal, from a departure point to a destination point. The vehicle 1000 may comprise a vehicle traveling on a road or track, a vessel moving over the sea or river, an airplane flying in the sky utilizing the action of air, and/or the like.

The vehicle 1000 may travel on a road and/or a track. The vehicle 1000 may move in a certain direction according to rotation of at least one wheel. For example, the vehicle 1000 may comprise a three-wheeled or four-wheeled vehicle, a construction machine, a two-wheeled vehicle, a prime mover apparatus, a bicycle, and a train running on a track.

The vehicle 1000 may comprise a body having an interior and an exterior, and a chassis in which mechanical apparatuses necessary for driving are installed as other parts except for the body. The exterior of the body may comprise a front panel, a bonnet, a roof panel, a rear panel, a trunk, a pillar provided at a boundary between doors, and/or the like. The chassis of the vehicle 1000 may comprise a power generating apparatus, a power transmitting apparatus, a driving apparatus, a steering apparatus, a braking apparatus, a suspension apparatus, a transmission apparatus, a fuel apparatus, front and rear wheels, left and right wheels, and/or the like.

The vehicle 1000 may comprise a side window glass 1100, a front window glass 1200, a side mirror 1300, a cluster 1400, a center fascia 1500, a passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may comprise a first side window glass 1110 and a second side window glass 1120. In an embodiment, the first side window glass 1110 may be arranged adjacent to the cluster 1400. The second side window glass 1120 may be arranged adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, the imaginary straight line L connecting the first side window glass 1110 and the second side window glass 1120 to each other may extend in the x direction or the -x direction.

The front window glass 1200 may be installed in the front of the vehicle 1000. The front window glass 1200 may be arranged between the side window glasses 1100 facing each other.

The side mirror 1300 may provide a rear view of the vehicle 1000. The side mirror 1300 may be installed on the exterior of the body. In an embodiment, a plurality of side mirrors 1300 may be provided. Any one of the plurality of side mirrors 1300 may be arranged outside the first side window glass 1110. The other one of the plurality of side mirrors 1300 may be arranged outside the second side window glass 1120.

The cluster 1400 may be arranged in front of the steering wheel. The cluster 1400 may comprise a tachometer, a speedometer, a coolant thermometer, a fuel gauge, a turn indicator, a high beam indicator, a warning lamp, a seat belt warning lamp, an odometer, a hodometer, an automatic shift selector indicator lamp, a door open warning lamp, an engine oil warning lamp, and/or a low fuel warning lamp.

The center fascia 1500 may comprise a control panel on which a plurality of buttons for adjusting an audio apparatus, an air conditioning apparatus, and a heater of a seat are arranged. The center fascia 1500 may be arranged on one side of the cluster 1400.

The passenger seat dashboard 1600 may be spaced apart from the cluster 1400 with the center fascia 1500 arranged therebetween. In an embodiment, the cluster 1400 may be arranged to correspond to a driver seat, and the passenger seat dashboard 1600 may be arranged to correspond to a passenger seat. In an embodiment, the cluster 1400 may be adjacent to the first side window glass 1110, and the passenger seat dashboard 1600 may be adjacent to the second side window glass 1120.

In an embodiment, the display apparatus 2 may comprise a display panel 3, and the display panel 3 may display an image. The display apparatus 2 may be arranged inside the vehicle 1000. In an embodiment, the display apparatus 2 may be arranged between the side window glasses 1100 facing each other. The display apparatus 2 may be arranged on at least one of the cluster 1400, the center fascia 1500, or the passenger seat dashboard 1600.

The display apparatus 2 may comprise an organic light-emitting display apparatus, an inorganic light-emitting display apparatus, a quantum dot display apparatus, and/or the like. Hereinafter, as the display apparatus 2 according to an embodiment of the disclosure, an organic light-emitting display apparatus comprising the light-emitting device according to the disclosure will be described as an example, but one or more suitable types (kinds) of display apparatuses as described above may be utilized in embodiments of the disclosure.

Referring to FIG. 6A, the display apparatus 2 may be arranged on the center fascia 1500. In an embodiment, the display apparatus 2 may display navigation information. In an embodiment, the display apparatus 2 may display audio, video, or information regarding vehicle settings.

Referring to FIG. 6B, the display apparatus 2 may be arranged on the cluster 1400. When the display apparatus 2 is arranged on the cluster 1400, the cluster 1400 may display driving information and/or the like through the display apparatus 2. For example, the cluster 1400 may be implemented digitally. The digital cluster 1400 may display vehicle information and driving information as images. For example, a needle and a gauge of a tachometer and one or more suitable warning light icons may be displayed by digital signals.

Referring to FIG. 6C, the display apparatus 2 may be arranged on the passenger seat dashboard 1600. The display apparatus 2 may be embedded in the passenger seat dashboard 1600 or arranged on the passenger seat dashboard 1600. In an embodiment, the display apparatus 2 arranged on the passenger seat dashboard 1600 may display an image related to information displayed on the cluster 1400 and/or information displayed on the center fascia 1500. In one or more embodiments, the display apparatus 2 arranged on the passenger seat dashboard 1600 may display information different from information displayed on the cluster 1400 and/or information displayed on the center fascia 1500.

### Manufacturing method

Respective layers comprised in the hole transport region, the emission layer, and respective layers comprised in the electron transport region may be formed in a certain region by utilizing one or more suitable methods selected from vacuum deposition, spin coating, casting, Langmuir-Blodgett (LB) deposition, ink-jet printing, laser-printing, laser-induced thermal imaging, and/or the like.

When respective layers comprised in the hole transport region, the emission layer, and respective layers comprised in the electron transport region are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be comprised in a layer to be formed and the structure of a layer to be formed.

### Definition of terms

The term "C₃-C₆₀ carbocyclic group" as used herein refers to a cyclic group consisting of carbon only as a ring-forming atom and having 3 to 60 carbon atoms, and the term "C₁-C₆₀ heterocyclic group" as used herein refers to a cyclic group that has 1 to 60 carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the number of ring-forming atoms of the C₁-C₆₀ heterocyclic group may be from 3 to 61.

The "cyclic group" as used herein may comprise both the C₃-C₆₀ carbocyclic group and the C₁-C₆₀ heterocyclic group.

The term "π electron-rich C₃-C₆₀ cyclic group" as used herein refers to a cyclic group that has 3 to 60 carbon atoms and does not comprise *-N=*' as a ring-forming moiety, and the term "π electron-deficient nitrogen-containing C₁-C₆₀ heterocyclic group" as used herein refers to a heterocyclic group that has 1 to 60 carbon atoms and comprises *-N=*' as a ring-forming moiety.

For example,
the C₃-C₆₀ carbocyclic group may be i) a T1 group or ii) a condensed cyclic group in which two or more T1 groups are condensed with each other (for example, the C₃-C₆₀ carbocyclic group may be a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which two or more T2 groups are condensed with each other, or iii) a condensed cyclic group in which at least one T2 group and at least one T1 group are condensed with each other (for example, the C₁-C₆₀ heterocyclic group may be a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a T1 group, ii) a condensed cyclic group in which two or more T1 groups are condensed with each other, iii) a T3 group, iv) a condensed cyclic group in which two or more T3 groups are condensed with each other, or v) a condensed cyclic group in which at least one T3 group and at least one T1 group are condensed with each other (for example, the π electron-rich C₃-C₆₀ cyclic group may be the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ heterocyclic group may be i) a T4 group, ii) a condensed cyclic group in which two or more T4 groups are condensed with each other, iii) a condensed cyclic group in which at least one T4 group and at least one T1 group are condensed with each other, iv) a condensed cyclic group in which at least one T4 group and at least one T3 group are condensed with each other, or v) a condensed cyclic group in which at least one T4 group, at least one T1 group, and at least one T3 group are condensed with one another (for example, the π electron-deficient nitrogen-containing C₁-C₆₀ heterocyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group," "the C₁-C₆₀ heterocyclic group," "the π electron-rich C₃-C₆₀ cyclic group," or "the π electron-deficient nitrogen-containing C₁-C₆₀ heterocyclic group" as used herein refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, and/or the like, which may be easily understood by one of ordinary skill in the art according to the structure of a formula comprising the "benzene group."

Examples of the monovalent C₃-C₆₀ carbocyclic group and the monovalent C₁-C₆₀ heterocyclic group may comprise (e.g., may be) a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group. Examples of the divalent C₃-C₆₀ carbocyclic group and the divalent C₁-C₆₀ heterocyclic group may comprise (e.g., may be) a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has 1 to 60 carbon atoms, and examples thereof may comprise (e.g., may be) a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, and/or the like. The term "C₁-C₆₀ alkylene group" as used herein refers to a divalent group having substantially the same structure as the C₁-C₆₀ alkyl group.

The term "C₂-C₆₀ alkenyl group" as used herein refers to a monovalent hydrocarbon group having at least one carbon-carbon double bond in the middle and/or at a terminal end (e.g., the terminus) of the C₂-C₆₀ alkyl group, and examples thereof may comprise (e.g., may be) an ethenyl group, a propenyl group, a butenyl group, and/or the like. The term "C₂-C₆₀ alkenylene group" as used herein refers to a divalent group having substantially the same structure as the C₂-C₆₀ alkenyl group.

The term "C₂-C₆₀ alkynyl group" as used herein refers to a monovalent hydrocarbon group having at least one carbon-carbon triple bond in the middle and/or at a terminal end (e.g., the terminus) of the C₂-C₆₀ alkyl group, and examples thereof may comprise (e.g., may be) an ethynyl group, a propynyl group, and/or the like. The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof may comprise (e.g., may be) a methoxy group, an ethoxy group, an isopropyloxy group, and/or the like.

The term "C₃-C₁₀ cycloalkyl group" as used herein refers to a monovalent saturated hydrocarbon cyclic group having 3 to 10 carbon atoms, and examples thereof may comprise (e.g., may be) a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and/or the like. The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent cyclic group that comprises, in addition to 1 to 10 carbon atoms, at least one heteroatom, as ring-forming atoms, and examples thereof may comprise (e.g., may be) a 1,2,3,4-oxatriazolidinyl group, a tetrahydrofuranyl group, a tetrahydrothiophenyl group, and/or the like. The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent cyclic group that has 3 to 10 carbon atoms and at least one carbon-carbon double bond in the ring thereof and no aromaticity, and examples thereof may comprise (e.g., may be) a cyclopentenyl group, a cyclohexenyl group, a cycloheptenyl group, and/or the like. The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent cyclic group that comprises, in addition to 1 to 10 carbon atoms, at least one heteroatom, as ring-forming atoms, and having at least one carbon-carbon double bond in the cyclic structure thereof. Examples of the C₁-C₁₀ heterocycloalkenyl group may comprise (e.g., may be) a 4,5-dihydro-1 ,2,3,4-oxatriazolyl group, a 2,3-dihydrofuranyl group, a 2,3-dihydrothiophenyl group, and/or the like. The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group may comprise (e.g., may be) a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and/or the like. When the C₆-C₆₀ aryl group and the C₆-C₆₀ arylene group each comprise two or more rings, the rings may be condensed with each other.

The term "C₁-C₆₀ heteroaryl group" as used herein refers to a monovalent group having a heterocyclic aromatic system that comprises, in addition to 1 to 60 carbon atoms, at least one heteroatom, as ring-forming atoms. The term "C₁-C₆₀ heteroarylene group" as used herein refers to a divalent group having a heterocyclic aromatic system that comprises, in addition to 1 to 60 carbon atoms, at least one heteroatom, as ring-forming atoms. Examples of the C₁-C₆₀ heteroaryl group may comprise (e.g., may be) a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, a naphthyridinyl group, a carbazolyl group, a dibenzofuranyl group, a dibenzothiofuranyl group, and/or the like. When the C₁-C₆₀ heteroaryl group and the C₁-C₆₀ heteroarylene group each comprise two or more rings, the two or more rings may be condensed with each other.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group may comprise (e.g., may be) an indenyl group, a fluorenyl group, a spiro-bifluorenyl group, a benzofluorenyl group, an indenophenanthrenyl group, an indeno anthracenyl group, and/or the like. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, in addition to carbon atoms, at least one heteroatom, as ring-forming atoms, and having non-aromaticity in its entire molecular structure. Examples of the monovalent non-aromatic condensed heteropolycyclic group may comprise (e.g., may be) a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, a benzothienodibenzothiophenyl group, an azaadamantyl group, and/or the like. The term "divalent non-aromatic condensed heteropolycyclic group" as utilized herein refers to a divalent group having substantially the same structure as the monovalent non-aromatic condensed heteropolycyclic group.

The term "C₆-C₆₀ aryloxy group" as used herein refers to a monovalent group represented by -OA₁₀₂ (wherein A₁₀₂ is the C₆-C₆₀ aryl group), and the term "C₆-C₆₀ arylthio group" as used herein refers to a monovalent group represented by -SA₁₀₃ (wherein A₁₀₃ is the C₆-C₆₀ aryl group).

The term "C₇-C₆₀ arylalkyl group" as used herein refers to a monovalent group represented by -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to a monovalent group represented by -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂).
Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "heteroatom" as used herein refers to any atom other than a carbon atom. Examples of the heteroatom may comprise (e.g., may be) O, S, N, P, Si, B, Ge, Se, and any combination thereof.

The term "third-row transition metal" as used herein comprises hafnium (Hf), tantalum (Ta), tungsten (W), rhenium (Re), osmium (Os), iridium (Ir), platinum (Pt), gold (Au), and/or the like.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group." In other words, the "biphenyl group" may be a substituted phenyl group having a C₆-C₆₀ aryl group as a substituent.

The term "terphenyl group" as used herein refers to "a phenyl group substituted with a biphenyl group." In other words, the "terphenyl group" may be a substituted phenyl group having, as a substituent, a C₆-C₆₀ aryl group substituted with a C₆-C₆₀ aryl group.

* and *' as used herein, unless defined otherwise, each refer to a binding site to a neighboring atom in a corresponding formula or moiety.

Hereinafter, compounds according to embodiments and light-emitting devices according to embodiments will be described in more detail with reference to the following synthesis examples and examples. The wording "B was utilized instead of A" utilized in describing Synthesis Examples refers to that an identical molar equivalent of B was utilized in place of A.

### Examples

The heterocyclic compound according to an embodiment may be synthesized, for example, as follows. However, synthesis methods of the heterocyclic compound according to an embodiment are not limited thereto.

### Synthesis Example 1: Synthesis of Compound 1

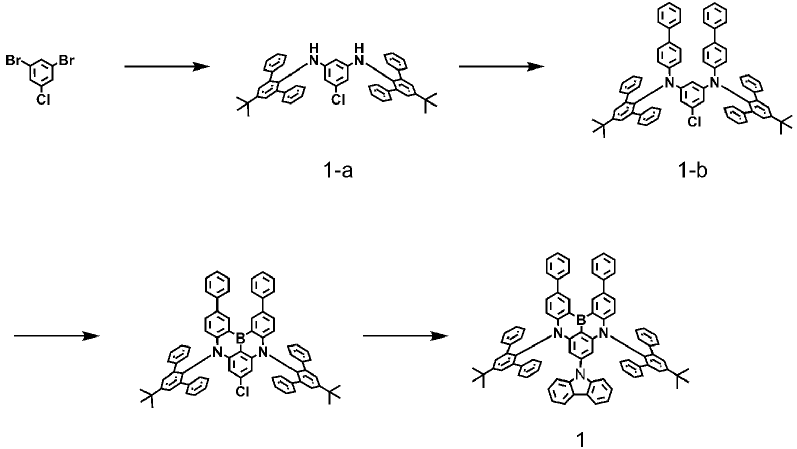

### (1) Synthesis of Intermediate Compound 1-a

1,3-dibromo-5-chlorobenzene (27 g, 100 mmol), 5'-(tert-butyl)-[1,1':3',1"-terphenyl]-2'-amine (60.29 g, 200 mmol), tris(dibenzylideneacetone)dipalladium(0) (4.58 g, 5 mmol), tri-tert-butylphosphine (1.01 g, 5 mmol), and sodium tert-butoxide (28.8 g, 300 mmol) were dissolved in 1 L of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 1-a (51.22 g, 72 mmol). (Yield: 72 %)

### (2) Synthesis of Intermediate Compound 1-b

Intermediate Compound 1-a (51.22 g, 72 mmol), 4-iodo-1,1'-biphenyl (302.5 g, 1,080 mmol), copper(I) iodide (27.43 g, 144 mmol), and potassium carbonate (99.5 g, 720 mmol) were dissolved in o-xylene (60 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 1-b (white solid, 54.12 g, 53.28 mmol, 74 %).

### (3) Synthesis of Intermediate Compound 1-c

In a nitrogen atmosphere, Intermediate Compound 1-b (54.12 g, 53.28 mmol) and Bl₃ (42 g, 106.6 mmol) were dissolved in 1,000 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Intermediate Compound 1-c (14.18 g, 13.85 mmol, 26 %).

### (4) Synthesis of Compound 1

Intermediate Compound 1-c (14.18 g, 13.85 mmol), carbazole (5.83 g, 35 mmol), tris(dibenzylideneacetone)dipalladium(0) (0.64 g, 0.7 mmol), tri-tert-butylphosphine (0.15 g, 0.7 mmol), and sodium tert-butoxide (4 g, 41.9 mmol) were dissolved in 300 mL of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Compound 1 (12.47 g, 10.8 mmol, 78 %).

### Synthesis Example 2: Synthesis of Compound 2

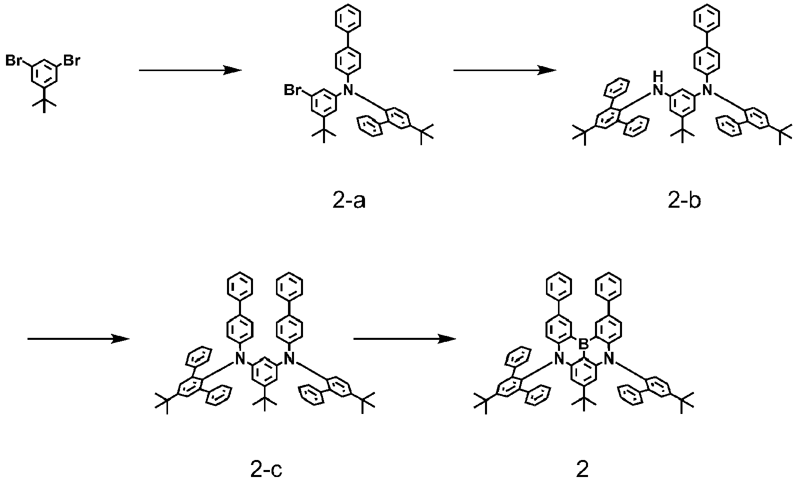

### (1) Synthesis of Intermediate Compound 2-a

1,3-dibromo-5-(tert-butyl)benzene (58.4 g, 200 mmol), N-([1,1'-biphenyl]-4-yl)-5-(tert-butyl)-[1,1'-biphenyl]-2-amine (75.5 g, 200 mmol), tris(dibenzylideneacetone)dipalladium(0) (9.2 g, 10 mmol), BINAP (6.22 g, 10 mmol), and sodium tert-butoxide (57.6 g, 600 mmol) were dissolved in 2 L of toluene, and the mixture was stirred at 90 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 2-a (88.3 g, 150 mmol). (Yield: 75 %)

### (2) Synthesis of Intermediate Compound 2-b

Intermediate Compound 2-a (88.3 g, 150 mmol), 5'-(tert-butyl)-[1,1':3',1"-terphenyl]-2'-amine (45.22 g, 150 mmol), tris(dibenzylideneacetone)dipalladium(0) (6.87 g, 7.5 mmol), tri-tert-butylphosphine (1.52 g, 7.5 mmol), and sodium tert-butoxide (43.25 g, 450 mmol) were dissolved in 1.5 L of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 2-b (86.17 g, 106.5 mmol, 71 %).

### (3) Synthesis of Intermediate Compound 2-c

Intermediate Compound 2-b (86.17 g, 106.5 mmol), 4-iodo-1,1'-biphenyl (298.3 g, 1,065 mmol), copper(I) iodide (40.56 g, 213 mmol), and potassium carbonate (147 g, 1,065 mmol) were dissolved in o-xylene (80 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 2-c (white solid, 82.9 g, 86.23 mmol, 81 %).

### (4) Synthesis of Compound 2

In a nitrogen atmosphere, Intermediate Compound 2-c (82.9 g, 86.23 mmol) and Bl₃ (67.5 g, 172.47 mmol) were dissolved in 900 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Compound 2 (23.4 g, 24.14 mmol, 28 %).

### Synthesis Example 3: Synthesis of Compound 3

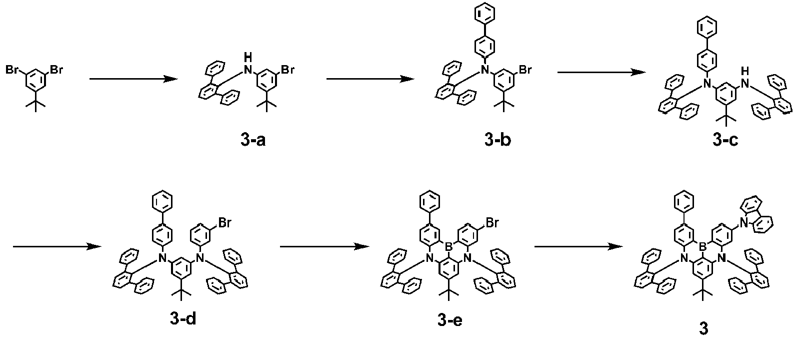

### (1) Synthesis of Intermediate Compound 3-a

1,3-dibromo-5-(tert-butyl)benzene (58.4 g, 200 mmol), [1,1':3',1"-terphenyl]-2'-amine (49.07 g, 200 mmol), tris(dibenzylideneacetone)dipalladium(0) (9.2 g, 10 mmol), BINAP (6.22 g, 10 mmol), and sodium tert-butoxide (57.6 g, 600 mmol) were dissolved in 2 L of toluene, and the mixture was stirred at 90 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 3-a (70.3 g, 154 mmol, 77 %).

### (2) Synthesis of Intermediate Compound 3-b

Intermediate Compound 3-a (70.3 g, 154 mmol), 4-iodo-1,1'-biphenyl (431.43 g, 1,540 mmol), copper(I) iodide (58.67 g, 308 mmol), and potassium carbonate (213 g, 1,540 mmol) were dissolved in o-xylene (100 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 3-b (74 g, 122 mmol, 79 %).

### (3) Synthesis of Intermediate Compound 3-c

Intermediate Compound 3-b (74 g, 122 mmol), [1,1':3',1"-terphenyl]-2'-amine (29.9 g, 122 mmol), tris(dibenzylideneacetone)dipalladium(0) (5.57 g, 6.1 mmol), tri-tert-butylphosphine (1.23 g, 6.1 mmol), and sodium tert-butoxide (35 g, 365 mmol) were dissolved in 1.1 L of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 3-c (85.8 g, 111 mmol, 81 %).

### (4) Synthesis of Intermediate Compound 3-d

Intermediate Compound 3-c (85.8 g, 111 mmol), 1-bromo-3-iodobenzene (314 g, 1,110 mmol), copper(I) iodide (42.27 g, 222 mmol), and potassium carbonate (153.4 g, 1,110 mmol) were dissolved in 1,2-dichlorobenzene (90 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 3-d (79.3 g, 85.5 mmol, 77 %).

### (5) Synthesis of Intermediate Compound 3-e

In a nitrogen atmosphere, Intermediate Compound 3-d (79.3 g, 85.5 mmol) and Bl₃ (66.9 g, 171 mmol) were dissolved in 900 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Intermediate Compound 3-e (27.2 g, 29.1 mmol, 34 %).

### (5) Synthesis of Compound 3

Intermediate Compound 3-e (27.2 g, 29.1 mmol), carbazole (9.72 g, 58.13 mmol), tris(dibenzylideneacetone)dipalladium(0) (1.33 g, 1.45 mmol), tri-tert-butylphosphine (0.3 g, 1.45 mmol), and sodium tert-butoxide (8.38 g, 87.2 mmol) were dissolved in 400 mL of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Compound 3 (24.1 g, 23.6 mmol, 81 %).

### Synthesis Example 4: Synthesis of Compound 4

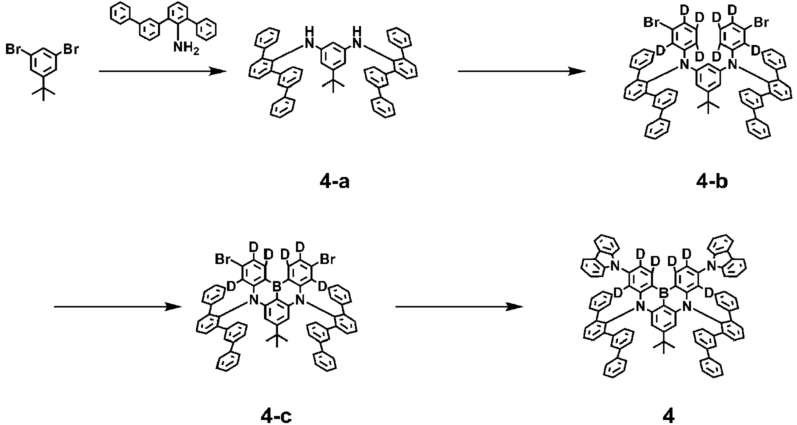

### (1) Synthesis of Intermediate Compound 4-a

1,3-dibromo-5-(tert-butyl)benzene (58.4 g, 200 mmol), [1,1':3',1":3",1‴-quaterphenyl]-2'-amine (128.56 g, 400 mmol), tris(dibenzylideneacetone)dipalladium(0) (9.16 g, 10 mmol), tri-tert-butylphosphine (2.02 g, 10 mmol), and sodium tert-butoxide (57.66 g, 600 mmol) were dissolved in 1.5 L of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 4-a (112.9 g, 146 mmol, 73 %).

### (2) Synthesis of Intermediate Compound 4-b

Intermediate Compound 4-a (112.9 g, 146 mmol), 1-bromo-3-iodobenzene-2,4,5,6-d4 (419 g, 1,460 mmol), copper(I) iodide (55.63 g, 292 mmol), and potassium carbonate (201.85 g, 1,460 mmol) were dissolved in 1,2-dichlorobenzene (110 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 4-b (119.5 g, 110 mmol, 75 %).

### (3) Synthesis of Intermediate Compound 4-c

In a nitrogen atmosphere, Intermediate Compound 4-b (119.5 g, 110 mmol) and Bl₃ (85.76 g, 219 mmol) were dissolved in 1,300 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Intermediate Compound 4-c (29 g, 26.4 mmol, 24 %).

### (4) Synthesis of Compound 4

Intermediate Compound 4-c (29 g, 26.4 mmol), carbazole (8.84 g, 52.88 mmol), tris(dibenzylideneacetone)dipalladium(0) (1.21 g, 1.32 mmol), tri-tert-butylphosphine (0.27 g, 1.32 mmol), and sodium tert-butoxide (7.62 g, 79.32 mmol) were dissolved in 300 mL of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Compound 4 (23.1 g, 18.2 mmol, 69 %).

### Synthesis Example 5: Synthesis of Compound 5

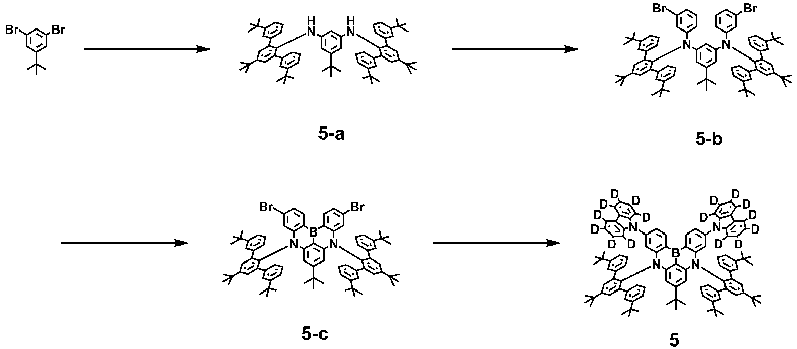

### (1) Synthesis of Intermediate Compound 5-a

1,3-dibromo-5-(tert-butyl)benzene (58.4 g, 200 mmol), 3,3",5'-tri-tert-butyl-[1,1':3',1"-terphenyl]-2'-amine (165.45 g, 400 mmol), tris(dibenzylideneacetone)dipalladium(0) (9.16 g, 10 mmol), tri-tert-butylphosphine (2.02 g, 10 mmol), and sodium tert-butoxide (57.66 g, 600 mmol) were dissolved in 1.5 L of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 5-a (147.5 g, 154 mmol, 77 %).

### (2) Synthesis of Intermediate Compound 5-b

Intermediate Compound 5-a (147.5 g, 154 mmol), 1-bromo-3-iodobenzene (436 g, 1,540 mmol), copper(I) iodide (58.68 g, 308 mmol), and potassium carbonate (213 g, 1,541 mmol) were dissolved in 1,2-dichlorobenzene (120 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 5-b (148.3 g, 117 mmol, 76 %).

### (3) Synthesis of Intermediate Compound 5-c

In a nitrogen atmosphere, Intermediate Compound 5-b (148.3 g, 117 mmol) and Bl₃ (91.62 g, 234 mmol) were dissolved in 1,600 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Intermediate Compound 5-c (35.8 g, 28.1 mmol, 24 %).

### (4) Synthesis of Compound 5

Intermediate Compound 5-c (35.8 g, 28.1 mmol), 9H-carbazole-1,2,3,4,5,6,7,8-d8 (9.84 g, 56.15 mmol), tris(dibenzylideneacetone)dipalladium(0) (1.29 g, 1.4 mmol), tri-tert-butylphosphine (0.29 g, 1.4 mmol), and sodium tert-butoxide (8.1 g, 84.22 mmol) were dissolved in 700 mL of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Compound 5 (28.4 g, 19.4 mmol, 69 %).

### Synthesis Example 6: Synthesis of Compound 6

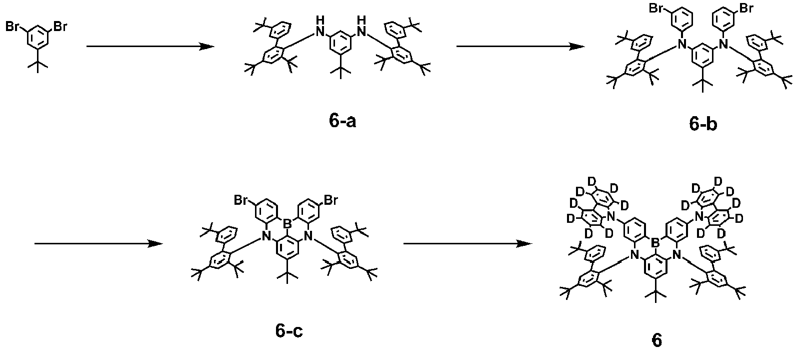

### (1) Synthesis of Intermediate Compound 6-a

1,3-dibromo-5-(tert-butyl)benzene (29.2 g, 100 mmol), 3,3',5-tri-tert-butyl-[1,1'-biphenyl]-2-amine (67.5 g, 200 mmol), tris(dibenzylideneacetone)dipalladium(0) (4.58 g, 5 mmol), tri-tert-butylphosphine (1.01 g, 5 mmol), and sodium tert-butoxide (28.83 g, 300 mmol) were dissolved in 1 L of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 6-a (64.4 g, 80 mmol, 80 %).

### (2) Synthesis of Intermediate Compound 6-b

Intermediate Compound 6-a (64.4 g, 80 mmol), 1-bromo-3-iodobenzene (226.25 g, 800 mmol), copper(I) iodide (30.46 g, 160 mmol), and potassium carbonate (111 g, 800 mmol) were dissolved in 1,2-dichlorobenzene (45 mL), and the mixture was stirred at 190 °C for about 5 days. After completion of the reaction, the resulting solid was filtered utilizing a Celite pad filter, purified utilizing a silica filter, and finally purified by recrystallization (DCM/Hx) to obtain Intermediate Compound 6-b (65.1 g, 58.4 mmol, 73 %).

### (3) Synthesis of Intermediate Compound 6-c

In a nitrogen atmosphere, Intermediate Compound 6-b (65.1 g, 58.4 mmol) and Bl₃ (45.71 g, 117 mmol) were dissolved in 840 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Intermediate Compound 6-c (18.4 g, 16.4 mmol, 28 %).

### (4) Synthesis of Compound 6

Intermediate Compound 6-c (18.4 g, 16.4 mmol), 9H-carbazole-1,2,3,4,5,6,7,8-d8 (5.74 g, 32.77 mmol), tris(dibenzylideneacetone)dipalladium(0) (0.75 g, 0.82 mmol), tri-tert-butylphosphine (0.17 g, 0.82 mmol), and sodium tert-butoxide (4.72 g, 49.15 mmol) were dissolved in 300 mL of toluene, and the mixture was stirred at 110 °C for 24 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Compound 6 (17.6 g, 13.4 mmol, 82 %).

### Comparative Synthesis Example 1: Synthesis of Compound 1

Compound 1 was synthesized in substantially the same manner as in Synthesis Example 1, except that the synthesis method of Intermediate Compound 1-b was changed as follows.

### Synthesis of Intermediate Compound 1-b

Intermediate Compound 1-a (71.1 g, 100 mmol), 4-iodo-1,1'-biphenyl (84.0 g, 300 mmol), Pd₂dba₃ (4.6 g, 5.0 mmol), tris-tert-butyl phosphine (50 % in toluene) (4.7 mL, 10 mmol), and sodium tert-butoxide (28.8 g, 300 mmol) were dissolved in o-xylene (100 mL), and the mixture was stirred at 140 °C for about 72 hours. After completion of the reaction, the resulting solid was filtered utilizing a Celite pad filter, purified utilizing a silica filter, and finally purified by recrystallization (DCM/Hx) to obtain Intermediate Compound 1-b (white solid, 3.0 g, 3.0 mmol, 3 %).

### Comparative Synthesis Example 2: Synthesis of Compound 2

Compound 2 was synthesized in substantially the same manner as in Synthesis Example 2, except that the synthesis method of Intermediate Compound 2-c was changed as follows.

### Synthesis of Intermediate Compound 2-c

Intermediate Compound 2-b (80.9 g, 100 mmol), 4-iodo-1,1'-biphenyl (56.0 g, 200 mmol), Pd₂dba₃ (4.6 g, 5.0 mmol), tris-tert-butyl phosphine (50 % in toluene) (4.7 mL, 10.0 mmol), and sodium tert-butoxide (28.8 g, 300 mmol) were dissolved in o-xylene (100 mL), and the mixture was stirred at 140 °C for about 72 hours. After completion of the reaction, the resulting solid was filtered utilizing a Celite pad filter, purified utilizing a silica filter, and finally purified by recrystallization (DCM/Hx) to obtain Intermediate Compound 2-c (white solid, 2.9 g, 3 mmol, 3 %).

### Comparative Synthesis Example 3: Synthesis of Compound 4

Compound 4 was synthesized in substantially the same manner as in Synthesis Example 4, except that the synthesis method of Intermediate Compound 4-b was changed as follows.

### Synthesis of Intermediate Compound 4-b

Intermediate Compound 4-a (80.9 g, 100 mmol), 1-bromo-3-iodobenzene-2,4,5,6-d4 (57.4 g, 200 mmol), Pd₂dba₃ (4.6 g, 5.0 mmol), tris-tert-butyl phosphine (50 % in toluene) (4.7 mL, 10.0 mmol), and sodium tert-butoxide (28.8 g, 300 mmol) were dissolved in o-xylene (100 mL), and the mixture was stirred at 140 °C for about 72 hours. After completion of the reaction, the resulting solid was filtered utilizing a Celite pad filter, purified utilizing a silica filter, and finally purified by recrystallization (DCM/Hx) to obtain Intermediate Compound 4-b (5.48 g, 5 mmol, 5 %).

### Comparative Synthesis Example 4: Synthesis of Compound 5

Compound 5 was synthesized in substantially the same manner as in Synthesis Example 5, except that the synthesis method of Intermediate Compound 5-b was changed as follows.

### Synthesis of Intermediate Compound 5-b

Intermediate Compound 5-a (95.7 g, 100 mmol), 1-bromo-3-iodobenzene (56.6 g, 200 mmol), Pd₂dba₃ (4.6 g, 5.0 mmol), tris-tert-butyl phosphine (50 % in toluene) (4.7 mL, 10.0 mmol), and sodium tert-butoxide (28.8 g, 300 mmol) were dissolved in o-xylene (100 mL), and the mixture was stirred at 140 °C for about 72 hours. After completion of the reaction, the resulting solid was filtered utilizing a Celite pad filter, purified utilizing a silica filter, and finally purified by recrystallization (DCM/Hx) to obtain Intermediate Compound 5-b (2.55 g, 2 mmol, 2 %).

### Comparative Synthesis Example 5: Synthesis of Compound 1

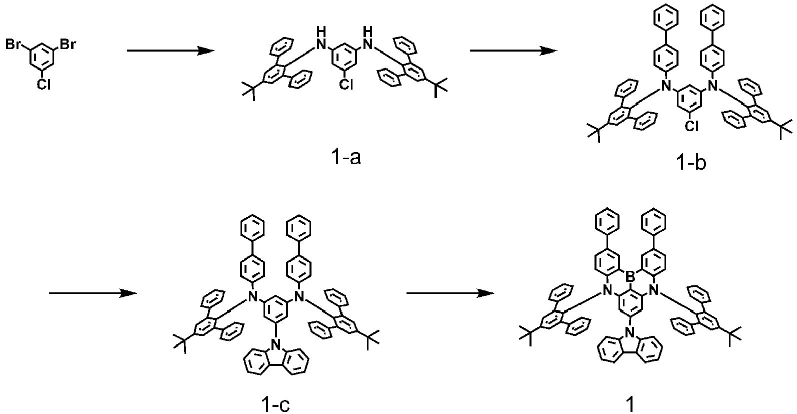

Compound 1 was synthesized in substantially the same manner as in Synthesis Example 1, except that, after the synthesis of Intermediate Compound 1-b, the order of synthesis was changed as follows.

### (1) Synthesis of Intermediate Compound 1-c

Intermediate Compound 1-b (54.12 g, 53.28 mmol, 74 %) carbazole (11.7 g, 70 mmol), tris(dibenzylideneacetone)dipalladium(0) (2.75 g, 3 mmol), tri-tert-butylphosphine (0.61 g, 3 mmol), and sodium tert-butoxide (15.36 g, 160 mmol) were dissolved in 600 mL of toluene, and the mixture was stirred at 110 °C for 12 hours. After cooling, the mixture was washed with ethyl acetate and water three times, and the organic layer obtained by separation was dried over MgSO₄ and then dried under reduced pressure. The resulting product was purified by column chromatography utilizing MC and n-hexane to obtain Intermediate Compound 1-c (47.65 g, 41.56 mmol). (Yield: 78 %)

### (2) Synthesis of Compound 1

In a nitrogen atmosphere, Intermediate Compound 1-c (47.65 g, 41.56 mmol) and Bl₃ (32.42 g, 83 mmol) were dissolved in 840 mL of ortho dichlorobenzene, and the mixture was stirred at 150 °C for 24 hours. After cooling, triethylamine was slowly added dropwise into the flask containing the reactant to terminate the reaction, and ethyl alcohol was added into the reactant to cause precipitation, thereby obtaining a reaction product. The obtained solid was purified by column chromatography utilizing MC and n-hexane, and then recrystallized utilizing toluene and acetone to obtain Compound 1 (4.8 g, 4.17 mmol, 1 %).

¹H NMR and MS/FAB of the compounds synthesized according to Synthesis Examples are shown in Table 1. Synthesis methods of compounds other than the compounds synthesized in Synthesis Examples above may be easily recognized by those skilled in the art by referring to the synthesis paths and source materials.

**Table 1**

| Compound No. | ¹H NMR (CDCl₃, 400 MHz) | MS/FAB | |
|---|---|---|---|
| | | found | calc. |
| 1 | 9.12-9.09 (2H, d), 8.36 (2H, s), 7.86-7.83 (4H, d), 7.75-7.69 (4H, s), 7.62-7.58 (2H, d), 7.55-7.48 (8H, m), 7.41-7.37 (2H, m), 7.23-7.19 (2H, s), 7.11-7.08 (22H, d), 6.93 (2H, s), 1.41 (18H, s) | 1154.321 | 1154.317 |
| 2 | 8.98-8.92 (2H, s), 7.81-7.62 (12H, m) 7.6-7.57 (4H, s) 7.18-7.13 (2H, m), 7.05-6.90 (16H, m), 6.25 (2H, s) 1.41 (18H, s), 1.04 (9H, s) | 969.136 | 969.125 |
| 3 | 8.96-8.93 (1H, s), 8.86-8.82 (1H, d), 8.21-8.17 (2H, d), 7.81-7.62 (6H, m), 7.6-7.57 (6H, s), 7.49-7.43 (4H, m), 7.31-7.26 (2H, m), 7.18-7.13 (3H, m), 7.05-6.90 (20H, m), 6.25 (2H, s), 1.04 (9H, s) | 1022.115 | 1022.108 |
| 4 | 8.21-8.15 (4H, d), 7.61-7.57 (6H, m) 7.49-7.41 (8H, m), 7.26-7.22 (4H, m), 7.17-7.13 (4H, m) 7.11-6.96 (24H, m), 6.24 (2H, s), 1.08 (9H, s) | 1269.445 | 1269.442 |
| 5 | 8.62-8.58 (2H, d), 7.6-7.57 (4H, s), 7.12-7.07 (4H, m) 7.07-6.98 (16H, m), 6.33 (2H, s) 1.41 (18H, s), 1.20(36H, s) 1.03 (9H, s) | 1463.958 | 1463.936 |
| 6 | 8.67-8.61 (2H, d), 7.61-7.58 (4H, m), 7.12-7.07 (4H, m) 7.08-6.95 (8H, m), 6.32 (2H, s) 1.43 (18H, s), 1.18(18H, s) 1.12 (18H, s), 1.05 (9H, s) | 1311.762 | 1311.757 |

### Evaluation Example 1

The number of moles of reaction of Intermediate Compound 1-a in Synthesis Example 1, the number of moles of reaction of Intermediate Compound 2-b in Synthesis Example 2, the number of moles of reaction of Intermediate Compound 4-a in Synthesis Example 4, and the number of moles of reaction of Intermediate Compound 5-a in Synthesis Example 5 were changed as shown in Table 2, and the yield of Intermediate Compound 1-b, the yield of Intermediate Compound 2-c, the yield of Intermediate Compound 4-b, and the yield of Intermediate Compound 5-b were measured relative to the number of moles of corresponding reactants, and results thereof are shown in Table 2.

**Table 2**

| Number of moles of reactant | Yield of product | | | |
|---|---|---|---|---|
| | Intermediate Compound 1-b | Intermediate Compound 2-c | Intermediate Compound 4-b | Intermediate Compound 5-b |
| 20 mmol | 88% | 85 % | 73 % | 75% |
| 40 mmol | 85% | 84 % | 70 % | 74% |
| 60 mmol | 80% | 82 % | 69 % | 72% |
| 80 mmol | 79% | 81 % | 68 % | 70% |
| 100 mmol | 75% | 81 % | 65 % | 69% |
| 200 mmol | 74% | 78 % | 63 % | 66% |

In addition, the number of moles of reaction of Intermediate Compound 1-a in Comparative Synthesis Example 1, the number of moles of reaction of Intermediate Compound 2-b in Comparative Synthesis Example 2, the number of moles of reaction of Intermediate Compound 4-a in Comparative Synthesis Example 3, and the number of moles of reaction of Intermediate Compound 5-a in Comparative Synthesis Example 4 were changed as shown in Table 3, and the yield of Intermediate Compound 1-b, the yield of Intermediate Compound 2-c, the yield of Intermediate Compound 4-b, and the yield of Intermediate Compound 5-b were measured relative to the number of moles of corresponding reactants, and results thereof are shown in Table 3.

**Table 3**

| Number of moles of reactant | Yield of product | | | |
|---|---|---|---|---|
| | Intermediate Compound 1-b | Intermediate Compound 2-c | Intermediate Compound 4-b | Intermediate Compound 5-b |
| 20 mmol | 67% | 72 % | 55 % | 65% |
| 40 mmol | 61 % | 68 % | 52 % | 59% |
| 60 mmol | 40% | 50 % | 22 % | 38% |
| 80 mmol | 17% | 19 % | 6% | 11 % |
| 100 mmol | 3% | 5% | 0% | 2% |
| 200 mmol | 0% | 0% | 0% | 0% |

Referring to Tables 2 and 3, it was confirmed that in Synthesis Examples 1 to 5, as compared with Comparative Synthesis Examples 1 to 4, the yield of the product at the same number of moles of the reactant was excellent or suitable, and the decrease in yield according to the increase in the number of moles of the reactant was not large.

### Evaluation Example 2

The yield of the final synthesized Compound 1 relative to the number of moles of reaction of Intermediate Compound 1-b in Synthesis Example 1, and the yield of the final synthesized Compound 1 relative to the number of moles of reaction of Intermediate Compound 1-b in Comparative Synthesis Example 5 were measured, and results thereof are shown in Table 4.

**Table 4**

| Synthesis method | Number of moles of reactant (Intermediate Compound 1-b) | Yield of final product (Compound 1) |
|---|---|---|
| Synthesis Example 1 | 100 mmol | 20.28 % |
| Comparative Synthesis Example 4 | 100 mmol | 0.78 % |

Referring to Table 4, it was confirmed that in Synthesis Example 1, as compared with Comparative Synthesis Example 5, production of by-products was suppressed or reduced and the reaction rate was excellent or suitable, so that Compound 1, which was the target final compound, was obtained in high yield.

By utilizing the method of preparing a heterocyclic compound according to one or more embodiments, even when a reactant comprises a substituent with large steric hindrance, a product may be obtained in high yield, and even when the number of moles of reaction of the reactant is increased, the yield of the product may not be reduced at a certain level. Accordingly, the efficiency of a purification process following preparation of a final compound may be increased, so that economic efficiency may be improved and large-scale synthesis may be possible, thus enabling mass production of the heterocyclic compound.

The use of "may" when describing embodiments of the inventive concept refers to "one or more embodiments of the inventive concept."

As utilized herein, the singular forms "a," "an," "one," and "the" are intended to comprise the plural forms as well, unless the context clearly indicates otherwise. Further, the use of "may" when describing embodiments of the present disclosure refers to "one or more embodiments of the present disclosure".

In the present disclosure, when particles are spherical, "diameter" indicates a particle diameter or an average particle diameter, and when the particles are non-spherical, the "diameter" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

As used herein, the term "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Also, any numerical range recited herein is intended to comprise all sub-ranges of the same numerical precision subsumed within the recited range. For example, a range of "1.0 to 10.0" is intended to comprise all subranges between (and comprising) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to comprise all lower numerical limitations subsumed therein and any minimum numerical limitation recited in this specification is intended to comprise all higher numerical limitations subsumed therein. Accordingly, Applicant reserves the right to amend this specification, comprising the claims, to expressly recite any sub-range subsumed within the ranges expressly recited herein.

The electronic apparatus and/or any other relevant devices or components according to embodiments of the present invention described herein may be implemented utilizing any suitable hardware, firmware (e.g. an application-specific integrated circuit), software, or a combination of software, firmware, and hardware. For example, the various components of the apparatus may be formed on one integrated circuit (IC) chip or on separate IC chips. Further, the various components of the apparatus may be implemented on a flexible printed circuit film, a tape carrier package (TCP), a printed circuit board (PCB), or formed on one substrate. Further, the various components of the apparatus may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the spirit and scope as defined by the following claims and equivalents thereof.

## Claims

1. A method of preparing a heterocyclic compound represented by Formula 1, the method comprising:
preparing a first reactant;
preparing a second reactant represented by Formula 2-2; and
reacting the first reactant with the second reactant by mixing the first and second reactants in a mixture with a copper catalyst, a base, and optionally, an auxiliary solvent, to prepare an intermediate compound,
wherein the first reactant is represented by Formula 2-1a, and the intermediate compound is represented by Formula 2-3a, or
the first reactant is represented by Formula 2-1b, and the intermediate compound is represented by Formula 2-3b: 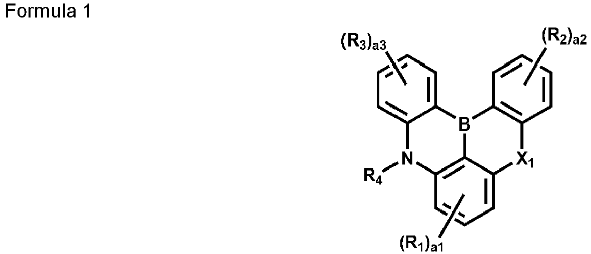 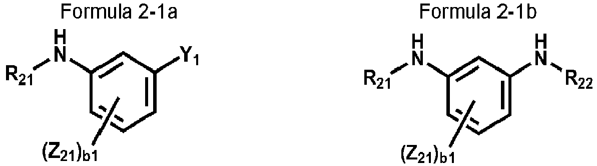 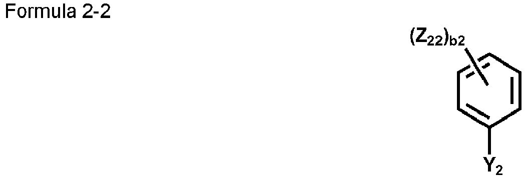 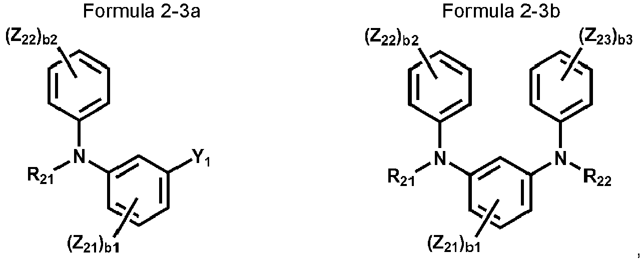
wherein, in Formula 1,
X₁ is N(R₁₁), O, S, or Se,
R₁ to R₄ and R₁₁ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂),
a1 is an integer from 1 to 3, and
a2 and a3 are each independently an integer from 1 to 4,
wherein, in Formulae 2-1a, 2-1b, 2-2, 2-3a, and 2-3b,
Y₁ and Y₂ are each independently -F, -Cl, -Br, or -I,
R₂₁, R₂₂, and Z₂₁ to Z₂₃ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂),
b1 is an integer from 1 to 4,
b2 and b3 are each independently an integer from 1 to 5,
two or more adjacent groups selected from R₁ to R₄, R₁₁, R₂₁, R₂₂, and Z₂₁ to Z₂₃ are optionally bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, -Si(Q₂₁)(Q₂₂)(Q₂₃), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -B(Q₃₁)(Q₃₂), -C(=O)(Q₃₁), -S(=O)₂(Q₃₁), or -P(=O)(Q₃₁)(Q₃₂), and
Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a C₃-C₆₀ carbocyclic group, a C₁-C₆₀ heterocyclic group, or any combination thereof.

2. The method of claim 1, wherein the copper catalyst is metal copper, CuCl, CuBr, Cul, CuCl₂, CuBr₂, CuI₂, CuO, or CuS.

3. The method of claim 1 or claim 2, wherein, a molar ratio between the second reactant and the first reactant is 5 or greater.

4. The method of any one of claims 1 to 3, wherein the reacting is performed at a temperature of about 170 °C to about 210 °C for about 100 hours to about 140 hours.

5. The method of claim 4, wherein:
the second reactant is in a liquid state, or the second reactant mixed with the auxiliary solvent is in a liquid state at the temperature of about 170 °C to about 210 °C.

6. The method of claim 5, wherein, in the liquid state of the second reactant mixed with the auxiliary solvent, a volume of the auxiliary solvent is less than or equal to a volume of the second reactant.

7. The method of any one of claims 1 to 6, wherein, in the mixture, the first reactant is 80 mmol or more in amount.

8. The method of any one of claims 1 to 7, wherein a yield of the intermediate compound is 60 % or more based on a total number of moles of the first reactant in the mixture.

9. The method of any one of claims 1 to 8, wherein at least one of R₂₁ or R₂₂ is a group represented by Formula 3: 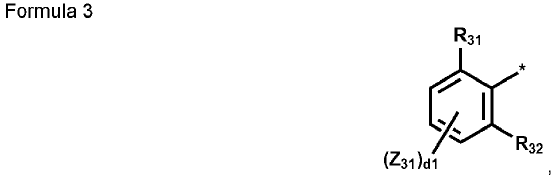
wherein, in Formula 3,
R₃₁, R₃₂, and Z₃₁ are each independently hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), -C(=O)(Q₁), -S(=O)₂(Q₁), or -P(=O)(Q₁)(Q₂),
d1 is an integer from 1 to 3,
* indicates a binding site to a neighboring atom,
two or more adjacent groups selected from R₃₁, R₃₂, and Z₃₁ are optionally bonded to each other to form a C₅-C₃₀ carbocyclic group unsubstituted or substituted with at least one R₁₀ₐ or a C₂-C₃₀ heterocyclic group unsubstituted or substituted with at least one R₁₀ₐ, and
at least one of R₃₁ or R₃₂ is a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, or-Si(Q₁)(Q₂)(Q₃).

10. The method of any one of claims 1 to 9, further comprising reacting the intermediate compound or a derivative thereof with a boron halide.

11. The method of claim 10, wherein at least one of R₁ to R₃ in Formula 1 is a group represented by Formula 1-1, and
the group represented by Formula 1-1 is introduced into the heterocyclic compound after the reacting of the intermediate compound or the derivative thereof with the boron halide: 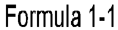 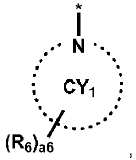
wherein, in Formula 1-1,
CY₁ is a C₅-C₃₀ carbocyclic group or a C₁-C₃₀ heterocyclic group,
R₆ is hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), - B(Q₁)(Q₂), -C(=O)(Q₁), -S(=O)₂(Q₁), or-P(=O)(Q₁)(Q₂),
a6 is an integer from 1 to 10, and
* indicates a binding site to a neighboring atom.

12. A heterocyclic compound represented by Formula 1, the heterocyclic compound being prepared according to the method of any one of claims 1 to 11.

13. The heterocyclic compound of claim 12, wherein the heterocyclic compound is to emit thermally activated delayed fluorescence (TADF).

14. A light-emitting device comprising:
a first electrode;
a second electrode facing the first electrode;
an interlayer between the first electrode and the second electrode and comprising an emission layer; and
the heterocyclic compound of claim 12.

15. The light-emitting device of claim 14, wherein
the emission layer comprises the heterocyclic compound,
the emission layer further comprises: i) a transition metal-containing compound; ii) a third compound comprising at least one π electron-deficient nitrogen-containing C₁-C₆₀ heterocyclic group; iii) a fourth compound comprising a group represented by Formula 4; iv) or any combination thereof, and
the transition metal-containing compound, the third compound, and the fourth compound are different from each other: 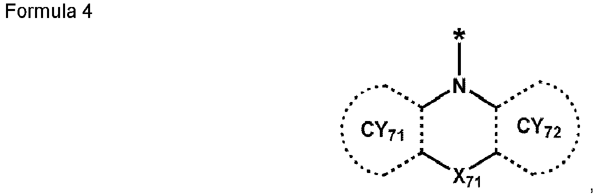
wherein, in Formula 4,
ring CY₇₁ and ring CY₇₂ are each independently a π electron-rich C₃-C₆₀ cyclic group or a pyridine group,
X₇₁ is a single bond, or a linking group comprising O, S, N, B, C, Si, or any combination thereof, and
* indicates a binding site to any atom comprised in a remaining portion of the fourth compound other than the group represented by Formula 4.

16. An electronic apparatus comprising the light-emitting device of claim 14 or 15.

17. The electronic apparatus of claim 16, further comprising:
a thin-film transistor,
wherein the thin-film transistor comprises a source electrode and a drain electrode, and
the first electrode of the light-emitting device is electrically connected to the source electrode or the drain electrode of the thin-film transistor.

18. The electronic apparatus of claim 16, further comprising a color filter, a color conversion layer, a touch screen layer, a polarizing layer, or any combination thereof.

19. An electronic equipment comprising the light-emitting device of claim 14 or 15.

20. The electronic equipment of claim 19, wherein the electronic equipment is a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and/or a signboard.
